(19) Europäisches Patentamt
European Patent Office
Office européen des brevets

(11) **EP 4 590 100 A1**

(12) **EUROPEAN PATENT APPLICATION**
published in accordance with Art. 153(4) EPC

(43) Date of publication:
**23.07.2025 Bulletin 2025/30**

(21) Application number: **23954953.8**

(22) Date of filing: **25.10.2023**

(51) International Patent Classification (IPC):
**H10K 59/12** (2023.01)    **H10K 59/123** (2023.01)

(52) Cooperative Patent Classification (CPC):
**H10K 59/12; H10K 59/121; H10K 59/123**

(86) International application number:
**PCT/CN2023/126428**

(87) International publication number:
**WO 2025/086132 (01.05.2025 Gazette 2025/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **BOE TECHNOLOGY GROUP CO., LTD.**
**Beijing 100015 (CN)**
• **Beijing BOE Technology Development Co., Ltd.**
**Beijing 100176 (CN)**

(72) Inventors:
• **ZHANG, Yuxin**
**Beijing 100176 (CN)**
• **FANG, Fei**
**Beijing 100176 (CN)**
• **WANG, Jingquan**
**Beijing 100176 (CN)**
• **HAO, Xueguang**
**Beijing 100176 (CN)**
• **LIANG, Ke**
**Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE AND DISPLAY DEVICE**

(57)    A display substrate includes a first display region (A1) including a plurality of island regions (A11) and a transmissive region (TA) located between adjacent island regions (A11). A light transmittance of the transmissive region (TA) is greater than a light transmittance of the island region (A11). The transmissive region (TA) includes at least one first light emitting element (14) disposed on a substrate (30), and the island region (A11) includes at least one first pixel circuit (11) disposed on the substrate (30). At least one first pixel circuit (11) in the island region (A11) is electrically connected with at least one first light emitting element (14) in an adjacent transmissive region (TA), and a distance between an orthographic projection of the first pixel circuit (11) on the substrate (30) and an orthographic projection of the connected first light emitting element (14) on the substrate (30) is greater than 0.

FIG. 2

EP 4 590 100 A1

**Description**

Technical Field

The present disclosure relates to, but is not limited to, the field of display technologies, in particular to a display substrate and a display apparatus.

Background

Organic Light Emitting Diodes (OLED) and Quantum-dot Light Emitting Diodes (QLED) are active light emitting display devices, and have advantages of self-illumination, a wide viewing angle, a high contrast ratio, low power consumption, an extremely high reaction speed, lightness and thinness, flexibility, and low cost, etc.

Summary

The following is a summary of subject matters described herein in detail. This summary is not intended to limit the protection scope of claims.

Embodiments of the present disclosure provide a display substrate and a display apparatus.

In one aspect, a display substrate is provided in an embodiment. The display substrate includes a first display region including a plurality of island regions and a transmissive region located between adjacent island regions; wherein a light transmittance of the transmissive region is greater than a light transmittance of an island region. The transmissive region includes at least one first light emitting element disposed on a substrate; the island region includes at least one first pixel circuit disposed on the substrate. At least one first pixel circuit of the island region is electrically connected with at least one first light emitting element of an adjacent transmissive region, and a distance between an orthographic projection of the first pixel circuit on the substrate and an orthographic projection of the connected first light emitting element on the substrate is greater than 0.

In some exemplary implementations, the first pixel circuit in the island region is electrically connected with a plurality of first light emitting elements emitting light of a same color in an adjacent transmissive region.

In some exemplary implementations, the transmissive region includes a plurality of first light emitting elements emitting light of different colors, the first light emitting elements emitting light of different colors in the transmissive region are located on different insulation layers, first light emitting elements emitting light of a same color in the transmissive region are located on a same insulation layer.

In some exemplary implementations, the transmissive region includes a plurality of first light emitting elements emitting light of different colors, and the plurality of first light emitting elements are located on a same insulation layer.

In some exemplary implementations, the first pixel circuit of the island region is connected with at least one first light emitting element in an adjacent transmissive region by at least one connection line, and the at least one connection line is made of a metal material or a transparent conductive material.

In some exemplary implementations, the display substrate further includes a shielding layer located in the island region, wherein the shielding layer is located on a side of the first pixel circuit close to the substrate, an orthographic projection of the shielding layer on the substrate covers an orthographic projection of an active layer of at least one transistor of the first pixel circuit on the substrate, and the at least one connection line and the shielding layer are in a same layer.

In some exemplary implementations, an anode of the first light emitting element includes a plurality of anode sub-layers, and the at least one connection line and one of the anode sub-layers are in a same layer.

In some exemplary implementations, the display substrate further includes at least one transparent conductive layer located between the first pixel circuit and the first light emitting element, wherein the at least one connection line is located in the at least one transparent conductive layer.

In some exemplary implementations, the island region further includes at least one second light emitting element; the first pixel circuit of the island region is electrically connected with at least one second light emitting element and at least one first light emitting element located in the transmissive region, which emit light of a same color.

In some exemplary implementations, the island region further includes at least one second pixel circuit and at least one second light emitting element, the at least one second pixel circuit is electrically connected with the at least one second light emitting element, and an orthographic projection of the second pixel circuit on the substrate is overlapped, at least partially, with an orthographic projection of the connected second light emitting element on the substrate.

In some exemplary implementations, a light emitting area of the first light emitting element is less than a light emitting area of the second light emitting element that emits light of a same color.

In some exemplary implementations, both a plurality of second light emitting elements of the island region and a plurality of first light emitting elements of the transmissive region are located on a same insulation layer.

In some exemplary implementations, the transmissive region includes at least one first light emitting element emitting light of a first color, at least one first light emitting element emitting light of a second color, and at least one first light emitting element emitting light of a third color; the first light emitting element emitting light of the first color in the transmissive region and the plurality of second light emitting elements in the island region are located on a same insulation layer, the first light emitting element emitting light of the second color, the first light emitting element emitting light of the third color, and the first light emitting element emitting light of the first color in the transmissive region are located on different insulation layers, a minimum distance between the first light emitting element emitting light of the first color and the substrate is greater than a minimum distance between the first light emitting element emitting light of the second color and the substrate, and is greater than a minimum distance between the first light emitting element emitting light of the third color and the substrate.

In some exemplary implementations, the first display region further includes an inter-island connection region connecting adjacent island regions. The inter-island connection region includes at least one third light emitting element; the first pixel circuit of the island region is electrically connected with at least one first light emitting element located in the transmissive region and at least one third light emitting element located in the inter-island connection region, which emit light of a same color; or the inter-island connection region includes at least one third light emitting element and at least one third pixel circuit, wherein the at least one third pixel circuit is electrically connected with the at least one third light emitting element.

In some exemplary implementations, the display substrate further includes a second display region located on at least one side of the first display region, a light transmittance of the second display region is less than a light transmittance of the first display region. The second display region includes a plurality of second region light emitting elements and a plurality of second region pixel circuits, the plurality of second region pixel circuits are electrically connected with the plurality of second region light emitting elements, and orthographic projections of the second region pixel circuits on the substrate are overlapped, at least partially, with orthographic projections of the connected second region light emitting elements on the substrate.

In some exemplary implementations, a pixel density of the first display region is less than a pixel density of the second display region.

In some exemplary implementations, the plurality of transmissive regions are spaced apart from each other, the plurality of transmissive regions including at least one of the following shapes: a rounded rectangle, a circle, an oval, an octagon, a cross with twelve sides.

In another aspect, a display apparatus is provided in an embodiment. The display apparatus includes the aforementioned display substrate and a sensor located on a non-display side of the display substrate, wherein an orthographic projection of the sensor on the substrate of the display substrate is overlapped with an orthographic projection of the first display region of the display substrate on the substrate.

In another aspect, a display substrate is provided in an embodiment. The display substrate includes a first display region including a plurality of island regions separated from each other, an inter-island connection region connecting adjacent island regions, and a plurality of transmissive regions surrounded by the plurality of island regions and the inter-island connection region. A light transmittance of the transmissive region is greater than a light transmittance of the island regions and a light transmittance of the inter-island connection region. The inter-island connection region includes at least one third light emitting element disposed on a substrate; the at least one third light emitting element is electrically connected with at least one third pixel circuit, the at least one third pixel circuit is located in the island region or in the inter-island connection region.

In some exemplary implementations, the first display region further includes at least one second light emitting element disposed on the substrate and located in the island region, the third pixel circuit of the island region is electrically connected with at least one second light emitting element and at least one third light emitting element located in the inter-island connection region, which emits light of a same color.

In some exemplary implementations, the first display region further includes at least one second light emitting element and at least one second pixel circuit which are disposed on the substrate and located in the island region. The at least one second pixel circuit is electrically connected with the at least one second light emitting element, and an orthographic projection of the second pixel circuit on the substrate is overlapped, at least partially, with an orthographic projection of the connected second light emitting element on the substrate.

In some exemplary implementations, the inter-island connection region of the first display region includes a first inter-island connection region and a second inter-island connection region, the first inter-island connection region connects adjacent island regions along a first direction, the second inter-island connection region connects adjacent island regions along a second direction, and the first direction intersects with the second direction. A quantity of pixel circuit rows in the first inter-island connection region is less than or equal to a quantity of pixel circuit rows in the island region, and a quantity of pixel circuit columns in the second inter-island connection region is less than or equal to a quantity of pixel circuit columns in the island region. A plurality of pixel circuits arranged along the first direction are a row of pixel circuits, and a plurality of pixel circuits arranged along the second direction are a column of pixel circuits.

In some exemplary implementations, the transmissive region includes at least one first light emitting element disposed on the substrate, where the at least one first light emitting element is electrically connected with at least one third pixel circuit. The first inter-island connection region includes a row of pixel circuits, and a third pixel circuit in the row of pixel circuits is connected with a plurality of first light emitting elements that emit light of a same color in two transmissive regions adjacent to the first inter-island connection region in the second direction. The second inter-island connection region includes a column of pixel circuits, and a third pixel circuit in the column of pixel circuits is connected with a plurality of first light emitting elements that emit light of a same color in two transmissive regions adjacent to the second inter-island connection region in the first direction.

In some exemplary implementations, the third pixel circuit in the inter-island connection region is connected with at least one first light emitting element in an adjacent transmissive region by at least one connection line, the at least one connection line is made of a metal material or a transparent conductive material.

In some exemplary implementations, a light emitting area of the first light emitting element is smaller than a light emitting area of the second light emitting element emitting light of a same color. A light emitting area of the third light emitting element is less than or equal to a light emitting area of the second light emitting element emitting light of a same color.

In another aspect, a display substrate is provided in an embodiment. The display substrate includes a first display region including a plurality of island regions separated from each other, an inter-island connection region connecting adjacent island regions, and a plurality of transmissive regions surrounded by the plurality of island regions and the inter-island connection region. A light transmittance of the transmissive region is greater than a light transmittance of the island regions and a light transmittance of the inter-island connection region. The transmissive region includes at least one first light emitting element disposed on a substrate. The inter-island connection region includes at least one first pixel circuit disposed on the substrate. At least one first light emitting element in the transmissive region is electrically connected with at least one first pixel circuit in an adjacent inter-island connection region, and a distance between an orthographic projection of the first pixel circuit on the substrate and an orthographic projection of the connected first light emitting element on the substrate is greater than 0.

In some exemplary implementations, the transmissive region includes a plurality of first light emitting elements emitting light of different colors. The first light emitting elements emitting light of different colors in the transmissive region are located on different insulation layers, and first light emitting elements emitting light of a same color in the transmissive region are located on a same insulation layer. Alternatively, a plurality of first light emitting elements in the transmissive region are located on a same insulation layer.

In some exemplary implementations, the first pixel circuit in the inter-island connection region is connected with at least one first light emitting element in an adjacent transmissive region through at least one connection line. At least one connection line is made of a metal material or a transparent conductive material.

In some exemplary implementations, the inter-island connection region further includes at least one third light emitting element disposed on the substrate. At least one first pixel circuit in the inter-island connection region is electrically connected with at least one first light emitting element located in the transmissive region and at least one third light emitting element emitting light of a same color, located in the inter-island connection region.

In some exemplary implementations, the inter-island connection region further includes at least one third light emitting element and at least one third pixel circuit disposed on the substrate, wherein the at least one third pixel circuit is electrically connected with the at least one third light emitting element, an orthographic projection of the third pixel circuit on the substrate is overlapped, at least partially, with an orthographic projection of the connected third light emitting element on the substrate.

Other aspects of the present disclosure may be comprehended after the drawings and the detailed descriptions are read and understood.

Brief Description of Drawings

Accompanying drawings are used for providing an understanding of technical solutions of the present application and form a part of the specification, are used for explaining the technical solutions of the present application together with embodiments of the present application, and do not constitute a limitation on the technical solutions of the present application.

FIG. 1 is a schematic diagram of a display substrate according to at least one embodiment of the present disclosure.
FIG. 2 is a partial schematic diagram of a first display region according to at least one embodiment of the present disclosure.
FIG. 3 illustrates an example of a circuit and trace arrangement of the first display region in FIG. 2.
FIG. 4 illustrates schematically a partial cross-sectional view of a display substrate according to at least one embodiment of the present disclosure.

FIG. 5 illustrates schematically another partial cross-sectional view of a display substrate according to at least one embodiment of the present disclosure.

FIG. 6 illustrates schematically another partial cross-sectional view of a display substrate according to at least one embodiment of the present disclosure.

FIG. 7 illustrates schematically another partial cross-sectional view of a display substrate according to at least one embodiment of the present disclosure.

FIG. 8 illustrates schematically another partial cross-sectional view of a display substrate according to at least one embodiment of the present disclosure.

FIG. 9 illustrates schematically another partial cross-sectional view of a display substrate according to at least one embodiment of the present disclosure.

FIG. 10 illustrates schematically another partial cross-sectional view of a display substrate according to at least one embodiment of the present disclosure.

FIG. 11 illustrates schematically another partial diagram of a first display region according to at least one embodiment of the present disclosure.

FIG. 12 illustrates schematically another partial diagram of a first display region according to at least one embodiment of the present disclosure.

FIG. 13 illustrates schematically another partial diagram of a first display region according to at least one embodiment of the present disclosure.

FIG. 14 illustrates schematically another partial diagram of a first display region according to at least one embodiment of the present disclosure.

FIG. 15 illustrates schematically another partial diagram of a first display region according to at least one embodiment of the present disclosure.

FIG. 16 illustrates schematically another partial diagram of a first display region according to at least one embodiment of the present disclosure.

FIG. 17 illustrates schematically another partial diagram of a first display region according to at least one embodiment of the present disclosure.

FIG. 18 illustrates schematically another partial diagram of a first display region according to at least one embodiment of the present disclosure.

FIG. 19 illustrates schematically another partial diagram of a first display region according to at least one embodiment of the present disclosure.

FIG. 20 illustrates schematically another partial diagram of a first display region according to at least one embodiment of the present disclosure.

FIG. 21 illustrates schematically another partial diagram of a first display region according to at least one embodiment of the present disclosure.

FIG. 22 illustrates schematically another partial diagram of a first display region according to at least one embodiment of the present disclosure.

FIG. 23 illustrates schematically another partial diagram of a first display region according to at least one embodiment of the present disclosure.

FIG. 24 illustrates schematically another partial diagram of a first display region according to at least one embodiment of the present disclosure.

FIG. 25 illustrates schematically another partial diagram of a first display region according to at least one embodiment of the present disclosure.

FIG. 26 illustrates schematically another partial diagram of a first display region according to at least one embodiment of the present disclosure.

FIG. 27 illustrates schematically another partial diagram of a first display region according to at least one embodiment of the present disclosure.

FIG. 28 illustrates schematically another partial diagram of a first display region according to at least one embodiment of the present disclosure.

FIG. 29 is an equivalent circuit diagram of a pixel circuit according to at least one embodiment of the present disclosure.

FIG. 30 is a schematic diagram of a partition of a semiconductor layer of a display region according to at least one embodiment of the present disclosure.

FIG. 31A is a schematic diagram of a partition of a display region after a first conductive layer is formed, according to at least one embodiment of the present disclosure.

FIG. 31B is a schematic diagram of the first conductive layer in FIG. 31A.

FIG. 32A is a schematic diagram of a partition of a display region after a second conductive layer is formed, according to at least one embodiment of the present disclosure.

FIG. 32B is a schematic diagram of the second conductive layer in FIG. 32A.

FIG. 33A is a schematic diagram of a partition of a display region after a third conductive layer is formed, according to at least one embodiment of the present disclosure.

FIG. 33B is a schematic diagram of the third conductive layer in FIG. 33A.

FIG. 34A is a schematic diagram of a partition of a display region after a fourth conductive layer is formed, according to at least one embodiment of the present disclosure.

FIG. 34B is a schematic diagram of the fourth conductive layer in FIG. 34A.

FIG. 35A is a schematic diagram of a partition of a display region after an anode layer is formed, according to at least one embodiment of the present disclosure.

FIG. 35B is a schematic diagram of the anode layer in FIG. 35A.

FIG. 36 is another schematic diagram of a display substrate according to at least one embodiment of the present disclosure.

FIG. 37 is a partial schematic diagram of a pixel circuit and a trace of a first display region according to at least one embodiment of the present disclosure.

FIG. 38 is another schematic diagram of a display substrate according to at least one embodiment of the present disclosure.

FIG. 39 is another schematic diagram of a display substrate according to at least one embodiment of the present disclosure.

FIG. 40 is a schematic diagram of a display apparatus according to at least one embodiment of the present disclosure.

Detailed Description

The embodiments of the present disclosure will be described below with reference to the drawings in detail. Implementations may be implemented in multiple different forms. Those of ordinary skills in the art may easily understand such a fact that implementations and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the accompanying drawings schematically illustrate ideal examples, and a mode of the present disclosure is not limited to shapes, numerical values, or the like shown in the drawings.

Ordinal numerals "first", "second", "third", etc., in the specification are set not to form limits in numbers but only to avoid confusion between composition elements. In the present disclosure, "a plurality of" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the composition elements with reference to the drawings, not to indicate or imply that involved apparatuses or elements are required to have specific orientations and be structured and operated with the specific orientations but only to easily and simply describe the present specification, and thus should not be understood as limitations on the present disclosure. The positional relationships between the constituent elements are changed as appropriate according to a direction with which the constituent elements are described. Therefore, appropriate replacements based on situations are allowed, which is not limited to the expressions in the specification.

In the specification, unless otherwise specified and defined, terms "mounting", "mutual connection", "connection" and "couple" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art may understand meanings of the aforementioned terms in the present disclosure according to situations.

In the specification, "electrical connection" includes connection of composition elements through an element with some electrical function. The "element having some electrical function" is not particularly limited as long as electrical signals between the connected constituent elements may be transmitted. Examples of the "element having some electrical function" not only include an electrode and a wiring, but also include a switching element such as a transistor, a resistor, an inductor, a capacitor, another element with multiple functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is -10° or more and 10° or less, and thus may include a state in which the angle is -5° or more and 5° or less. In addition, "perpendicular" refers to a state in which an angle formed by two straight lines is 80° or more and 100° or less, and thus may include a state in which the angle is 85° or more and 95° or less.

In this specification, a circle, oval, triangle, rectangle, trapezoid, pentagon or hexagon, etc. is not strictly speaking, but may be an approximate circle, oval, triangle, rectangle, trapezoid, pentagon or hexagon, etc. Some small deformations due to tolerances may exist, for example, lead angles, curved edges and deformations thereof may exist.

A "light transmittance" in the present disclosure refers to an ability of light to pass through a medium, and is a percentage of luminous flux passing through a transparent or translucent body to its incident luminous flux.

In the present disclosure, "about" and "substantially" refer to that a boundary is not defined strictly and a case within a range of process and measurement errors is allowed. In the present disclosure, the same may include the case of exactly the same and substantially the same. "Substantially the same" refers to a case where numerical values differ by less than 10%.

In the present disclosure, "A extends along a B direction" means that A may include a main portion and a secondary portion connected with the main portion, the main portion is a line, a line segment, or a strip-shaped body, the main portion extends along the B direction, and a length of the main portion extending along the B direction is greater than a length of the secondary portion extending along another direction. "A extends along the B direction" in the present disclosure means "the main portion of A extends along the B direction".

With continuous development of display technologies, a camera is usually installed on a display device to meet needs of shooting or face recognition. In order to maximize a screen-to-body ratio, technologies such as fringe screen, water drop screen and in-screen hole have successively came into being. These technologies reduce the area occupied by the camera by digging a hole locally in a display region and placing the camera under a hole-digging region, thus increasing the screen-to-body ratio. However, the above technologies need to dig out part of the display region, which will cause some regions in a display picture to be unable to be displayed, and make it impossible to further improve the screen-to-body ratio. In order to avoid punching holes in the display region and under a premise of ensuring practicability of the display substrate, a true full-screen will be achieved by adopting a pixel circuit built-out method or a pixel circuit built-in method in the full display with camera (FDC) region.

The pixel circuit built-out method means that the pixel circuits connected with the light emitting elements in the FDC region is provided in the normal display region, and the light transmittance of the FDC region is improved by arranging the light emitting elements and the pixel circuits separately. Because no pixel circuit is provided in the FDC region, there is no light-shielding layer other than the anodes of the light emitting elements in this region, and a higher light transmittance can be realized. However, in this mode, the pixel circuits and the light emitting elements need to be electrically connected through conductive connection lines, the size (e.g., aperture) of the FDC region of the display substrate using the pixel circuit built-out method is limited due to the limitation of the space for the arrangement of the conductive connection lines. Moreover, increasing the aperture of the FDC region usually requires an increased mask process of the conductive connection lines, resulting in increased cost. In addition, the material of the conductive connection lines is usually a transparent conductive material, such as indium tin oxide (ITO). Due to the large square resistance of ITO, the load of a longer conductive connection line is large, which easily affects the brightness of the light emitting elements in the FDC region and reduces the brightness of the FDC region, which leads to a display defect in the FDC region, such as a vertical display defect (Mura).

The pixel circuit built-in method refers to the provision of light emitting elements and the pixel circuits connected with the light emitting elements in the FDC region. Compared with the pixel circuit built-out method, the built-in method eliminates the need for long conductive connection lines for the electric connection between the pixel circuits and the light emitting elements in the FDC region, which can avoid the display defect of the FDC region caused by the conductive connection lines. Moreover, the built-in method does not limit the size of the FDC region and can support the FDC region with large aperture. In order to improve a light transmittance of the FDC region, there is a large difference between a pixel density of the FDC region and a pixel density of a normal display region, which can easily lead to a display difference between the normal display region and the FDC region.

Embodiments provide a display substrate and a display apparatus, which can increase the pixel density of the region where a camera under panel is located while ensuring the light transmittance of the region where the camera under panel is located, so as to achieve a high pixel density (high Pixels Per Inch (PPI)) display.

A display substrate is provided in an embodiment. The display substrate includes a first display region, wherein the first display region includes a plurality of island regions, and a transmissive region located between adjacent island regions. A light transmittance of the transmissive region is greater than a light transmittance of the island region. The transmissive region includes at least one first light emitting element disposed on a substrate; the island region includes at least one first pixel circuit disposed on the substrate. At least one first pixel circuit is electrically connected with at least one first light emitting element of an adjacent transmissive region, and a distance between an orthographic projection of the first pixel circuit on the substrate and an orthographic projection of the connected first light emitting element on the substrate is greater than 0. In other words, the orthographic projection of the first pixel circuit on the substrate is not overlapped with the orthographic projection of the connected first light emitting element on the substrate.

In some examples, the first pixel circuits and the first light emitting elements may be connected in a one-to-one manner or in a one-to-multiple manner. In this embodiment, the one-to-one refers to as that the pixel circuits and the light emitting elements may be connected in a one-to-one correspondence, and one pixel circuit is configured to drive one connected light emitting element. One-to-multiple refers to as that one pixel circuit is electrically connected with a plurality of light emitting elements, and one pixel circuit is configured to drive multiple connected light emitting elements. For example, the one-to-multiple may be one-to-two (i.e., one pixel circuit is connected with two light emitting elements), one-to-three (i.e., one pixel circuit is connected with three light emitting elements), one-to-four (i.e., one pixel circuit is connected with four light emitting elements), or one-to-five (i.e.to, one pixel circuit is connected with five light emitting elements). In some examples, the first pixel circuits and the first light emitting elements may be connected in a one-to-multiple manner. For example, one first pixel circuit may be electrically connected with a plurality of first light emitting elements emitting light of a same color. The embodiment is not limited thereto.

According to the display substrate provided in this embodiment, the first light emitting element is disposed in the transmissive region between the island regions, and the first pixel circuit driving the first light emitting element is disposed in the island region, so that the pixel density of the first display region can be increased while ensuring the light transmittance of the first display region, thereby enabling high PPI display in the first display region.

In some exemplary implementations, the first pixel circuit in the island region may be electrically connected with a plurality of first light emitting elements emitting light of a same color in an adjacent transmissive region. The first pixel circuits and the first light emitting elements in this example may be connected in a one-to-multiple manner, which can reduce a quantity of the first pixel circuits and is beneficial for reducing a circuit arrangement space required for the first display region.

In some exemplary implementations, the transmissive region may include a plurality of first light emitting elements emitting light of different colors. First light emitting elements emitting light of different colors in the transmissive region may be located on different insulation layers, and first light emitting elements emitting light of a same color in the transmissive region may be located on a same insulation layer. In this example, the plurality of first light emitting elements may be arranged on different insulation layers according to the colors of light emitted by the first light emitting elements, so as to ensure the light transmittance and the display effect of the first display region.

In some exemplary implementations, the transmissive region may include a plurality of first light emitting elements emitting light of different colors, and the plurality of first light emitting elements in the transmissive region may be located on a same insulation layer. In this example, the plurality of first light emitting elements in the transmissive region are located in the same insulation layer, which can ensure anode flatness of the plurality of first light emitting elements, and is beneficial for ensuring the display effect.

In some exemplary implementations, the first pixel circuit of the island region is connected with at least one first light emitting element in an adjacent transmissive region by at least one connection line, and the at least one connection line may be made of a metal material or a transparent conductive material. In some examples, the first pixel circuit may be connected with one first light emitting element in an adjacent transmissive region by a connection line, or may be connected with a plurality of first light emitting elements in an adjacent transmissive region by a connection line, or may be connected with one first light emitting element in an adjacent transmissive region by a plurality of connection lines; or may be connected with a plurality of first light emitting elements in an adjacent transmissive region by a plurality of connection lines. For example, the first pixel circuit may be connected with a plurality of first light emitting elements in an adjacent transmissive region by a plurality of connection lines, the plurality of connection lines may include a first connection line and a second connection line, the first pixel circuit may be connected with one first light emitting element in an adjacent transmissive region by the first connection line, and a plurality of first light emitting elements in an adjacent transmissive region, which are connected with a same first pixel circuit, may be connected by the second connection line. For example, the first connection line and the second connection line may be connected to each other to form an integral structure, And the embodiment is not limited thereto. In some other examples, the first connection line and the second connection line may be located in different film layers. Alternatively, the first connection line and the second connection line may be made of different materials.

In some exemplary implementations, the display substrate may include a shielding layer located in the island region, the shielding layer may be located on a side of the first pixel circuit close to the substrate, and an orthographic projection of the shielding layer on the substrate may cover an orthographic projection of an active layer of at least one transistor of the first pixel circuit on the substrate. At least one connection line and the shielding layer may be in a same layer. In this example, by disposing at least one connection line at a same layer as the shielding layer, manufacturing acts can be reduced, and the cost can be saved. Moreover, the connection line is made of a metal material, which can reduce the resistance, thereby beneficial for ensuring effectiveness of the signals transmitted by the connection line.

In some exemplary implementations, an anode of the first light emitting element may include a plurality of anode sub-layers, and the at least one connection line and one of the anode sub-layers are in a same layer. For example, a plurality of connection lines may be in a same layer as a same anode sub-layer, or a part of the connection lines may be in the same layer as an anode sub-layer, and another part of the connection lines may be in a same layer as another anode sub-layer. In some examples, the anode of the first light emitting element may include a first anode sub-layer, a second anode sub-layer, and a third anode sub-layer. The first anode sub-layer and the third anode sub-layer may be made of a transparent conductive material, including, for example, Indium Tin Oxide (ITO). The second anode sub-layer may be made of a metal material, including, for example, silver (Ag). For example, a plurality of connection lines may be in a same layer as the first anode sub-layer. In this example, by disposing the connection lines in the same layer as one of the anode sub-layers, the manufacturing acts can be reduced, and the cost can be saved. Moreover, the connection lines are made of a transparent conductive material, which is beneficial for ensuring the light transmittance of the first display region.

In some exemplary implementations, the display substrate may further include at least one transparent conductive layer located between the first pixel circuit and the first light emitting element, wherein the at least one connection line may be located in the at least one transparent conductive layer. For example, the plurality of connection lines may be located in a same transparent conductive layer, or some of the connection lines may be located in a transparent conductive layer, and another part of the connection lines may be located in another transparent conductive layer. The connection lines in this example are made of a transparent conductive material, which is beneficial for ensuring the light transmittance of the first display region.

In some exemplary implementations, the island region may further include at least one second light emitting element. The first pixel circuit of the island region may be electrically connected with at least one first light emitting element located in the transmissive region and at least one second light emitting element, which emit light of a same color. For example, an orthographic projection of the first pixel circuit on the substrate may be overlapped, at least partially, with an orthographic projection of the connected second light emitting element on the substrate. The first pixel circuit in this example can drive the second light emitting element and the first light emitting element at the same time, and the quantity of pixel circuits in the first display region can be reduced, which is beneficial for ensuring the light transmittance of the first display region.

In some exemplary implementations, the island region may further include at least one second pixel circuit and at least one second light emitting element. At least one second pixel circuit is electrically connected with at least one second light emitting element. An orthographic projection of the second pixel circuit on the substrate may be overlapped, at least partially, with an orthographic projection of the connected second light emitting element on the substrate. For example, the second pixel circuit and the second light emitting element may be connected in a one-to-one manner or in a one-to-multiple manner. In this example, different pixel circuits are provided for driving the first light emitting element and the second light emitting element respectively, which is beneficial for improving the display effect of the first display region.

In some exemplary implementations, a light emitting area of the first light emitting element may be less than a light emitting area of the second light emitting element that emits light of a same color. In this example, the light emitting area of the light emitting element may refer to an overlapping area of an anode of the light emitting element exposed by the pixel definition layer with an organic light emitting layer and a cathode. Arrangement in this example is beneficial for ensuring the light transmittance of the transmissive region.

In some exemplary implementations, a plurality of second light emitting elements of the island region and a plurality of first light emitting elements of the transmissive region may be located on a same insulation layer. In this example, the second light emitting element and the first light emitting element are disposed on a same insulation layer, which is beneficial for ensuring display uniformity of the first display region.

In some exemplary implementations, the transmissive region may include at least one first light emitting element that emits light of a first color, at least one first light emitting element that emits light of a second color, and at least one first light emitting element that emits light of a third color. The first light emitting element emitting light of the first color in the transmissive region and a plurality of second light emitting elements in the island region may be located on a same insulation layer, the first light emitting element emitting light of the second color, the first emitting element emitting light of the third color, and the first light emitting element emitting light of the first color in the transmissive region may be located on different insulation layers. A minimum distance between the first light emitting element emitting light of the first color and the substrate may be greater than a minimum distance between the first light emitting element emitting light of the second color and the substrate, and greater than a minimum distance between the first light emitting element emitting light of the third color and the substrate. In this example, the minimum distance between the first light emitting element and the substrate may refer to a vertical distance between a surface on a side of the anode of the first light emitting element away from the substrate and the surface of the substrate. In this example, by removing an insulation layer below a part of the first light emitting elements in the transmissive region, it is beneficial for improving the light transmittance of the transmissive region.

In some exemplary implementations, the first display region may further include an inter-island connection region connecting adjacent island regions. The inter-island connection region may include at least one third light emitting element. The first pixel circuit in the island region is electrically connected with at least one first light emitting element located in the transmissive region and at least one third light emitting element located in the inter-island connection region, which emit light of a same color. Alternatively, the inter-island connection region may include at least one third light emitting element and at least one third pixel circuit, wherein the at least one third pixel circuit is electrically connected with the at least one third light emitting element. For example, the third pixel circuit and the third light emitting element may be connected in a one-to-one manner or in a one-to-multiple manner. In this example, by providing the third light emitting element in the inter-island connection region, the pixel density of the first display region can be increased while the light transmittance of the first display region is ensured, thereby enabling high PPI display in the first display region.

In some exemplary implementations, the display substrate may further include a second display region located on at least one side of the first display region. A light transmittance of the second display region may be smaller than a light transmittance of the first display region. The second display region may include a plurality of second region light emitting elements and a plurality of second region pixel circuits, which are disposed on the substrate. A plurality of second region pixel circuits are electrically connected with a plurality of second region light emitting elements, and an orthographic projection of the second region pixel circuit on the substrate is overlapped, at least partially, with an orthographic projection of the connected second region light emitting element on the substrate. For example, the second region pixel circuit and the second region light emitting element may be connected in a one-to-one manner or in a one-to-multiple manner. However, the embodiment is not limited thereto.

In some exemplary implementations, the pixel density of the first display region may be less than a pixel density of the second display region. A pixel density difference between the first display region and the second display region in this example is small, which is beneficial for improving the display uniformity between the first display region and the second display region. In some other examples, the pixel density of the first display region may be equal to the pixel density of the second display region. In some other examples, the pixel density of the first display region may be greater than the pixel density of the second display region, thereby achieving high PPI display of the first display region.

In some exemplary implementations, the plurality of transmissive regions are spaced apart from each other, the plurality of transmissive regions may include at least one of the following shapes: a rounded rectangle, a circle, an oval, an octagon, a cross with twelve sides. For example, shapes of a plurality of transmissive regions included by the display substrate may be substantially the same. Alternatively, the plurality of transmissive regions included in the display substrate may be of a plurality of shapes, such as a part of the transmissive regions having the same shape and a part of the transmissive regions having different shapes. Alternatively, the shapes of the plurality of transmissive regions are different from each other. In some examples, the transmissive region may be surrounded by an island region. Alternatively, the transmissive region may be surrounded by an island region and an inter-island connection region. The shape of the transmissive region in this example is beneficial for reducing a light diffraction effect, thereby improving the display effect and a shooting effect of the display apparatus.

In some exemplary implementations, the first light emitting element located in the transmissive region may be electrically connected with the first pixel circuit, and is driven to emit light by the first pixel circuit, and the first pixel circuit may be located in an island region or an inter-island connection region. The second light emitting element located in the island region may be electrically connected with the second pixel circuit located in the island region. The third light emitting element located in the inter-island connection region may be electrically connected with the third pixel circuit, and is driven to emit light by the third pixel circuit, and the third pixel circuit may be located in the island region or the inter-island connection region. In some examples, the first pixel circuit, the second pixel circuit and the third pixel circuit may be separately disposed to drive corresponding first light emitting elements, second light emitting elements, and third light emitting elements, respectively. In some other examples, the first pixel circuit may be provided in the island region or the inter-island connection region, the second pixel circuit and the third pixel circuit may be omitted, and the first pixel circuit drives the first light emitting element, the second light emitting element, and the third light emitting element, simultaneously. In some other examples, the first pixel circuit may be provided in the island region or the inter-island connection region, the second pixel circuit may be provided in an island region, the third pixel circuit may be omitted, the first pixel circuit drives the first light emitting element and the third light emitting element simultaneously, and the second pixel circuit drives the second light emitting element. In some other examples, the first pixel circuit and the third pixel circuit may be provided in the island region or the inter-island connection region, the second pixel circuit may be omitted, the first pixel circuit drives the first light emitting element and the second light emitting element simultaneously, and the third pixel circuit drives the third light emitting element. Alternatively, the first light emitting element is driven by the first pixel circuit, and the second light emitting element and the third light emitting element are simultaneously driven by the third pixel circuit. The embodiment is not limited thereto.

Solutions of the embodiments will be described below through some examples.

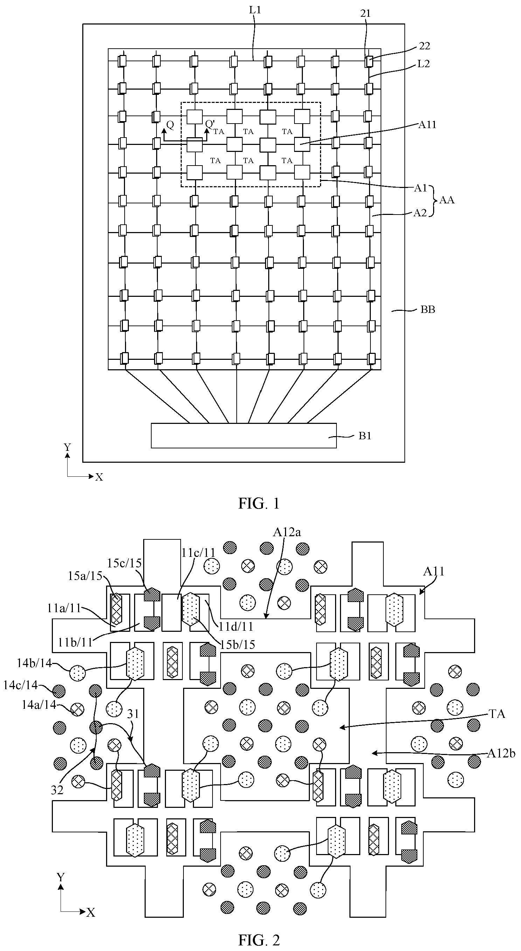

FIG. 1 is a schematic diagram of a display substrate according to at least one embodiment of the present disclosure. In some examples, as shown in FIG. 1, the display substrate may include a display region AA and a peripheral region BB located at a periphery of the display region AA. The display region AA of the display substrate may include a first display region A1 and a second display region A2. The second display region A2 may at least partially surround the first display region A1. For example, the second display region A2 may surround a periphery of the first display region A1. The peripheral region BB may surround a periphery of the second display region A2. However, the embodiment is not limited thereto. In some other examples, the display region may include only a first display region, and the peripheral region may surround a periphery of the first display region.

In some examples, as shown in FIG. 1, the first display region A1 may be a light-transmitting display region, e.g. a Full Display with Camera (FDC) region or a full display facial recognition functional region (Face ID). The second display region A2 may be a normal display region. A light transmittance of the first display region A1 may be greater than a light transmittance of the second display region A2. For example, an orthographic projection of a sensor (such as a camera and other hardware) on the display substrate may be located in the first display region A1 of the display substrate. In some examples, as shown in FIG. 1, the first display region A1 may be rectangular, a dimension of an orthographic projection of a single sensor on the display substrate may be less than or equal to a dimension of a circle inscribed within the first display region A1, and the first display region A1 may cover orthographic projection of one or more sensors on the display substrate. However, the embodiment is not limited thereto. In some other examples, the first display region A1 may be circular, and a dimension of an orthographic projection of a single sensor on the display substrate may be less than or equal to a dimension of the first display region A1.

In some examples, as shown in FIG. 1, the first display region A1 may be located at a middle position close to a top of the display region AA. The second display region A2 may surround a periphery of the first display region A1. However, the embodiment is not limited thereto. For example, the first display region A1 may be located at the middle position, an upper left corner, a lower left corner, a lower right corner, or an upper right corner of the top of the display region AA, or other positions. For example, the second display region A2 may partially surround the first display region A1, such as on one, two or three sides of the first display region A1.

In some examples, as shown in FIG. 1, the display region AA may be in a shape of a substantial rectangle, e.g., a rounded rectangle. The first display region A1 may be substantially rectangular, for example, a length of the first display region A1 along the first direction X may be greater than a length of the first display region A1 along the second direction Y. The first direction X intersects with the second direction Y. For example, the first direction X may be perpendicular to the second direction Y. However, the embodiment is not limited thereto. For example, the first display region A1 may be circular, elliptical, semicircular, pentagonal or in another shape.

In some examples, the display region AA may be provided with a plurality of sub-pixels. At least one sub-pixel may include a pixel circuit and a light emitting element. The pixel circuit may be configured to drive a light emitting element connected thereto. For example, the pixel circuit may be configured to provide a drive current to drive a light emitting element connected thereto to emit light. The pixel circuit may include a plurality of transistors and at least one capacitor. For example, the pixel circuit may be of a 3T1C, 4T1C, 5T1C, 5T2C, 6T1C, 7T1C, 8T1C, or 8T2C structure. In the above-mentioned circuit structures, T refers to a thin film transistor, C refers to a capacitor, a number before T represents a quantity of thin film transistors in the circuit, and a number before C represents a quantity of capacitors in the circuit.

In some examples, the plurality of transistors in the pixel circuit may be P-type transistors or may be N-type transistors. Usage of same type of transistors in the pixel circuit may simplify a process flow, reduce a process difficulty of the display substrate, and improve a yield of a product. In some other examples, the plurality of transistors in the pixel circuit may include a P-type transistor and an N-type transistor.

In some examples, low temperature poly silicon thin film transistors, or oxide thin film transistors, or both a low temperature poly silicon thin film transistor and an oxide thin film transistor may be used as the plurality of transistors in the pixel circuit. Low Temperature Poly Silicon (LTPS) is adopted for an active layer of a low temperature poly silicon thin film transistor and an oxide semiconductor (Oxide) is adopted for an active layer of an oxide thin film transistor. The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display substrate, that is, an LTPS + Oxide (LTPO for short) display substrate, advantages of both the low temperature poly silicon thin film transistor and the oxide thin film transistor may be utilized, so that low-frequency drive can be achieved, power consumption can be reduced, and display quality can be improved.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under driving of a pixel circuit corresponding to the light emitting element. A color of light emitted by the light emitting element may be determined as required. In some examples, the light emitting element may include an anode, a cathode, and an organic light emitting layer located between the anode and the cathode. The anode of the light emitting element may be electrically connected to a corresponding pixel circuit. However, the embodiment is not limited thereto.

In some examples, one pixel unit of the display region AA may include three sub-pixels. For example, the three sub-pixels may be a red sub-pixel, a green sub-pixel, and a blue sub-pixel, respectively. However, the embodiment is not limited thereto. In some examples, one pixel unit of the display region AA may include four sub-pixels, which may be two green sub-pixels, one red sub-pixel, and one blue sub-pixel, respectively. In some other examples, one pixel unit may include four sub-pixels, which may be a red sub-pixel, a green sub-pixel, a blue sub-pixel, and a white sub-pixel, respectively. In some examples, a shape of the light emitting element may be a rectangle, a rhombus, a pentagon, or a hexagon. When one pixel unit includes three sub-pixels, light emitting elements of the three sub-pixels may be arranged side by side horizontally, side by side vertically, or in a shape of a Chinese character "品". When one pixel unit includes four sub-pixels, light emitting elements of the four sub-pixels may be arranged side by side horizontally, side by side vertically, or in a square arrangement. However, the embodiment is not limited thereto.

In some examples, a pixel circuit in the display region AA may be connected with a plurality of first signal lines L1 extending along the first direction X and a plurality of second signal lines L2 extending along the second direction Y. For example, the plurality of first signal lines L1 may at least include a scan line and a light emitting control line. The plurality of second signal lines L2 may at least include a plurality of data lines. However, the embodiment is not limited thereto.

In some examples, the peripheral region BB may include a driver chip provision region B1 located on one side of the display region AA, and the driver chip provision region B1 may be provided with a plurality of access pins that may be connected to a plurality of second signal lines L2 in the display region AA, and may also be connected to a driver chip (IC). The driver chip may be configured to provide corresponding signals to the plurality of second signal lines L2. For example, the driver chip may be configured to provide data signals to a plurality of data lines.

In some examples, the first display region A1 may include a plurality of island regions A11 and a transmissive region TA located between adjacent island regions A11. For example, the plurality of island regions A11 may be arranged in an array. For example, a plurality of island regions arranged along the first direction X may be referred to as a row of island regions, and a plurality of island regions arranged along the second direction Y may be referred to as a column of island regions. A light transmittance of the transmissive region TA may be greater than a light transmittance of the island region A11.

In some examples, the second display region A2 may include a plurality of second region pixel circuits 21 and a plurality of second region light emitting elements 22. At least one second region pixel circuit 21 is electrically connected to at least one second region light emitting element 22, and is configured to drive the at least one second region light emitting element 22 to emit light. An orthographic projection of a second region pixel circuit 21 on the substrate may be overlapped, at least partially, with an orthographic projection of a second region light emitting element 22 electrically connected to the second region pixel circuit 21 on the substrate. For example, the second region pixel circuit and the second region light emitting element may be connected in a one-to-one manner (i.e., a one-to-one correspondence relationship) or a one-to-multiple (i.e., a one-to-multiple correspondence relationship) manner. The embodiment is not limited thereto.

FIG. 2 is a schematic diagram of a partition of a first display region according to at least one embodiment of the present disclosure. In some examples, as shown in FIGs. 1 and 2, in a plane parallel to the display substrate, the first display region A1 may include a plurality of island regions A11 separated from each other, transmissive regions TA located between adjacent island regions A11, and inter-island connection regions connecting adjacent island regions A11 (for example, a first inter-island connection region A12a and a second inter-island connection region A12b may be included). In FIG. 2, four island regions A11 arranged in an array are illustrated as an example.

In some examples, as shown in FIG. 2, in the plane parallel to the display substrate, shapes of the plurality of island regions A11 may be substantially the same, for example, may be substantially rectangular, such as may be substantially square. A plurality of inter-island connection regions may connect a plurality of display island regions A11 to each other. For example, the first inter-island connection region A12a may be a strip-shaped region extending substantially along a first direction X, and may connect adjacent island regions A11 arranged along the first direction X. The second inter-island connection region A12b may be a strip-shaped region extending substantially along a second direction Y, and may connect adjacent island regions A11 arranged along the second direction Y. For example, each island region A11 may connect two first inter-island connection regions A12a and two second inter-island connection regions A12b. One island region A11 may be connected to four other island regions surrounding the island region A11 through four inter-island connection regions. However, the embodiment is not limited thereto. In some other examples, shapes of the plurality of island regions A11 may be different or may be partially the same.

In some examples, as shown in FIG. 2, in the plane parallel to the display substrate, shapes of the plurality of transmissive regions TA may be substantially the same, such as a shape of a cross formed by twelve sides. One transmissive region TA may be surrounded by a plurality of island regions A11 and a plurality of inter-island connection regions. For example, one transmissive region TA may be surrounded by four island regions A11 arranged in a 2 × 2 array, two first inter-island connection regions A12a and two second inter-island connection regions A12b.

In some examples, an area of a single transmissive region TA may be larger than an area of a single island region A11, to increase the light transmittance of the first display region A1. However, the embodiment is not limited thereto. In some other examples, an area of a single transmissive region TA may be less than or equal to an area of a single island region A11 to improve a display effect of the first display region.

In some examples, the first display region A1 may include a plurality of first region pixel circuits and a plurality of first region light emitting elements. At least one first region pixel circuit is electrically connected to at least one first region light emitting element, and is configured to drive the at least one first region light emitting element to emit light. For example, the first region pixel circuits may be in a one-to-one correspondence with the first region light emitting elements, or may be in a one-to-multiple correspondence with the first region light emitting elements. In this example, the plurality of first region pixel circuits of the first display region A1 may include: a plurality of first pixel circuits 11 located in the island region A11, and the plurality of first region light emitting elements of the first display region A1 may include a plurality of first light emitting elements 14 located in the transmissive region TA, and a plurality of second light emitting elements 15 located in the island region A11. In this example, a pixel density of the first display region is increased by providing light emitting elements in both the transmissive region TA and the island region A11.

In some examples, as shown in FIG. 2, a single island A11 may be provided with two pixel units. For example, the two pixel units may be arranged sequentially along the second direction Y. However, the embodiment is not limited thereto. For example, the two pixel units in the island region A11 may be arranged sequentially along the first direction X. In some other examples, the island region A11 may be provided with one pixel unit or, alternatively, with one or two second light emitting elements. In this embodiment, a quantity of the second light emitting elements provided for the single island region A11 is not limited.

In some examples, as shown in FIG. 2, a plurality of first pixel circuits 11 in the island region A11 may be electrically connected to a plurality of second light emitting elements 15 in a one-to-one correspondence. That is, the first pixel circuits 11 and the second light emitting elements 15 are connected in a one-to-one manner. However, the embodiment is not limited thereto. In some other examples, the first pixel circuits and the second light emitting elements in the island region may be connected in a one-to-multiple manner.

In some examples, as shown in FIG. 2, each pixel unit of the island region A11 may include four second light emitting elements 15, and four first pixel circuits 11 (including, for example, first pixel circuits 11a, 11b, 11c, and 11d) connected to the four second light emitting elements 15. Four first pixel circuits 11a, 11b, 11c, and 11d of each pixel unit may be arranged sequentially along the first direction X, and electrically connected to the four second light emitting elements 15 in a one-to-one correspondence. For example, an island region A11 provided with two pixel units arranged along the second direction Y is taken as an example, wherein eight first pixel circuits 11 included in the two pixel units may be arranged in two rows and four columns. Four first pixel circuits 11 located in a same row are connected to four second light emitting elements of the same pixel unit. An orthographic projection of each second light emitting element 15 on the substrate may be overlapped, at least partially, with an orthographic projection of the connected first pixel circuit 11 on the substrate. Alternatively, an orthographic projection of a part of the second light emitting elements 15 on the substrate may be overlapped, at least partially, with an orthographic projection of the connected first pixel circuit 11 on the substrate, and an orthographic projection of the other part of the second light emitting elements 15 on the substrate may be not overlapped with an orthographic projection of the connected first pixel circuit 11 on the substrate.

In some examples, as shown in FIG. 2, four second light emitting elements 15 of each pixel unit of the island region A11 may include one second light emitting element 15a emitting light of a first color, one second light emitting element 15b emitting light of a second color, and two second light emitting elements 15c emitting light of a third color. The two second light emitting elements 15c emitting light of the third color light may be arranged in a same column along the second direction Y, the first light emitting elements 15a and 15b may be arranged in a same row along the first direction X, and the second light emitting elements 15a and 15b and the second light emitting elements 15c may be located in different rows and different columns. The first pixel circuit 11a may be electrically connected with the first light emitting element 15a, the first pixel circuit 11b may be electrically connected with one second light emitting element 15c, the first pixel circuit 11c may be electrically connected with the other second light emitting element 15c, and the first pixel circuit 11d may be electrically connected with the second light emitting element 15b. However, the embodiment is not limited thereto.

In some examples, the light of the first color may be red light, the light of the second color may be blue light, and the light of the third color may be green light. Orthographic projections of light emitting regions of the second light emitting elements 15a and 15b on the substrate may be substantially hexagonal, and orthographic projections of light emitting regions of the second light emitting elements 15c on the substrate may be substantially pentagonal. However, the embodiment is not limited thereto.

In some examples, a light emitting area of a single second light emitting element 15a may be smaller than a light emitting area of a single second light emitting element 15b, and a light emitting area of a single second light emitting element 15c may be smaller than a light emitting area of the single second light emitting element 15a.

In some examples, as shown in FIG. 2, the transmissive region TA may include a plurality of first light emitting elements 14, for example including at least one first light emitting element 14a emitting light of the first color, at least one first light emitting element 14b emitting light of the second color, and at least one first light emitting element 14c emitting light of the third color. A plurality of first light emitting elements 14 within a single transmissive region TA may be uniformly arranged throughout the transmissive region TA. A quantity of the first light emitting elements 14 within the single transmissive region TA may be different from a quantity of the second light emitting elements 15 within a single island region A11. For example, the quantity of the first light emitting elements 14 within the single transmissive region TA may be greater than the quantity of the second light emitting elements 15 within the single island region A11. However, the embodiment is not limited thereto. For example, the quantity of the first light emitting elements of the single transmissive region TA may be less than or equal to the quantity of the second light emitting elements within the single island region A11.

In some examples, orthographic projections of light emitting regions of the first light emitting elements 14a, 14b and 14c on the substrate may be substantially circular or elliptical. A light emitting area of a single first light emitting element 14a may be smaller than a light emitting area of a single first light emitting element 14b, and a light emitting area of a single first light emitting element 14c may be smaller than a light emitting area of the single first light emitting element 14a.

In some examples, arrangement of a plurality of first light emitting elements 14 in the transmissive region TA may be the same as arrangement of a plurality of second light emitting elements 15 in the island region A11. For example, the first light emitting elements 14a emitting light of the first color and the first light emitting elements 14b emitting light of the second color may be arranged at intervals along the first direction X and the second direction Y, the first light emitting elements 14c emitting light of the third color may be arranged in an array along the first direction X and the second direction Y, and the first light emitting elements 14c and the first light emitting elements 14a and 14b may be located in different columns and different rows. However, the embodiment is not limited thereto. In some other examples, arrangement of a plurality of first light emitting elements in the transmissive region TA may be different from arrangement of a plurality of second light emitting elements in the island region A11.

In some examples, a light emitting area of a first light emitting elements 14 in the transmissive region TA may be smaller than a light emitting area of a second light emitting element 15 in the island region A11 emitting light of a same color. For example, the light emitting area of the first light emitting element 14a may be smaller than the light emitting area of the second light emitting element 15a, the light emitting area of the first light emitting element 14b may be smaller than the light emitting area of the second light emitting element 15b, and the light emitting area of the first light emitting element 14c may be smaller than the light emitting area of the second light emitting element 15c. In this example, a display effect of the island region A11 and a light transmittance of the transmissive region TA can be guaranteed. However, the embodiment is not limited thereto. In some other examples, a light emitting area of a first light emitting element may be larger than or equal to a light emitting area of a second light emitting element that emits light of a same color.

In some examples, a first light emitting element 14 in the transmissive region TA may be electrically connected to a first pixel circuit 11 in an adjacent island region A11. First pixel circuits 11 in the island region A11 and first light emitting elements 14 in the transmissive region TA may be connected in a one-to-multiple manner. For example, the first pixel circuit 11 may be connected with a plurality of first light emitting elements 14 emitting light of a same color in the transmissive region TA. The plurality of first light emitting elements 14 connected to the first pixel circuit 11 may be located in a same transmissive region TA, or may be located in different transmissive regions TA.

In some examples, the first pixel circuit 11 in the island region A11 may be configured to drive a plurality of first region light emitting elements emitting light of a same color (including, for example, one second light emitting element 15 located in the same island region A11 and a plurality of first light emitting elements 14 located in at least one transmissive region TA adjacent to the island region A11). In this example, the first pixel circuit disposed in the island region A11 is configured to drive the first light emitting elements in the transmissive region, which can be beneficial for ensuring the light transmittance of the transmissive region; and the first pixel circuit is configured to drive the first light emitting element and the second light emitting element simultaneously, which can be beneficial for reducing an arrangement space for a pixel circuit, and ensuring a light transmittance of the first display region.

In some examples, as shown in FIG. 2, the first pixel circuit 11 is connected with at least one first light emitting element 14 through at least one connection line. A plurality of first light emitting elements 14 emitting light of a same color in a same transmissive region TA may be connected through a second connection line 32, one of the plurality of first light emitting elements 14 may be connected with a second light emitting element 15 emitting light of the same color in an adjacent island region A11 through a first connection line 31, and may be connected with a same first pixel circuit 11 through the second light emitting element 15, so that the plurality of first light emitting elements 14 emitting light of the same color in the transmissive region TA and one second light emitting element 15 in the island region A11 may be connected with the same first pixel circuit 11. In FIG. 2, a connection relationship between several first light emitting elements 14 and several second light emitting elements 15 is illustrated as an example, and a connection relationship between remaining first light emitting elements 14 and second light emitting element 15 is omitted. For example, the first light emitting element 14 may be connected to an adjacent second light emitting element 15 emitting light of the same color through the first connection line 31, and may be connected to the plurality of first light emitting elements 14 connected to the same first pixel circuit 11 through the second connection line 32. In some examples, the first connection line 31 and the second connection line 32 connected to the plurality of first light emitting elements 14 connected to the same first pixel circuit 11 may be connected to each other to form an integral structure. However, the embodiment is not limited thereto.

In some examples, which first light emitting element 14 or which second light emitting element 15 will be determined to be connected to a first light emitting element 14 in the transmissive region TA, according to distances between the first light emitting element 14 to adjacent first light emitting elements 14 and second light emitting elements 15 emitting light of the same color in the transmissive region TA. For example, the first light emitting element 14 may be connected to the nearest first light emitting element 14 or second light emitting element 15 emitting light of the same color, so as to ensure that a length of the connected first connection line 31 or second connection line 32 is the shortest, thereby reducing an influence on the display effect of the first display region caused by an increased load due to a longer connection line.

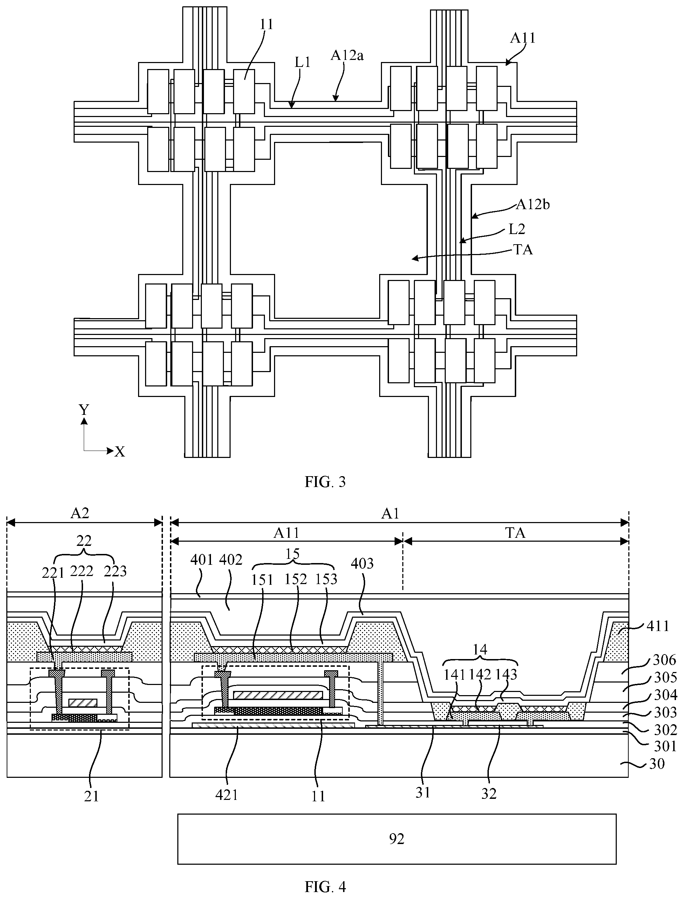

FIG. 3 illustrates an example of a circuit and trace arrangement of the first display region in FIG. 2. In some examples, as shown in FIGs. 2 and 3, a single island region A11 may include a plurality of first pixel circuits 11. The first pixel circuit 11 may be connected with a plurality of first signal lines L1 extending along a first direction X, and may also be connected to a plurality of second signal lines L2 extending along a second direction Y. A first inter-island connection region A12a may be provided with a plurality of first signal lines L1 extending along the first direction X, and a second inter-island connection region A12b may be provided with a plurality of second signal lines L2 extending along the second direction Y.

In some examples, the plurality of first signal lines L1 and the plurality of second signal lines L2 may be made of a metal material. Edges of the first inter-island connection region A12a and the second inter-island connection region A12b may be determined by a peripheral edge shape of the signal lines disposed in the inter-island connection regions. For example, the edges of the first inter-island connection region A12a and the second inter-island connection region A12b may be non-planarized edges, such as may have a protrusion or a recess, or may be substantially arc-shaped. However, the embodiment is not limited thereto. In some other examples, edges of the first inter-island connection region A12a and the second inter-island connection region A12b may be determined by a peripheral edge shape of a shading layer (e.g., a shading layer made of a metal material or a black shading layer made of another material), wherein the shading layer may cover a non-luminous region of the island region as well as the inter-island connection region.

In some examples, the signal lines in the first inter-island connection region A12a and the second inter-island connection region A12b may be made of a transparent conductive material, such that adjacent transmissive regions TA may be communicated with each other. The transmissive regions TA may surround the island region A11. In this example, the light transmittance of the first display region may be improved.

FIG. 4 illustrates schematically a partial cross-sectional view of a display substrate according to at least one embodiment of the present disclosure. FIG. 4 illustrates schematically a partial cross-sectional view taken along a direction Q-Q' in FIG. 1. In some examples, as shown in FIG. 4, in a direction perpendicular to the display substrate, the display substrate may include a substrate 30, and a circuit structure layer, a light emitting structure layer, and an encapsulation structure layer which are disposed on the substrate 30, sequentially. In some examples, the display substrate may further include other film layers, e.g. a touch structure layer, a color filter layer and the like. The embodiment is not limited thereto.

In some examples, a circuit structure layer of the first display region A1 may include a first pixel circuit 11 located in the island region A11, and a light emitting structure layer of the first display region A1 may include a second light emitting element 15 located in the island region A11 and a first light emitting element 14 located in the transmissive region TA. A circuit structure layer of the second display region A2 may include a second region pixel circuit 21, and a light emitting structure layer of the second display region A2 may include a second region light emitting element 22. In FIG. 4, one transistor of one second region pixel circuit 21 and one second region light emitting element 22 in the second display region A2 are illustrated as an example, and one transistor of one first pixel circuit 11, one second light emitting element 15 and two first light emitting elements 14 emitting light of a same color (for example, two first light emitting elements 14 and one second light emitting element 15 emitting light of the first color) in the first display region A1 are illustrated as an example.

In some examples, the circuit structure layer may include a shielding layer 421, a semiconductor layer, a first conductive layer, a second conductive layer, and a third conductive layer disposed on the substrate 30. A first insulation layer 301 (also referred to as a first buffer layer) may be provided between the shielding layer 421 and the substrate 30, a second insulation layer 302 (also referred to as a second buffer layer) may be provided between the shielding layer 421 and the semiconductor layer, a third insulation layer 303 (also referred to as a first gate insulation layer) may be provided between the semiconductor layer and the first conductive layer, a fourth insulation layer 304 (also referred to as a second gate insulation layer) may be provided between the first conductive layer and the second conductive layer, a fifth insulation layer 305 (also referred to as an inter-layer insulation layer) may be provided between the second conductive layer and the third conductive layer, and a sixth insulation layer 306 (also referred to as a first planarization layer) may be provided on a side of the third conductive layer away from the substrate 30. The first conductive layer may also be referred to as a first gate metal layer, the second conductive layer may also be referred to as a second gate metal layer, and the third conductive layer may also be referred to as a first source-drain metal layer. In some examples, the shielding layer 421, the first conductive layer, the second conductive layer, and the third conductive layer may be made of a metal material.

In some examples, the first insulation layer 301 to the fifth insulation layer 305 may be inorganic insulation layers, and the sixth insulation layer 306 may be an organic insulation layer. However, the embodiment is not limited thereto. In some other examples, an inorganic insulation layer may be provided between the sixth insulation layer 306 and the third conductive layer.

In some examples, the shielding layer 421 may be located, at least, in the island region A11 of the first display region A1, and an orthographic projection of the shielding layer 421 on the substrate 30 may cover an orthographic projection of an active layer of at least one transistor of the first pixel circuit 11 of the island region A11 on the substrate 30. For example, the first pixel circuit 11 includes a plurality of transistors, and the orthographic projection of the shielding layer 421 on the substrate may cover orthographic projections of active layers of all transistors of the first pixel circuit 11 on the substrate. Alternatively, the orthographic projection of the shielding layer 421 on the substrate may cover orthographic projections of active layers of a part of the plurality of transistors of the first pixel circuit 11 on the substrate. In this example, by providing the shielding layer 421 in the island region A11 to cover the active layer of the transistor of the first pixel circuit 11, interference from external light to the transistor of the first pixel circuit 11 can be avoided, and performance of the transistor of the first pixel circuit 11 can be ensured.

In some examples, the semiconductor layer may include, at least, the active layer of the transistor of the first pixel circuit 11 located in the island region A11, and an active layer of a transistor of the second region pixel circuit 21 located in the second display region A2. The first conductive layer may include, at least, a gate of the transistor and a first electrode of a storage capacitor (not shown) of the first pixel circuit 11 located in the island region A11, and a gate of the transistor and a first electrode of a storage capacitor (not shown) of the second region pixel circuit 21 located in the second display region A2. The second conductive layer may include, at least, a second electrode (not shown) of the storage capacitor of the first pixel circuit 11, and a second electrode (not shown) of the storage capacitor of the second region pixel circuit 21. The third conductive layer may include, at least, a first electrode and a second electrode of the transistor of the first pixel circuit 11, and a first electrode and a second electrode of the transistor of the second region pixel circuit 21.

In some examples, the light emitting structure layer may include an anode layer, a pixel definition layer 411, an organic functional layer, and a cathode layer that are disposed sequentially. The anode layer may include, at least, an anode 141 of the first light emitting element 14 located in the transmissive region TA, an anode 151 of the second light emitting element 15 located in the island region A11, and an anode 221 of the second region light emitting element 22 located in the second display region A2. The organic functional layer may include, at least, an organic light emitting layer 142 of the first light emitting element 14 located in the transmissive region TA, an organic light emitting layer 152 of the second light emitting element 15 located in the island region A11, and an organic light emitting layer 222 of the second region light emitting element 22 located in the second display region A2. The cathode layer may include, at least, a cathode 143 of the first light emitting element 14 located in the transmissive region TA, a cathode 153 of the second light emitting element 15 located in the island region A11, and a cathode 223 of the second region light emitting element 22 located in the second display region A2.

In some examples, the anode 221 of the second region light emitting element 22 may be located on the sixth insulation layer 306, and connected with the second region pixel circuit 21 through a via opened in the sixth insulation layer 306. The pixel definition layer 411 may be provided with a third pixel opening opened in the second display region A2, and the third pixel opening may expose at least a part of a surface of the anode 221 of the second region light emitting element 22. The organic light emitting layer 222 and the cathode 223 of the second region light emitting element 22 may be sequentially stacked within the third pixel opening.

In some examples, the anode 151 of the second light emitting element 15 may be located on the sixth insulation layer 306, and connected with the first pixel circuit 11 through the via opened in the sixth insulation layer 306. The pixel definition layer 411 may be provided with a second pixel opening in the island region A11 of the first display region A1, and the second pixel opening may expose at least a part of a surface of the anode 151 of the second light emitting element 15. The organic light emitting layer 152 and the cathode 153 of the second light emitting element 15 may be sequentially stacked within the second pixel opening.

In some examples, the anode 141 of the first light emitting element 14 may be located on the second insulation layer 302. For example, after the sixth insulation layer 306 is manufactured, a sixth insulation layer 306, a fifth insulation layer 305, a fourth insulation layer 304, and a third insulation layer 303 in the transmissive region TA may be removed, so that the anode 141 of the first light emitting element 14 may be formed on the second insulation layer 302, and connected with a first connection line 31 and a second connection line 32 through a via opened in the second insulation layer 302. However, the embodiment is not limited thereto. In some other examples, the anode 141 of the first light emitting element 14 may be located on the third insulation layer, the fourth insulation layer, the fifth insulation layer, or the sixth insulation layer.

The first connection line 31 and the second connection line 32 in this example may be connected to each other to form an integral structure, and may be located in a same layer as the shielding layer 421. The anodes 141 of the two first light emitting elements 14 emitting light of the same color in the transmissive region TA may be connected through the second connection line 32, and the anodes 141 of the two first light emitting elements 14 may be connected with the anode 151 of the second light emitting element 15 emitting light of the same color in the island region A11 through the first connection line 31, so as to connect with the same first pixel circuit 11. The anode 151 of the second light emitting element 15 of the island region A11 may be connected with the first connection line 31 through a via penetrating the sixth insulation layer 306, the fifth insulation layer 305, the fourth insulation layer 304, the third insulation layer 303, and the second insulation layer 302. However, the embodiment is not limited thereto. In some other examples, the first connection line 31 and the second connection line 32 may be located in a layer different from the shielding layer 421. For example, the first connection line 31 and the second connection line 32 may be located in a same layer as the first conductive layer, the second conductive layer, or the third conductive layer. In some other examples, the first connection line 31 and the second connection line 32 may be located in different layers. For example, the first connection line 31 may be located in a same layer as the shielding layer 421, and the second connection line 32 may be located on a side of the first connection line 31 close to the substrate 30, or on a side of the first connection line 31 away from the substrate 30.

In this example, the first light emitting element 14 and the second light emitting element 15 are located on different insulation layers. By removing a plurality of insulation layers on a side of the first light emitting element 14 close to the substrate 30 in the transmissive region TA, so that the first light emitting element 14 is nearer to the substrate 30, which is convenient to design the first connection line and the second connection line disposed in a same layer as the shielding layer. Moreover, in this example, a part of the insulation layers of the transmissive region TA is dug off, which is beneficial for improving the light transmittance of the transmissive region TA.

In some examples, the cathode 223 of the second region light emitting element 22, the cathode 143 of the first light emitting element 14, and the cathode 153 of the second light emitting element 15 may be connected to each other to form an integral structure. The cathode layer of the second display region A2 may be a whole-surface structure, and the cathode layer of the first display region A1 may be patterned. For example, the cathode layer of a region other than the light emitting element may be removed to improve the light transmittance of the first display region A1.

In some examples, the encapsulation structure layer may include a first encapsulation layer 401, a second encapsulation layer 402, and a third encapsulation layer 403 which are stacked, wherein the first encapsulation layer 401 and the third encapsulation layer 403 may be made of an inorganic material, the second encapsulation layer 402 may be made of an organic material, and the second encapsulation layer 402 may be disposed between the first encapsulation layer 401 and the third encapsulation layer 403 to form a laminated structure of an inorganic material/an organic material/an inorganic material, which can ensure that external water vapor cannot enter the light emitting structure layer.

In some examples, a sensor 92 may be provided on a non-display side of the display substrate, and an orthographic projection of the sensor 92 on the display substrate may be overlapped with the first display region A1 of the display substrate.

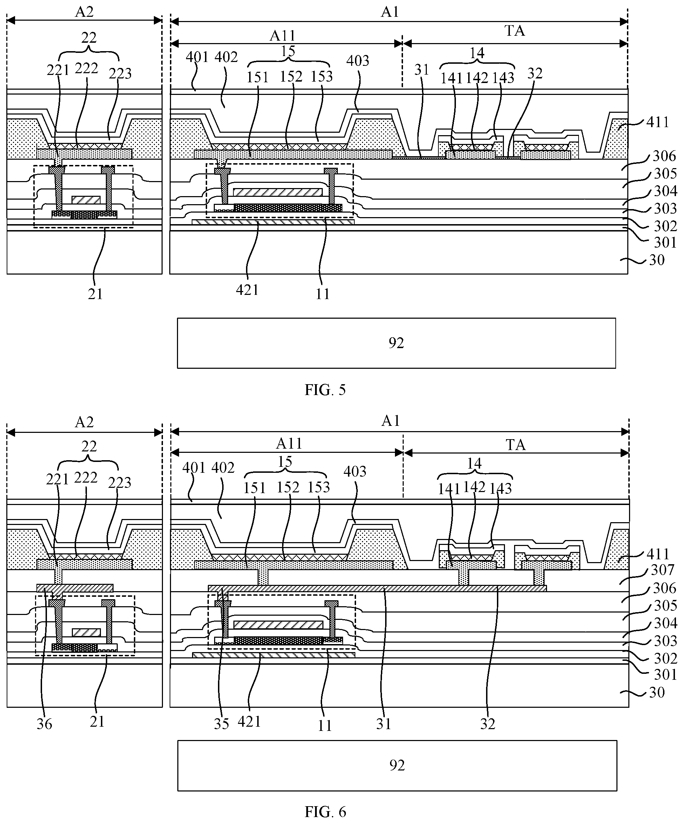

FIG. 5 illustrates schematically another partial cross-sectional view of a display substrate according to at least one embodiment of the present disclosure. FIG. 5 illustrates schematically another partial cross-sectional view taken along the Q-Q' direction in FIG. 1. In some examples, as shown in FIG. 5, both an anode 141 of a first light emitting element 14 of a transmissive region TA and an anode 151 of a second light emitting element 15 of an island region A11 may be located on a sixth insulation layer 306. Anodes 141 of first light emitting elements 14 that emit light of a same color and are connected to a same first pixel circuit 11 in the transmissive region TA may be connected through a second connection line 32, wherein an anode 141 of one of the first light emitting elements 14 may be connected with the anode 151 of the second light emitting element 15 through a first connection line 31.

In some examples, the anode layer may include a first sub-conductive layer, a second sub-conductive layer, and a third sub-conductive layer which are stacked. The second sub-conductive layer is located between the first sub-conductive layer and the third sub-conductive layer, the first sub-conductive layer is located on a side of the second sub-conductive layer close to the substrate 30, and the third sub-conductive layer is located on a side of the second sub-conductive layer away from the substrate 30. Materials of the first sub-conductive layer and the third sub-conductive layer may be the same. For example, a transparent conductive material may be used, such as Indium Tin Oxide (ITO). The second sub-conductive layer may be made of a metal material, including silver (Ag), for example. An anode of each light emitting element may include three stacked anode sub-layers, wherein a first anode sub-layer may be located on the first sub-conductive layer, a second anode sub-layer may be located on the second sub-conductive layer, and a third anode sub-layer may be located on the third sub-conductive layer.

In some examples, the first connection line 31 and the second connection line 32 may be located in a same layer as the first sub-conductive layer of the anode layer. However, the embodiment is not limited thereto. For example, the first connection line 31 and the second connection line 32 may be located in a same layer as the second sub-conductive layer or the third sub-conductive layer. In some other examples, the first connection line 31 and the second connection line 32 may be located in a same layer as different sub-conductive layers of the anode layer. For example, the first connection line 31 may be located in a same layer as the first sub-conductive layer, and the second connection line 32 may be located in a same layer as the third sub-conductive layer.

In this example, the first connection line 31 and the second connection line 32 are made of a transparent conductive material and are manufactured synchronously with the anode layer, which can be beneficial for improving a light transmittance of the transmissive region, and can also be beneficial for decreasing manufacturing acts, thereby saving costs. Remaining description of the display substrate in this example may be referred to the description in the aforementioned embodiments, which is not repeated here.

FIG. 6 illustrates schematically another partial cross-sectional view of a display substrate according to at least one embodiment of the present disclosure. FIG. 6 illustrates schematically another partial cross-sectional view taken along the Q-Q' direction in FIG. 1. In some examples, as shown in FIG. 6, in a direction perpendicular to the display substrate, the display substrate may include a substrate 30, and a circuit structure layer, a transparent conductive layer, a light emitting structure layer, and an encapsulation structure layer which are disposed on the substrate 30. The transparent conductive layer may be located between the circuit structure layer and the light emitting structure layer. The transparent conductive layer may be located above the sixth insulation layer 306 of the circuit structure layer, and a seventh insulation layer (which may also be referred to as a second planarization layer) 307 may be provided between the transparent conductive layer and the light emitting structure layer. An anode layer of the light emitting structure layer may be located above the seventh insulation layer 307. For example, the transparent conductive layer may be made of a transparent conductive material that may include ITO, for example.

In some examples, the transparent conductive layer may include a second anode connection electrode 36 located in a second display region A2, and a first anode connection electrode 35, a first connection line 31, and a second connection line 32 located in a first display region A1. An anode 221 of a second region light emitting element 22 may be connected with the second anode connection electrode 36 through a via opened in the seventh insulation layer 307, and the second anode connection electrode 36 may be connected with a second region pixel circuit 21 through a via opened in the sixth insulation layer 306, thereby achieving electrical connection between the anode 221 of the second region light emitting element 22 and the second region pixel circuit 21.

In some examples, an anode 151 of a second light emitting element 15 may be connected with the first anode connection electrode 35 through a via opened in the seventh insulation layer 307, and the first anode connection electrode 35 may be connected with a first pixel circuit 11 through a via opened in the sixth insulation layer 306. An anode 141 of a first light emitting element 14 may be connected with the first connection line 31 or the second connection line 32 through a via opened in the seventh insulation layer 307. A first anode connection electrode 35, a first connection line 31, and a second connection line 32 electrically connected to a same first pixel circuit 11 may be connected to each other to form an integral structure, so that two first light emitting elements 14 and one second light emitting element 15 which emit light of a same color are electrically connected to the same first pixel circuit 11. However, the embodiment is not limited thereto. In some other examples, the display substrate may include a plurality of transparent conductive layers made of a transparent conductive material, and the first connection line and the second connection line may be located in different transparent conductive layers.

In this example, the first connection line and the second connection line are made of a transparent conductive material, which is beneficial for improving a light transmittance of a transmissive region. Remaining description of the display substrate in this example may be referred to the description in the aforementioned embodiments, which is not repeated here.

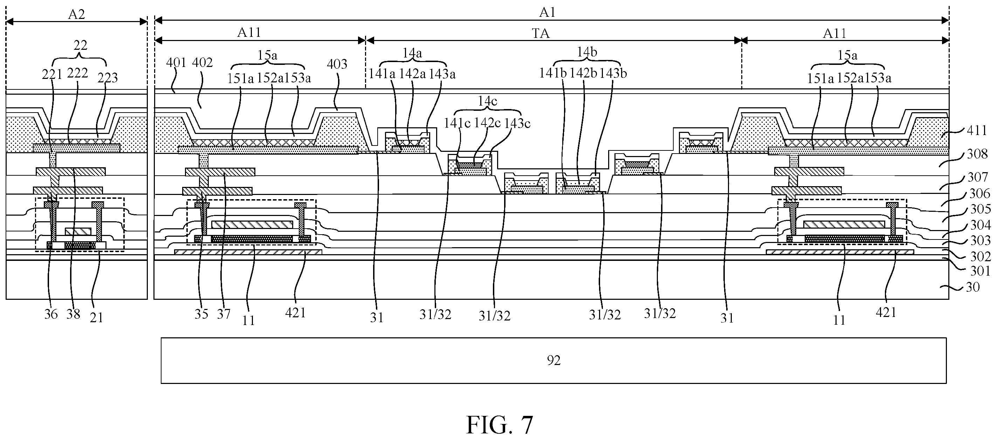

FIG. 7 illustrates schematically another partial cross-sectional view of a display substrate according to at least one embodiment of the present disclosure. FIG. 7 illustrates schematically another partial cross-sectional view taken along the Q-Q' direction in FIG. 1. In some examples, as shown in FIG. 7, in a direction perpendicular to the display substrate, the display substrate may include a substrate 30, and a circuit structure layer, a first transparent conductive layer, a second transparent conductive layer, a light emitting structure layer, and an encapsulation structure layer which are disposed on the substrate 30. The first transparent conductive layer may be located between the circuit structure layer and the second transparent conductive layer, the first transparent conductive layer may be located above a sixth insulation layer 306 of the circuit structure layer, a seventh insulation layer 307 may be provided between the first transparent conductive layer and the second transparent conductive layer, and an eighth insulation layer (may also be referred to as a third planarization layer) 308 may be provided on a side of the second transparent conductive layer away from the substrate 30. The first transparent conductive layer and the second transparent conductive layer may be made of a transparent conductive material, which may include ITO, for example.

In some examples, the first transparent conductive layer may include a second anode connection electrode 36 located in a second display region A2, and a first anode connection electrode 35 located in an island region A11 of a first display region A1. The second transparent conductive layer may include a fourth anode connection electrode 38 located in the second display region A2, and a third anode connection electrode 37 located in the island region A11 of the first display region A1. An anode 221 of a second region light emitting element 22 may be connected with the fourth anode connection electrode 38 through a via opened in the eighth insulation layer 308, the fourth anode connection electrode 38 may be connected with the second anode connection electrode 36 through a via opened in a seventh insulation layer 307, and the second anode connection electrode 36 may be connected with a second region pixel circuit 21 through a via opened in a sixth insulation layer 306. An anode 151a of a second light emitting element 15a may be connected with the third anode connection electrode 37 through a via opened in the eighth insulation layer 308, the third anode connection electrode 37 may be connected with the first anode connection electrode 35 through a via opened in the seventh insulation layer 307, and the first anode connection electrode 35 may be connected with a first pixel circuit 11 through a via opened in the sixth insulation layer 306.

In some examples, the second light emitting element 15a, which includes the anode 151a, an organic light emitting layer 152a, and a cathode 153a, may be located on the eighth insulation layer 308. A second light emitting element in the island region A11 and a part of first light emitting elements (e.g., a first light emitting element 14a) in a transmissive region TA may be located on a same insulation layer. For example, the second light emitting element in the island region A11 and a first light emitting element emitting light of a first color in the transmissive region TA may be located on a same insulation layer. In some other examples, the second light emitting element in the island region A11 may be located on a same insulation layer as a first light emitting element emitting light of a second color or a third color light in the transmissive region TA.

In some examples, first light emitting elements emitting light of different colors in the transmissive region TA may be located on different insulation layers, and first light emitting elements emitting light of a same color may be located on a same insulation layer. For example, a first light emitting element 14a (including an anode 141a, an organic light emitting layer 142a, and a cathode 143a) emitting light of the first color in the transmissive region TA may be located on the eighth insulation layer 308, a first light emitting element 14b (including an anode 141b, an organic light emitting layer 142b, and a cathode 143b) emitting light of the second color may be located on the sixth insulation layer 306, and a first light emitting element 14c (including an anode 141c, an organic light emitting layer 142c, and a cathode 143c) emitting light of the third color may be located on the seventh insulation layer 307. A minimum distance between the first light emitting element 14a and the substrate 30 may be greater than a minimum distance between the first light emitting element 14c and the substrate 30, and the minimum distance between the first light emitting element 14c and the substrate 30 may be greater than a minimum distance between the first light emitting element 14b and the substrate 30. However, the embodiment is not limited thereto. In some other examples, the first light emitting elements emitting light of the first color and the second color may be located on a same insulation layer, and the first light emitting element emitting light of the third color and the first light emitting element emitting light of the first color may be located on different insulation layers.

In some other examples, which insulation layer a first light emitting element is disposed on is distinguished based on a distance between the first light emitting element in the transmissive region TA and a center of the transmissive region TA. For example, a plurality of first light emitting elements close to the center of the transmissive region TA may be located on a same insulation layer, and a plurality of first light emitting elements away from the center of the transmissive region TA may be located on a same insulation layer that is different from the insulation layer on which the plurality of first light emitting elements close to the center of the transmissive region TA are located. For example, a minimum distance between the plurality of first light emitting elements away from the center of the transmissive region TA and the substrate may be greater than a minimum distance between the plurality of first light emitting elements close to the center of the transmissive region TA and the substrate.

In this example, a part of the insulation layers in the transmissive region is removed, which can reduce a thickness of the insulation layers in the transmissive region, and is beneficial for improving the light transmittance of the transmissive region. Moreover, the first light emitting elements that emit light of different colors are disposed on different insulation layers, so that a display effect of the transmissive region can be optimized. In this example, by providing insulation layers of different heights in the transmissive region, it can be advantageous to reduce diffraction.

In some examples, an anode layer may include a first sub-conductive layer, a second sub-conductive layer, and a third sub-conductive layer which are stacked. Materials of the first sub-conductive layer and the third sub-conductive layer may be the same. For example, a transparent conductive material may be used, such as Indium Tin Oxide (ITO). The second sub-conductive layer may be made of a metal material, including silver (Ag), for example. A first connection line 31 or a second connection line 32 to which the first light emitting elements are connected may be located in a same layer as a sub-conductive layer of the anode layer. For example, both the first connection line 31 and the second connection line 32 may be in a same layer as the first sub-conductive layer. For example, the anode 141a of the first light emitting element 14a may be connected with the anode 151a of the second light emitting element 15a through the first connection line 31 to achieve electrical connection with the same first pixel circuit 11, and a part of the first connection line 31, a part of the anode 141a of the first light emitting element 14a, and a part of the anode 151a of the second light emitting element 15a in the first sub-conductive layer may be connected to each other to form an integral structure. However, the embodiment is not limited thereto. In some other examples, first connection lines and second connection lines connected to first light emitting elements emitting light of different color may be located in a same layer as different sub-conductive layers, respectively. For example, the first connection lines and the second connection lines connected to the first light emitting elements emitting light of the first color and the second color may be in a same layer as the first sub-conductive layer, and the first connection lines and the second connection lines connected to the first light emitting elements emitting light of the third color may be located in a same layer as the third sub-conductive layer.

In this example, the first connection line and the second connection line are made of a transparent conductive material and are manufactured synchronously with the anode layer, which can be beneficial for ensuring a light transmittance of the transmissive region, and can also be beneficial for decreasing manufacturing acts, thereby saving costs. Remaining description of the display substrate in this example may be referred to the description in the aforementioned embodiments, which is not repeated here.

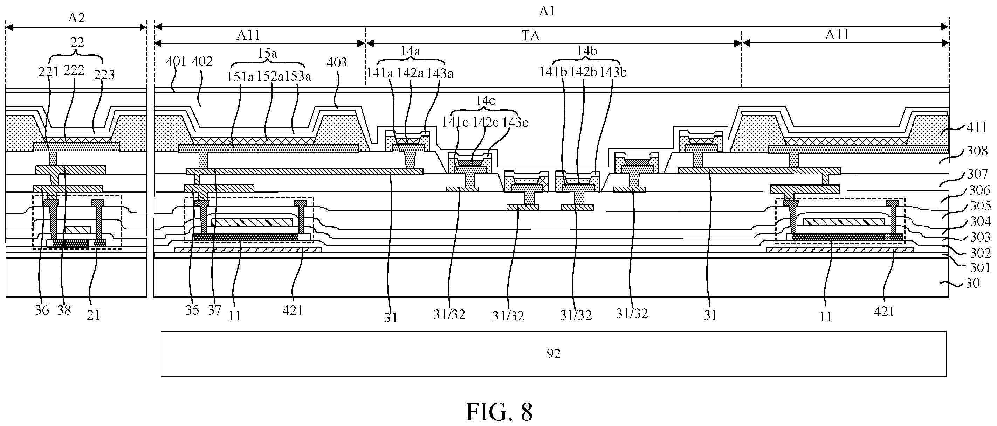

FIG. 8 illustrates schematically another partial cross-sectional view of a display substrate according to at least one embodiment of the present disclosure. FIG. 8 illustrates schematically another partial cross-sectional view taken along the Q-Q' direction in FIG. 1. In some examples, as shown in FIG. 8, in a direction perpendicular to the display substrate, the display substrate may include a substrate 30, and a circuit structure layer, a first transparent conductive layer, a second transparent conductive layer, a light emitting structure layer, and an encapsulation structure layer which are disposed on the substrate 30. The first transparent conductive layer and the second transparent conductive layer may be made of a transparent conductive material, which may include ITO, for example. The first transparent conductive layer may include a second anode connection electrode 36 located in a second display region A2, and a first anode connection electrode 35 located in an island region A11 of a first display region A1. The second transparent conductive layer may include a fourth anode connection electrode 38 located in the second display region A2, and a third anode connection electrode 37 located in the island region A11 of the first display region A1.

In some examples, first light emitting elements emitting light of different colors in the transmissive region TA may be located on different insulation layers, and first light emitting elements emitting light of a same color may be located on a same insulation layer. For example, a first light emitting element 14a (including an anode 141a, an organic light emitting layer 142a, and a cathode 143a) emitting light of the first color in the transmissive region TA may be located on the eighth insulation layer 308, a first light emitting element 14b (including an anode 141b, an organic light emitting layer 142b, and a cathode 143b) emitting light of the second color may be located on the sixth insulation layer 306, and a first light emitting element 14c (including an anode 141c, an organic light emitting layer 142c, and a cathode 143c) emitting light of the third color may be located on the seventh insulation layer 307.

In some examples, a first connection line 31 or a second connection line 32 connected to the first light emitting element 14a emitting light of the first color in the transmissive region TA may be located in the second transparent conductive layer, a first connection line 31 or a second connection line 32 connected to the first light emitting element 14c emitting light of the third color in the transmissive region TA may be located in the first transparent conductive layer, and a first connection line 31 or a second connection line 32 connected to the first light emitting element 14b emitting light of the second color in the transmissive region TA may be located in a third conductive layer. However, the embodiment is not limited thereto. In some other examples, the first connection line 31 or the second connection line 32 connected to the second light emitting element 14b emitting light of the second color in the transmissive region TA may be located in a transparent conductive layer on a side of the third conductive layer away from the substrate.

In this example, the first connection lines and the second connection lines connected to the first light emitting element emitting light of different colors are disposed in different film layers, so that a plurality of first connection lines and second connection lines can be reasonably arranged. Remaining description of the display substrate in this example may be referred to the description in the aforementioned embodiments, which is not repeated here.

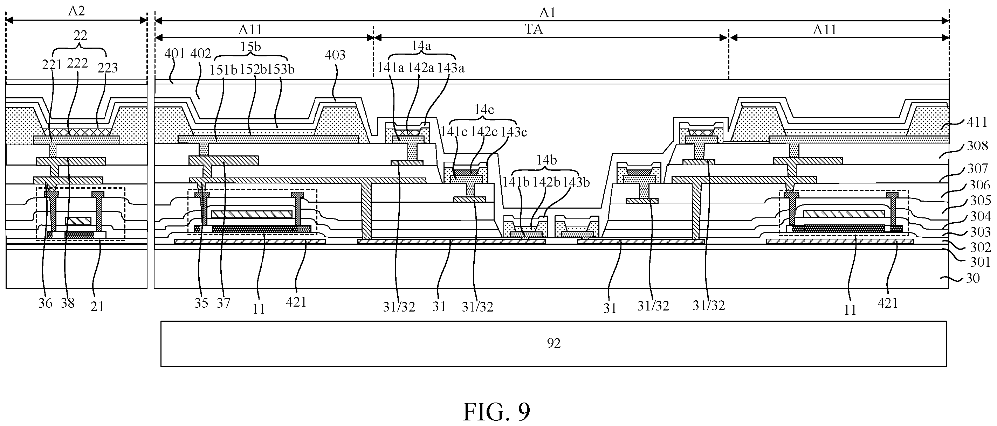

FIG. 9 illustrates schematically another partial cross-sectional view of a display substrate according to at least one embodiment of the present disclosure. FIG. 9 illustrates schematically another partial cross-sectional view taken along the Q-Q' direction in FIG. 1. In some examples, as shown in FIG. 9, in a direction perpendicular to the display substrate, the display substrate may include a substrate 30, and a circuit structure layer, a first transparent conductive layer, a second transparent conductive layer, a light emitting structure layer, and an encapsulation structure layer which are disposed on the substrate 30. The first transparent conductive layer and the second transparent conductive layer may be made of a transparent conductive material, which may include ITO, for example.

In some examples, a second light emitting element 15b (including the anode 151b, an organic light emitting layer 152b, and a cathode 153b) of an island region A11 may be located on an eighth insulation layer 308. First light emitting elements emitting light of different colors in the transmissive region TA may be located on different insulation layers, and first light emitting elements emitting light of a same color may be located on a same insulation layer. For example, a first light emitting element 14a (including an anode 141a, an organic light emitting layer 142a, and a cathode 143a) emitting light of a first color in the transmissive region TA may be located on the eighth insulation layer 308, a first light emitting element 14b (including an anode 141b, an organic light emitting layer 142b, and a cathode 143b) emitting light of a second color may be located on a second insulation layer 302, and a first light emitting element 14c (including an anode 141c, an organic light emitting layer 142c, and a cathode 143c) emitting light of a third color may be located on a sixth insulation layer 306.

In some examples, a first connection line 31 or a second connection line 32 connected to the first light emitting element 14a emitting light of the first color in the transmissive region TA may be located in the second transparent conductive layer, a first connection line 31 or a second connection line 32 connected to the first light emitting element 14c emitting light of the third color in the transmissive region TA may be located in the third conductive layer, and a first connection line 31 or a second connection line 32 connected to the first light emitting element 14b emitting light of the second color in the transmissive region TA may be located in a same layer as a shielding layer 421. For example, the anode 151b of the second light emitting element 15b may be connected with a first anode connection electrode 35 through a third anode connection electrode 37, the first anode connection electrode 35 may be electrically connected with the first connection line 31 through a via penetrating the sixth insulation layer 306, a fifth insulation layer 305, a fourth insulation layer 304, a third insulation layer 303, and the second insulation layer 302, and the first anode connection electrode 35 may also be electrically connected with a first pixel circuit 11 through a via opened in the sixth insulation layer 306, so that the second light emitting element 15b and the first light emitting element 14b are connected to a same first pixel circuit 11.

In this example, a part of the insulation layers in the transmissive region is removed, which can reduce a thickness of the insulation layers in the transmissive region, and is beneficial for improving the light transmittance of the transmissive region. Moreover, the first light emitting elements that emit light of different colors are disposed on different insulation layers, so that a display effect of the transmissive region can be optimized. By providing insulation layers of different heights in the transmissive region, it can be advantageous to reduce diffraction. In addition, in this example, the first connection lines and the second connection lines connected to the first light emitting elements are disposed in suitable film layers according to insulation layers where the first light emitting elements are located, which not only facilitates arrangement of the connection lines, but also facilitates simplification of a manufacturing process, and saves costs. Remaining description of the display substrate in this example may be referred to the description in the aforementioned embodiments, which is not repeated here.

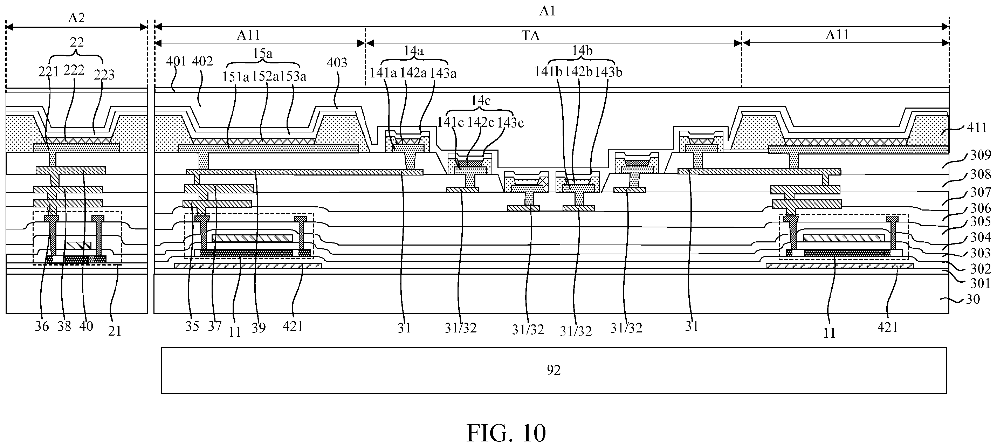

FIG. 10 illustrates schematically another partial cross-sectional view of a display substrate according to at least one embodiment of the present disclosure. FIG. 10 illustrates schematically another partial cross-sectional view taken along the Q-Q' direction in FIG. 1. In some examples, as shown in FIG. 10, in a direction perpendicular to the display substrate, the display substrate may include a substrate 30, and a circuit structure layer, a first transparent conductive layer, a second transparent conductive layer, a third transparent conductive layer, a light emitting structure layer, and an encapsulation structure layer which are disposed on the substrate 30. A seventh insulation layer 307 may be provided between the first transparent conductive layer and the second transparent conductive layer, an eighth insulation layer 308 may be provided between the second transparent conductive layer and the third transparent conductive layer, and a ninth insulation layer (also referred to as a fourth planarization layer) 309 may be provided on a side of the third transparent conductive layer away from the substrate 30. The first transparent conductive layer, the second transparent conductive layer and the third transparent conductive layer may be made of a transparent conductive material, which may include ITO, for example.

In some examples, the first transparent conductive layer may include a second anode connection electrode 36 located in a second display region A2, and a first anode connection electrode 35 located in an island region A11. The second transparent conductive layer may include a fourth anode connection electrode 38 located in the second display region A2, and a third anode connection electrode 37 located in the island region A11. The third transparent conductive layer may include a sixth anode connection electrode 40 located in the second display region A2, and a fifth anode connection electrode 39 located in the island region A11. The anode 221 of the second region light emitting element 22 may be connected with a second region pixel circuit 21 through the sixth anode connection electrode 40, the fourth anode connection electrode 38, and the second anode connection electrode 36, sequentially. An anode of a second light emitting element (e.g. an anode 151a of a second light emitting element 15a) may be connected with a first pixel circuit 11 through the fifth anode connection electrode 39, the third anode connection electrode 37, and the first anode connection electrode 35, sequentially.

In some examples, first light emitting elements emitting light of different colors in the transmissive region TA may be located on different insulation layers, and first light emitting elements emitting light of a same color may be located on a same insulation layer. In a transmissive region TA, a first light emitting element 14a may be located on the ninth insulation layer 309, a first light emitting element 14b may be located on the seventh insulation layer 307, and a first light emitting element 14c may be located on the eighth insulation layer 308.

In some examples, a first connection line 31 connected to the anode 141a of the first light emitting element 14a may be located in the third transparent conductive layer. The first connection line 31, and the fifth anode connection electrode 39 to which the second light emitting element 15a is connected are connected to each other to form an integral structure, so that the first light emitting element 14a and the second light emitting element 15a, which emit light of a same color, are connected to a same first pixel circuit 11. A first connection line 31 or a second connection line 32 connected to an anode 141b of a first light emitting element 14b may be located in the first transparent conductive layer, and a first connection line 31 or a second connection line 32 connected to an anode 141c of a first light emitting element 14c may be located in the second transparent conductive layer.

In this example, the first connection lines and the second connection lines connected to the first light emitting elements emitting light of different colors are disposed in different film layers, so that a plurality of first connection lines and second connection lines can be reasonably arranged. Moreover, in this example, the first connection lines and the second connection lines are made of a transparent conductive material, which is beneficial for ensuring a light transmittance of a transmissive region. Remaining description of the display substrate in this example may be referred to the description in the aforementioned embodiments, which is not repeated here.

Solutions of the above-mentioned embodiments may be combined with each other. In some other examples, first connection lines and second connection lines connected to a part of the first light emitting elements may be located in the transparent conductive layers, and first connection lines and second connection lines connected to another part of the first light emitting elements may be located in a same layer as one of sub-conductive layers of an anode layer. In some other examples, first connection lines and second connection lines connected to a part of the first light emitting elements may be located in a same layer as one of the sub-conductive layers of the anode layer, and first connection lines and second connection lines connected to another part of the first light emitting elements may be located in a same layer as a shielding layer.

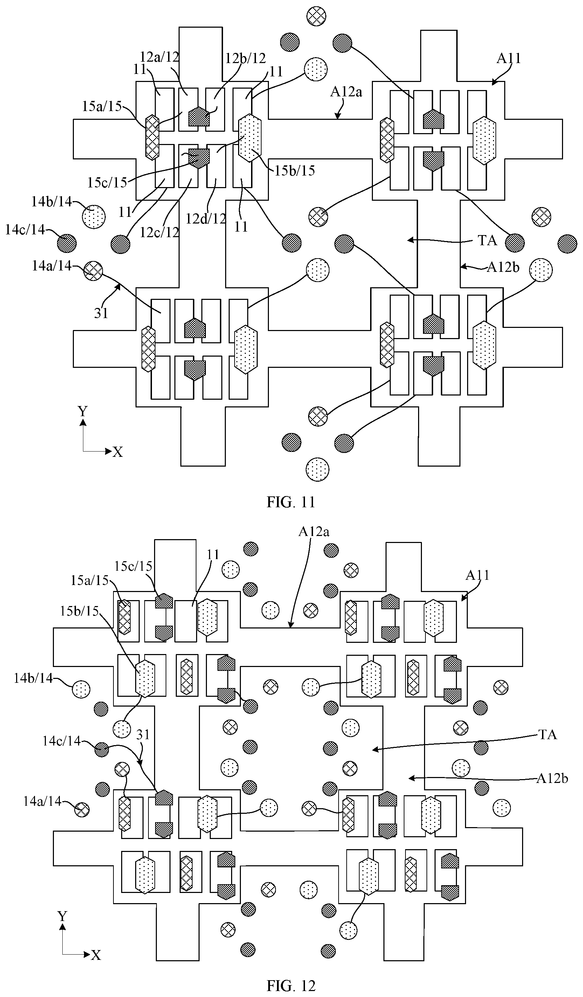

FIG. 11 is another partial schematic diagram of a first display region according to at least one embodiment of the present disclosure. Connection relationships between several first light emitting elements and first pixel circuits are just illustrated in FIG. 11. In some examples, as shown in FIG. 11, an island region A11 of a first display region A1 may include a plurality of second light emitting elements 15, a plurality of first pixel circuits 11, and a plurality of second pixel circuits 12. A transmissive region TA may include a plurality of first light emitting elements 14. A first inter-island connection region A12a and a second inter-island connection region A12b connecting adjacent island regions A11 may be provided with a plurality of signal lines, respectively. In this example, a plurality of first region light emitting elements may include a plurality of first light emitting elements 14 and a plurality of second light emitting elements 15, and a plurality of first region pixel circuits may include a plurality of first pixel circuits 11 and a plurality of second pixel circuits 12.

In some examples, at least one first pixel circuit 11 is connected with at least one first light emitting element 14, and at least one second pixel circuit 12 is connected with at least one second light emitting element 15. In this example, the first light emitting element 14 and the second light emitting element 15 may be driven by different pixel circuits, wherein the first pixel circuit 11 is configured to drive the first light emitting element 14, and the second pixel circuit 12 is configured to drive the second light emitting element 15. For example, the first pixel circuit 11 and the first light emitting element 14 may be connected in a one-to-one manner, and the second pixel circuit 12 and the second light emitting element 15 may be connected in a one-to-one manner. However, the embodiment is not limited thereto. In some other examples, the first pixel circuit 11 and the first light emitting element 14 may be connected in a one-to-multiple manner, or the second pixel circuit 12 and the second light emitting element 15 may be connected in a one-to-multiple manner.

In some examples, a single island region A11 may be provided with a pixel unit that may include four second light emitting elements 15 (including, for example, one second light emitting element 15a, one second light emitting element 15b, and two second light emitting elements 15c) and four second pixel circuits 12 (including, for example, second pixel circuits 12a, 12b, 12c, and 12d). The second pixel circuit 12a may be electrically connected with the second light emitting element 15a, the second pixel circuit 12b may be electrically connected with a second light emitting element 15c, the second pixel circuit 12c may be electrically connected with the other second light emitting element 15c, and the second pixel circuit 12d may be electrically connected with the second light emitting element 15b.

In some examples, a plurality of first pixel circuits 11 and second pixel circuits 12 in the island A11 may be arranged in a same manner. For example, a plurality of first pixel circuits 11 and a plurality of second pixel circuits 12 in the island region A11 may be arranged in rows. In some examples, the island region A11 may include four first pixel circuits 11 and four second pixel circuits 12, wherein the four second pixel circuits 12 may be arranged in an array of two rows and two columns, and the four first pixel circuits 11 may be arranged on two sides of the four second pixel circuits 12 along a first direction X. For example, one first pixel circuit 11, two second pixel circuits 12, and one first pixel circuit 11 may be sequentially arranged in one row of pixel circuits. However, the embodiment is not limited thereto. In some other examples, a plurality of (e.g., four) first pixel circuits may be arranged in one row, and a plurality of (e.g., four) second pixel circuits may be arranged in another row. In some other examples, a plurality of second pixel circuits 12 in the island region A11 may be concentratedly arranged in the middle, and a plurality of first pixel circuits 11 may be arranged on a periphery of the plurality of second pixel circuits 12. Alternatively, a plurality of first pixel circuits 11 and a plurality of second pixel circuits 12 in the island region A11 may be arranged at intervals. In some other examples, arrangements of pixel circuits in the plurality of island regions may be different, or partially the same.

In some examples, a single transmissive region TA may be provided with one pixel unit that may include four first light emitting elements 14. The four first light emitting elements 14 in the transmissive region TA may be connected to first pixel circuits 11 in adjacent different island regions A11.

In this example, the first region pixel circuits and the first region light emitting elements in the first display region may be electrically connected in a one-to-one correspondence, so that the display effect of the first display region can be guaranteed, and the light transmittance of the first display region can be ensured. Remaining description of the display substrate in this example may be referred to the description in the aforementioned embodiments, which is not repeated here.

FIG. 12 is another partial schematic diagram of a first display region according to at least one embodiment of the present disclosure. Connection relationships between several first light emitting elements and first pixel circuits are just illustrated in FIG. 12. In some examples, as shown in FIG. 12, an island region A11 of a first display region A1 may include a plurality of second light emitting elements 15, and a plurality of first pixel circuits 11. A transmissive region TA may include a plurality of first light emitting elements 14. A first inter-island connection region A12a and a second inter-island connection region A12b connecting adjacent island regions A11 may be provided with a plurality of signal lines, respectively. In this example, a plurality of first region light emitting elements may include a plurality of first light emitting elements 14 and a plurality of second light emitting elements 15, and a plurality of first region pixel circuits may include a plurality of first pixel circuits 11.

In some examples, the first pixel circuit 11 may be connected with a first light emitting element 14 and a second light emitting element 15 emitting light of a same color, and configured to drive the connected first and second light emitting elements 14 and 15 to emit light. For example, an anode of the first light emitting element 14 may be connected with an anode of a second light emitting element 15 emitting light of a same color in an adjacent island region A11 through a first connection line 31, and an anode of the second light emitting element 15 is connected with a first pixel circuit 11, so that the first light emitting element 14 and the second light emitting element 15 emitting light of the same color are electrically connected with the same first pixel circuit 11. In this example, the first pixel circuit 11 is configured to simultaneously drive the second light emitting element 15 of the island region A11 and the first light emitting element 14 of the transmissive region TA, which is beneficial for ensuring the display effect of the first display region.

In some examples, the transmissive region TA may include a central region and an edge region, wherein the edge region may surround the central region, and the edge region of the transmissive region TA may be adjacent to the island region A11 and the inter-island connection region. The first light emitting element 14 may be located in the edge region of the transmissive region TA, and the first light emitting element 14 may not be provided in the central region.

In this example, by providing the first light emitting element in a part of the transmissive region TA, a pixel density of the first display region can be increased, and a light transmittance of the transmissive region can be guaranteed. Remaining description of the display substrate in this example may be referred to the description in the aforementioned embodiments, which is not repeated here.

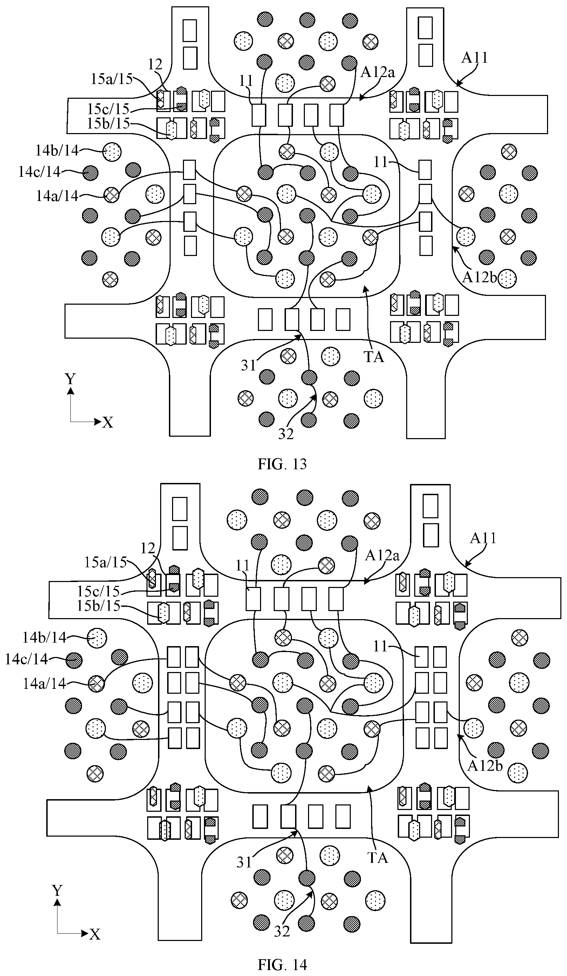

FIG. 13 is another partial schematic diagram of a first display region according to at least one embodiment of the present disclosure. Connection relationships between several first light emitting elements and first pixel circuits are just illustrated in FIG. 13. In some examples, as shown in FIG. 13, an island region A11 of a first display region A1 may include a plurality of second light emitting elements 15, and a plurality of second pixel circuits 12. A transmissive region TA may include a plurality of first light emitting elements 14. An inter-island connection region may include a plurality of first pixel circuits 11. A second pixel circuit 12 and a second light emitting element 15 in a single island region A11 may be electrically connected in a one-to-one correspondence. At least one first pixel circuit 11 of the inter-island connection region may be electrically connected with a plurality of first light emitting elements 14 in an adjacent transmissive region TA. For example, a first pixel circuit 11 in a first inter-island connection region A12a may drive a plurality of first light emitting elements 14 in two transmissive regions TA adjacent in a second direction Y; and a first pixel circuit 11 in a second inter-island connection region A12b may drive a plurality of first light emitting elements 14 in two transmissive regions TA adjacent in a first direction X. In this example, a plurality of first region light emitting elements may include a plurality of first light emitting elements 14 and a plurality of second light emitting elements 15, and a plurality of first region pixel circuits may include a plurality of first pixel circuits 11 and a plurality of second pixel circuits 12. In some other examples, the first pixel circuits 11 located in the inter-island connection region and the first light emitting elements 14 located in the transmissive region TA may be connected in a one-to-one manner.

In some examples, as shown in FIG. 13, a row of first pixel circuits 11 may be provided in a single first inter-island connection region A12a. The row of first pixel circuits 11 in the first inter-island connection region A12a may be connected with a plurality of first light emitting elements 14 in transmissive regions TA on upper and lower sides of the first inter-island connection region A12a. A column of first pixel circuits 11 may be provided in a single second inter-island connection region A12b. The column of first pixel circuits 11 in the second inter-island connection region A12b may be connected with a plurality of first light emitting elements 14 in transmissive regions TA on left and right sides of the second inter-island connection region A12b. A single first pixel circuit 11 may be connected with a plurality of first light emitting elements 14 emitting light of a same color. In this example, by disposing the first pixel circuit in the inter-island connection region, a non-transmissive region in the first display region can be fully utilized to increase the pixel density of the first display region. Moreover, arrangement in this example is beneficial for reducing a length of a first connection line 31 between the first pixel circuit 11 and the first light emitting element 14, so as to avoid affecting the display effect due to an increase in load caused by an excessively long connection line.

In some examples, the transmissive region TA may be approximately a rounded rectangle. An edge between the transmissive region TA and the island region A11 may be an arc-shaped edge. In this example, connection of adjacent edges of the transmissive region TA does not form a perpendicular edge, so that the light diffraction effect can be reduced, and the display effect of the first display region can be improved. Remaining description of the display substrate in this example may be referred to the description in the aforementioned embodiments, which is not repeated here.

FIG. 14 is another partial schematic diagram of a first display region according to at least one embodiment of the present disclosure. Connection relationships between several first light emitting elements and first pixel circuits are just illustrated in FIG. 14. In some examples, as shown in FIG. 14, a plurality of first region light emitting elements in this example may include a plurality of first light emitting elements 14 located in a transmissive region TA, and a plurality of second light emitting elements 15 located in an island region A11, and a plurality of first region pixel circuits may include a plurality of first pixel circuits 11 located in an inter-island connection region, and a plurality of second pixel circuits 12 located in the island region A11.

In some examples, as shown in FIG. 14, a quantity of rows and a quantity of columns of the first pixel circuits 11 disposed in the inter-island connection region may be different from a quantity of rows and a quantity of columns of the second pixel circuits 12 disposed in the island region A11. The quantity of rows of the second pixel circuits 12 in the island region A11 may be greater than the quantity of rows of the first pixel circuits 11 in the first inter-island connection region A12a, and the quantity of columns of the second pixel circuits 12 in the island region A11 may be greater than the quantity of columns of the first pixel circuits 11 in the second inter-island connection region A12b. A row of pixel circuits may include a plurality of pixel circuits arranged along a first direction X, and a column of pixel circuits may include a plurality of pixel circuits arranged along a second direction Y. However, the embodiment is not limited thereto. In some other examples, the quantity of rows of the second pixel circuits 12 in the island region A11 may be equal to the quantity of rows of the first pixel circuits 11 in the first inter-island connection region A12a, and the quantity of columns of the second pixel circuits 12 in the island region A11 may be equal to the quantity of columns of the first pixel circuits 11 in the second inter-island connection region A12b.

In some examples, as shown in FIG. 14, a row of first pixel circuits 11 may be provided in a single first inter-island connection region A12a. Two columns of first pixel circuits 11 may be provided in a single second inter-island connection region A12b. Numbered along the first direction X, a first column of first pixel circuits 11 may be connected to a plurality of first light emitting elements 14 in a transmissive region TA adjacent to a left side of the second inter-island connection region A12b through first connection lines 31 and second connection lines 32, and a second column of first pixel circuits 11 may be connected to a plurality of first light emitting elements 14 in a transmissive region TA adjacent to a right side of the second inter-island connection region A12b through first connection lines 31 and second connection lines 32. In this example, the first pixel circuits 11 and the first light emitting elements 14 may be connected in a one-to-multiple manner. However, the embodiment is not limited thereto. In some other examples, the first pixel circuits 11 and the second light emitting elements 14 may be connected in a one-to-one manner. In some other examples, a single second inter-island connection region may be provided with a column of first pixel circuits, and a single first inter-island connection region may be provided with a plurality of rows of first pixel circuits. In this example, the quantity of columns of, and the quantity of rows of the first pixel circuits in the inter-island connection regions are not limited, and a corresponding quantity of first pixel circuits may be reasonably arranged according to an arrangement space of the inter-island connection regions. Remaining description of the display substrate in this example may be referred to the description in the aforementioned embodiments, which is not repeated here.

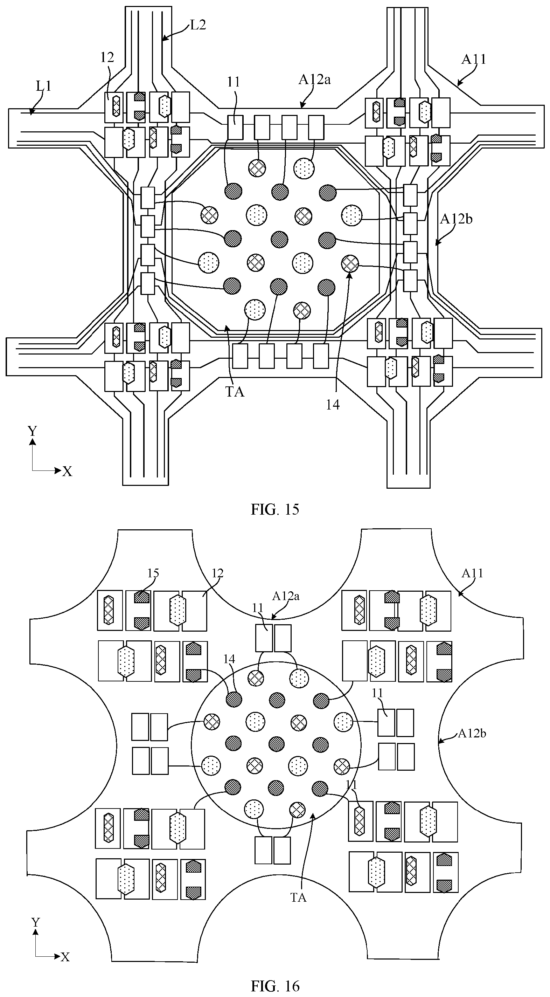

FIG. 15 is another partial schematic diagram of a first display region according to at least one embodiment of the present disclosure. FIG. 16 is another partial schematic diagram of a first display region according to at least one embodiment of the present disclosure. Connection relationships between several first light emitting elements and first pixel circuits are just illustrated in FIGs. 15 and 16.

In some examples, as shown in FIGs. 15 and 16, a plurality of first region light emitting elements in this example may include a plurality of first light emitting elements 14 located in a transmissive region TA, and a plurality of second light emitting elements 15 located in an island region A11, and a plurality of first region pixel circuits may include a plurality of first pixel circuits 11 located in an inter-island connection region, and a plurality of second pixel circuits 12 located in the island region A11.

In some examples, as shown in FIG. 15, a first inter-island connection region A12a may be provided with one row of first pixel circuits 11, and a second inter-island connection region A12b may be provided with one column of first pixel circuits 11. As shown in FIG. 16, a first inter-island connection region A12a may be provided with one row of first pixel circuits 11, and a second inter-island connection region A12b may be provided with two columns of first pixel circuits 11.

In some examples, as shown in FIG. 15, the transmissive region TA may be octagonal. The island region A11 may be substantially rhombic. As shown in FIG. 16, the transmissive region TA may be circular or elliptical, and an edge between the inter-island connection region and the transmissive region TA may be an arc-shaped edge. In this embodiment, a shape of the transmissive region is not limited. In some other examples, the transmissive region may be a polygon or irregular shape. In this example, connection of adjacent edges of the transmissive region TA does not form a perpendicular edge, so that the light diffraction effect can be reduced, and the display effect of the first display region can be improved.

In some examples, as shown in FIGs. 15 and 16, a single first pixel circuit 11 in the first inter-island connection region A12a and the second inter-island connection region A12b may be connected with a plurality of first light emitting elements 14 emitting light of a same color in an adjacent transmissive region TA. The first pixel circuits 11 and the first light emitting elements 14 may be in a one-to-multiple relationship. In some other examples, the first pixel circuits 11 and the first light emitting elements 14 may be connected in a one-to-one manner.

In some examples, as shown in FIG. 15, the first inter-island connection region A12a is further provided with a plurality of first signal lines L1, and the second inter-island connection region A12b is further provided with a plurality of second signal lines L2. The first signal lines L1 may extend substantially along a first direction X, and be connected with the second pixel circuits 12 of the island region A11 and also be connected with the first pixel circuits 11 in the first inter-island connection region A12a, and may be bent in a second direction Y, so as to be connected with the first pixel circuits 11 in the second inter-island connection region A12b. The second signal lines L2 may extend substantially along the second direction Y, and be connected with the second pixel circuits 12 in the island region A11 and also be connected with the first pixel circuits 11 in the second inter-island connection region A12b, and may be bent in the first direction X, so as to be connected with the first pixel circuits 11 in the first inter-island connection region A12a.

In some examples, the plurality of first signal lines L1 may include at least one of the following: an initial signal line, a scan line, and a light emitting control line. The plurality of second signal lines L2 may include at least one of the following: a data line, and a first power supply line.

Remaining description of the display substrate in this example may be referred to the description in the aforementioned embodiments, which is not repeated here.

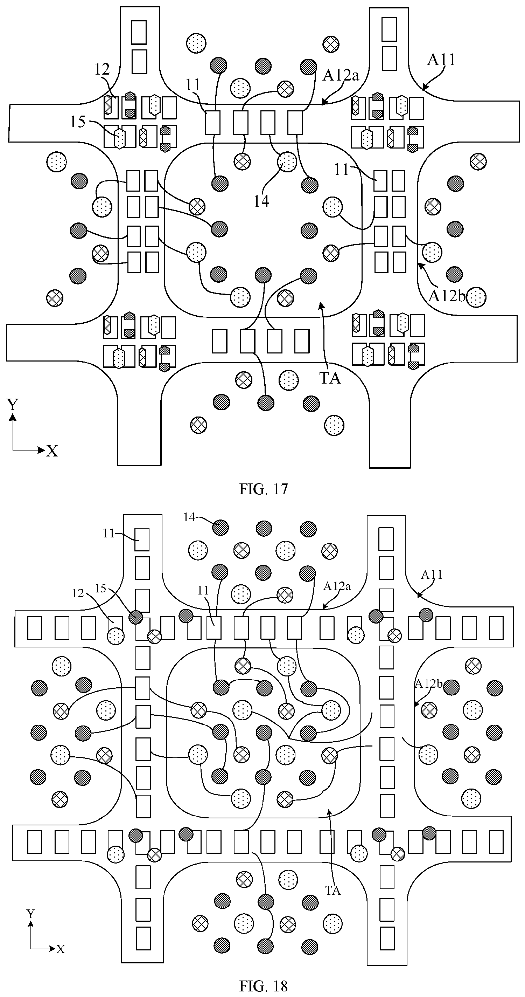

FIG. 17 is another partial schematic diagram of a first display region according to at least one embodiment of the present disclosure. Connection relationships between several first light emitting elements and first pixel circuits are just illustrated in FIG. 17. In some examples, as shown in FIG. 17, a plurality of first region light emitting elements in this example may include a plurality of first light emitting elements 14 located in a transmissive region TA, and a plurality of second light emitting elements 15 located in an island region A11, and a plurality of first region pixel circuits may include a plurality of first pixel circuits 11 located in an inter-island connection region, and a plurality of second pixel circuits 12 located in the island region A11. The first pixel circuits 11 and the first light emitting elements 14 may be connected in a one-to-one manner.

In some examples, as shown in FIG. 17, the transmissive region TA may include a central region and an edge region, wherein the edge region may surround the central region, and the edge region of the transmissive region TA may be adjacent to the island region A11 and the inter-island connection region. The first light emitting element 14 may be located in the edge region of the transmissive region TA, and the first light emitting element 14 may not be provided in the central region. Remaining description of the display substrate in this example may be referred to the description in the aforementioned embodiments, which is not repeated here.

FIG. 18 is another partial schematic diagram of a first display region according to at least one embodiment of the present disclosure. Connection relationships between several first light emitting elements and first pixel circuits are just illustrated in FIG. 18. In some examples, as shown in FIG. 18, a plurality of first region light emitting elements in this example may include a plurality of first light emitting elements 14 located in a transmissive region TA, and a plurality of second light emitting elements 15 located in an island region A11, and a plurality of first region pixel circuits may include a plurality of first pixel circuits 11 located in an inter-island connection region, and a plurality of second pixel circuits 12 located in the island region A11.

In some examples, as shown in FIG. 18, the inter-island connection regions and the island regions A11 may communicate to form a mesh region. A plurality of first region pixel circuits are arranged in the mesh region formed by the inter-island connection regions and the island regions A11. Arrangement of the second pixel circuits 12 in the island region A11 may be the same as arrangement of the first pixel circuits 11 in the inter-island connection regions. For example, a first inter-island connection region A12a is provided with a row of first pixel circuits 11 that is aligned with a row of second pixel circuits 12 in an island region A11, and a second inter-island connection region A12b is provided with a column of first pixel circuits 11 that is aligned with a column of second pixel circuits 12 in an island region A11. The first pixel circuits 11 and the second pixel circuits 12 may be arranged in a mesh shape as a whole.

In some examples, as shown in FIG. 18, the second pixel circuits 12 and the second light emitting elements 15 in the island region A11 may be connected in a one-to-one manner or a one-to-multiple manner, and the first pixel circuits 11 in the inter-island connection regions may be connected with the first light emitting elements 14 in the transmissive regions TA in a one-to-multiple manner. However, the embodiment is not limited thereto. In some other examples, the first pixel circuits 11 of the inter-island connection regions and the first light emitting elements 14 of the transmissive regions TA may be connected in a one-to-one connection manner. Remaining description of the display substrate in this example may be referred to the description in the aforementioned embodiments, which is not repeated here.

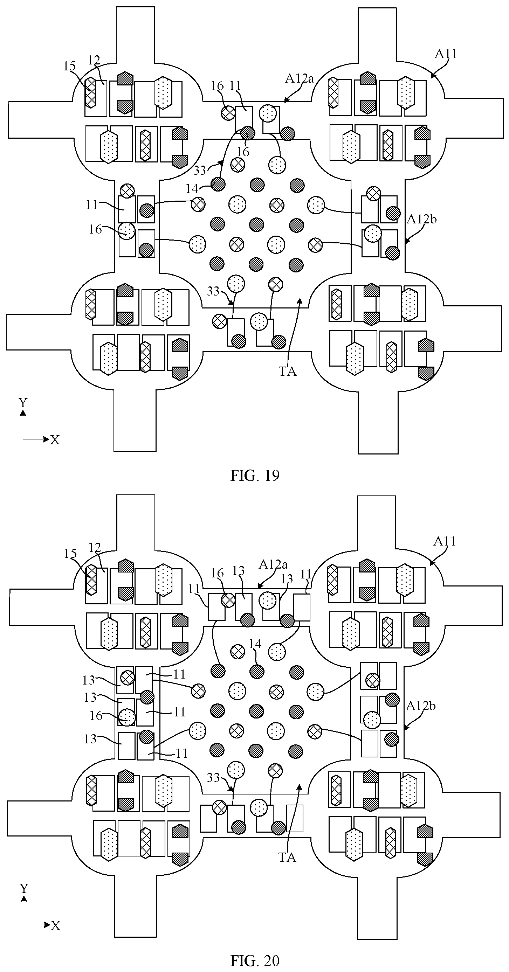

FIG. 19 is another partial schematic diagram of a first display region according to at least one embodiment of the present disclosure. Connection relationships between several first light emitting elements and first pixel circuits are just illustrated in FIG. 19. In some examples, as shown in FIG. 19, a plurality of first region light emitting elements in this example may include a plurality of first light emitting elements 14 located in a transmissive region TA, a plurality of second light emitting elements 15 located in an island region A11, and a plurality of third light emitting elements 16 located in an inter-island connection region. A plurality of first region pixel circuits may include a plurality of first pixel circuits 11 located in an inter-island connection region, and a plurality of second pixel circuits 12 located in the island region A11. In this example, the pixel density of the first display region can be increased by providing the third light emitting elements 16 in the inter-island connection regions and the first light emitting elements 14 in the transmissive regions TA.

In some examples, a plurality of second pixel circuits 12 may be connected with a plurality of second light emitting elements 15. For example, the second pixel circuits 12 and the second light emitting elements 15 may be connected in a one-to-one manner or in a one-to-multiple manner. A plurality of first pixel circuits 11 may be connected with a plurality of first light emitting elements 14 and a plurality of third light emitting elements 16. At least one first pixel circuit 11 may be connected with at least one first light emitting element 14 and at least one third light emitting element 16 emitting light of a same color. For example, one first pixel circuit 11 may be connected to one first light emitting element 14 and one third light emitting element 16 emitting light of the same color. Alternatively, one first pixel circuit 11 may be connected with a plurality of first light emitting elements 14 and one third light emitting element 16 emitting light of the same color. Alternatively, one first pixel circuit 11 may be connected with a plurality of first light emitting elements 14 and a plurality of third light emitting elements 16 emitting light of the same color. Alternatively, one first pixel circuit 11 may be connected with one first light emitting element 14 and a plurality of third light emitting elements 16 emitting light of the same color. In this example, the first pixel circuit 11 may also act as a third pixel circuit to drive the first light emitting element 14 and the third light emitting element 16.

In some examples, orthographic projections of the third light emitting element 16 and the connected first pixel circuit 11 on the substrate may be at least partially overlapped. The first light emitting element 14 may be connected with the first pixel circuit 11 through a third connection line 33. For example, the first light emitting element 14 may be connected with an anode of a third light emitting element 16 emitting light of a same color through the third connection line 33. The third light emitting element 16 is connected with the first pixel circuit 11, so that the first light emitting element 14 and the third light emitting element 16 emitting light of the same color are connected with a same first pixel circuit 11.

In some examples, a light emitting area of the third light emitting element 16 may be less than a light emitting area of the first light emitting element 14 emitting light of the same color. In some examples, a light emitting area of the third light emitting element 16 may be greater than or equal to a light emitting area of the first light emitting element 14 that emits light of a same color.

In some examples, arrangement of the third light emitting elements 16 in the inter-island connection region may be substantially the same as arrangement of the first light emitting elements 14 in the transmissive region TA. In some other examples, arrangement of the third light emitting elements 16 in the inter-island connection region may be different from arrangement of the first light emitting elements 14 in the transmissive region TA. For example, the arrangement of the third light emitting elements 16 in the inter-island connection region may be the same as arrangement of the second light emitting elements 15 in the island region A11.

In some examples, in a first direction X, a minimum distance between second light emitting elements 15 emitting light of a same color in the island region A11 may be smaller than a minimum distance between first light emitting elements 14 emitting light of a same color in the transmissive region TA. In a second direction Y, a minimum distance between the second light emitting elements 15 emitting light of a same color in the island region A11 may be smaller than a minimum distance between the first light emitting elements 14 emitting light of a same color in the transmissive region TA. For example, a minimum distance, in the first direction X, of adjacent second light emitting elements 15 emitting light of a first color in the island region A11 may be smaller than a minimum distance, in the first direction X, of the adjacent first light emitting elements 14 emitting light of the first color in the transmissive region TA, and a minimum distance, in the second direction Y, of adjacent second light emitting elements 15 emitting light of the first color in the island region A11 may be smaller than a minimum distance, in the second direction Y, of adjacent first light emitting elements 14 emitting light of the first color in the transmissive region TA. In this example, increasing the minimum distance between the first light emitting elements emitting light of the same color in the transmissive region may be beneficial for improving the light transmittance of the transmissive region.

In some examples, in the first direction X, a minimum distance between third light emitting elements 16 emitting light of a same color (e.g., light of the first color) in the first inter-island connection region A12a may be less than or equal to the minimum distance between the first light emitting elements 14 emitting light of the same color (e.g., the light of the first color) in the transmissive region TA. In the second direction Y, a minimum distance between third light emitting elements 16 emitting light of a same color (e.g., light of the first color) in the second inter-island connection region A12b may be less than or equal to a minimum distance between the first light emitting elements 14 emitting light pf the same color (e.g., the light of the first color) in the transmissive region TA.

In some examples, in the first direction X, a minimum distance between third light emitting elements 16 emitting light of a same color (e.g., light of the first color) in the first inter-island connection region A12a may be greater than or equal to a minimum distance between the second light emitting elements 15 emitting light of the same color (e.g., the light of the first color) in the island region A11. In the second direction Y, a minimum distance between third light emitting elements 16 emitting light of a same color (e.g., light of the first color) in the second inter-island connection region A12b may be greater than or equal to the minimum distance between the second light emitting elements 15 emitting light of the same color (e.g., the light of the first color) in the island region A11. The embodiment is not limited thereto.

The arrangement in this example is beneficial for increasing the pixel density of the first display region by making full use of a non-transmissive region of the first display region. Remaining description of the display substrate in this example may be referred to the description in the aforementioned embodiments, which is not repeated here.

FIG. 20 is another partial schematic diagram of a first display region according to at least one embodiment of the present disclosure. Connection relationships between several first light emitting elements and first pixel circuits are just illustrated in FIG. 20. In some examples, as shown in FIG. 20, a plurality of first region light emitting elements in this example may include a plurality of first light emitting elements 14 located in a transmissive region TA, a plurality of second light emitting elements 15 located in an island region A11, and a plurality of third light emitting elements 16 located in an inter-island connection region. A plurality of first region pixel circuits may include a plurality of first pixel circuits 11 and a plurality of third pixel circuits 13 located in an inter-island connection region, and a plurality of second pixel circuits 12 located in the island region A11.

In some examples, as shown in FIG. 20, a plurality of second pixel circuits 12 in the island region A11 may be connected with a plurality of second light emitting elements 15. For example, the second pixel circuits 12 and the second light emitting elements 15 may be connected in a one-to-one manner or in a one-to-multiple manner. A plurality of first pixel circuits 11 of the inter-island connection region may be connected with a plurality of first light emitting elements 14 of the transmissive region TA. For example, the first pixel circuits 11 and the first light emitting elements 14 may be connected in a one-to-one manner or in a one-to-multiple manner. A plurality of third pixel circuits 13 of the inter-island connection region may be connected with a plurality of third light emitting elements 16 of the inter-island connection region. For example, the third pixel circuit 13 and the third light emitting element 16 may be connected in a one-to-one manner or in a one-to-multiple manner.

In some examples, a plurality of first pixel circuits 11 of a first inter-island connection region A12a may be located on two sides of a plurality of third pixel circuits 13 in a first direction X. For example, the plurality of first pixel circuits 11 and the plurality of third pixel circuits 13 may be arranged in a row, and the first pixel circuits 11 may be located on two sides of the plurality of third pixel circuits 13 in the first direction X. In some other examples, the plurality of first pixel circuits 11 and the plurality of third pixel circuits 13 may be arranged at intervals. The embodiment is not limited thereto.

In some examples, a plurality of first pixel circuits 11 and a plurality of third pixel circuits 13 in the second inter-island connection region A12b may be arranged at intervals in the first direction X. For example, the second inter-island connection region A12b may be provided with two columns of pixel circuits, wherein the plurality of first pixel circuits 11 may be arranged in one column, and the plurality of third pixel circuits 13 may be arranged in one column. In some other examples, the plurality of first pixel circuits 11 may be located on both sides of the plurality of third pixel circuits 13 in a second direction Y. In some other examples, the plurality of first pixel circuits 11 and the plurality of third pixel circuits 13 may be arranged at intervals along the second direction Y. The embodiment is not limited thereto.

In some examples, orthographic projections of a third light emitting element 16 and its connected first pixel circuit 13 on the substrate may be at least partially overlapped. Alternatively, an orthographic projection of at least one third light emitting element 16 on the substrate may be not overlapped with an orthographic projection of its connected third pixel circuit 13 on the substrate.

The arrangement in this example is beneficial for increasing the pixel density of the first display region by making full use of a non-transmissive region of the first display region. Moreover, the first light emitting element and the third light emitting element are driven by different pixel circuits, which is beneficial for ensuring a display effect. Remaining description of the display substrate in this example may be referred to the description in the aforementioned embodiments, which is not repeated here.

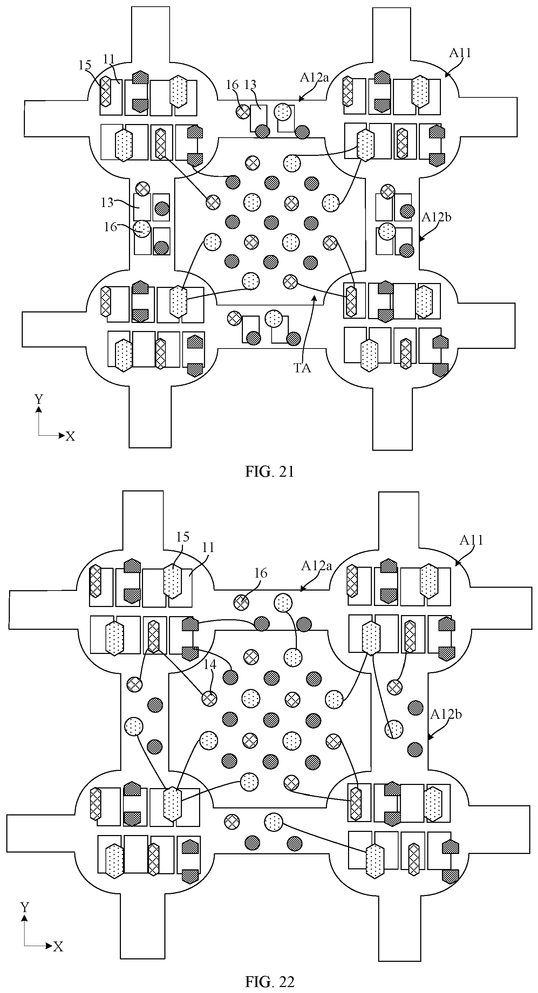

FIG. 21 is another partial schematic diagram of a first display region according to at least one embodiment of the present disclosure. Connection relationships between several first light emitting elements and first pixel circuits are just illustrated in FIG. 21. In some examples, as shown in FIG. 21, a plurality of first region light emitting elements in this example may include a plurality of first light emitting elements 14 located in a transmissive region TA, a plurality of second light emitting elements 15 located in an island region A11, and a plurality of third light emitting elements 16 located in an inter-island connection region. A plurality of first region pixel circuits may include a plurality of third pixel circuits 13 located in an inter-island connection region, and a plurality of first pixel circuits 11 located in the island region A11.

In some examples, as shown in FIG. 21, a plurality of third light emitting elements 16 located in the inter-island connection region may be connected to a plurality of third pixel circuits 13. For example, the third pixel circuits 13 and the third light emitting elements 16 may be connected in a one-to-one manner or in a one-to-multiple manner. A plurality of first pixel circuits 11 located in the island region A11 may be connected with a plurality of first light emitting elements 14 located in a transmissive region TA and a plurality of second light emitting elements 15 located in the island region A11. At least one first pixel circuit 11 may be connected with at least one first light emitting element 14 and at least one second light emitting element 15 emitting light of a same color. For example, one first pixel circuit 11 may be connected to one first light emitting element 14 and one second light emitting element 15 emitting light of the same color. Alternatively, one first pixel circuit 11 may be connected with a plurality of first light emitting elements 14 and one second light emitting element 15 emitting light of the same color. Alternatively, one first pixel circuit 11 may be connected with a plurality of first light emitting elements 14 and a plurality of second light emitting elements 15 emitting light of the same color. Alternatively, one first pixel circuit 11 may be connected with one first light emitting element 14 and a plurality of second light emitting elements 15 emitting light of the same color. In this example, the first pixel circuit 11 is configured to drive the first light emitting element 11 and the second light emitting element 12 simultaneously, and the third pixel circuit 13 is configured to drive the third light emitting element 16, so that a second pixel circuit that separately drives the second light emitting element 12 can be omitted, which is beneficial for reducing a space occupied by the pixel circuits.

In some other examples, the island region A11 may further include at least one second pixel circuit that may be connected with a plurality of second light emitting elements located in the island region A11, and a plurality of first pixel circuits located in the island region A11 may be connected with a plurality of first light emitting elements located in the transmissive region TA. For example, the second pixel circuits and the second light emitting elements may be connected in a one-to-one manner or in a one-to-multiple manner, and the first pixel circuits and the first light emitting elements may be connected in a one-to-one manner or in a one-to-multiple manner. Remaining description of the display substrate in this example may be referred to the description in the aforementioned embodiments, which is not repeated here.

FIG. 22 is another partial schematic diagram of a first display region according to at least one embodiment of the present disclosure. Connection relationships between several first light emitting elements and first pixel circuits, and connection relationships between several first light emitting elements and third light emitting elements are just illustrated in FIG. 22. In some examples, as shown in FIG. 22, a plurality of first region light emitting elements in this example may include a plurality of first light emitting elements 14 located in a transmissive region TA, a plurality of second light emitting elements 15 located in an island region A11, and a plurality of third light emitting elements 16 located in an inter-island connection region. A plurality of first region pixel circuits may include a plurality of first pixel circuits 11 located in the island region A11.

In some examples, as shown in FIG. 22, a plurality of first pixel circuits 11 located in the island region A11 may be connected with a plurality of first light emitting elements 14 located in the transmissive region TA, a plurality of second light emitting elements 15 located in the island region A11, and a plurality of third light emitting elements 16 located in the inter-island connection region. At least one first pixel circuit 11 may be connected with at least one first light emitting element 14, at least one second light emitting element 15, and at least one third light emitting element 16 which emit light of a same color. For example, one first pixel circuit 11 may be connected with one first light emitting element 14, one second light emitting element 15, and one third light emitting element 16, which emit light of the same color. Alternatively, one first pixel circuit 11 may be connected with a plurality of first light emitting elements 14, a plurality of second light emitting elements 15, and a plurality of third light emitting elements 16, which emit light of a same color. Alternatively, one first pixel circuit 11 may be connected with a plurality of first light emitting elements 14, one second light emitting element 15, and a plurality of third light emitting elements 16, which emit light of a same color. In this example, the first pixel circuit 11 may drive the first light emitting element 14, the second light emitting element 15, and the third light emitting element 16 simultaneously, so that a second pixel circuit that separately drives the second light emitting element 12 and a third pixel circuit that separately drives the third light emitting element 16 can be omitted, which is beneficial for reducing a space occupied by the pixel circuits. However, the embodiment is not limited thereto.

In some other examples, the island region A11 may further include at least one second pixel circuit, the at least one second pixel circuit located in the island region A11 may be connected with a plurality of second light emitting elements located in the island region A11. A plurality of first pixel circuits located in the island region A11 may be connected with a plurality of first light emitting elements located in the transmissive region TA and a plurality of third light emitting elements located in the inter-island connection region. For example, the second pixel circuits and the second light emitting elements may be connected in a one-to-one manner or in a one-to-multiple manner, the first pixel circuits and the first light emitting elements may be connected in a one-to-one manner or one-to-multiple manner, the first pixel circuits and the first light emitting elements may be connected in a one-to-one or one-to-multiple manner, and the first pixel circuits and the third light emitting elements may be connected in a one-to-one manner or in a one-to-multiple manner.

In some other examples, the island region A11 may further include at least one third pixel circuit. The at least one third pixel circuit located in the island region A11 may be connected with a plurality of third light emitting elements located in the inter-island connection region, and a plurality of first pixel circuits located in the island region A11 may be connected with a plurality of first light emitting elements located in the transmissive region TA and a plurality of second light emitting elements located in the island region A11.

In some other examples, the island region A11 may further include at least one second pixel circuit and at least one third pixel circuit, wherein the at least one second pixel circuit located in the island region A11 may be connected with a plurality of second light emitting elements located in the island region A11, the at least one third pixel circuit located in the island region A11 may be connected with at least one third light emitting element located in the inter-island connection region, and at least one first pixel circuit located in the island region A11 may be connected with at least one first light emitting element located in the transmissive region TA. Remaining description of the display substrate in this example may be referred to the description in the aforementioned embodiments, which is not repeated here.

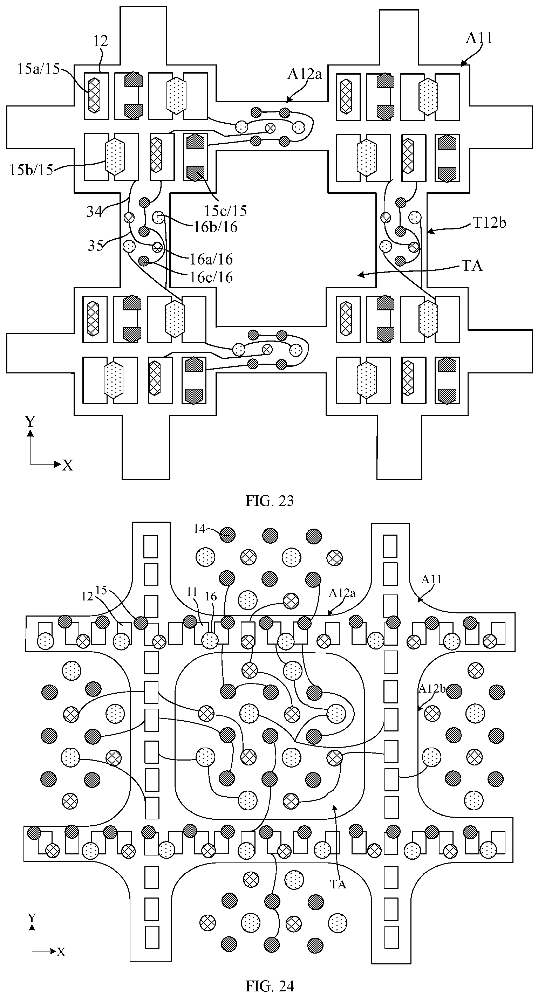

FIG. 23 is another partial schematic diagram of a first display region according to at least one embodiment of the present disclosure. Connection relationships between several third light emitting elements and second pixel circuits are just illustrated in FIG. 23. In some examples, as shown in FIG. 23, a plurality of first region light emitting elements in this example may include a plurality of second light emitting elements 15 located in an island region A11 and a plurality of third light emitting elements 16 located in an inter-island connection region (including, for example, a third light emitting element 16a emitting light of a first color, a third light emitting element 16b emitting light of a second color, and a third light emitting element 16c emitting light of a third color), wherein the plurality of first region pixel circuits may include a plurality of second pixel circuits 12 located in the inter-island connection region.

In some examples, as shown in FIG. 23, a plurality of second pixel circuits 12 of the island region A11 may be connected with a plurality of second light emitting elements 15, and a plurality of third light emitting elements 16 located in the inter-island connection region. At least one second pixel circuit 12 may be connected with at least one second light emitting element 15 located in the island region A11 and at least one third light emitting element 16 located in the inter-island connection region, which emit light of a same color. For example, one second pixel circuit 12 may be connected with one second light emitting element 15 and one third light emitting element 16, which emit light of a same color. Alternatively, one second pixel circuit 12 may be connected with one second light emitting element 15 and a plurality of third light emitting elements 16, which emit light of a same color. Alternatively, one second pixel circuit 12 may be connected with a plurality of second light emitting elements 15 and one third light emitting element 16, which emit light of a same color. In this example, the second pixel circuit 12 may drive the second light emitting element and the third light emitting element simultaneously, so that a third pixel circuit that separately drives the third light emitting element 16 can be omitted, which is beneficial for reducing a space occupied by the pixel circuits. The embodiment is not limited thereto. In some other examples, the island region A11 may further include at least one third pixel circuit that may be connected with a plurality of third light emitting elements located in the inter-island connection region, and a plurality of second pixel circuits located in the island region A11 may be connected with a plurality of second light emitting elements located in the island region A11.

In some examples, as shown in FIG. 23, no light emitting element is provided in the transmissive region TA. In this example, by providing the third light emitting elements in the inter-island connection region, a pixel density of the first display region can be increased with a non-transmissive region of the first display region, which can be beneficial for improving the display effect of the first display region. Moreover, no light emitting element is provided in the transmissive region, so that a light transmittance of the transmissive region can be guaranteed. Remaining description of the display substrate in this example may be referred to the description in the aforementioned embodiments, which is not repeated here.

FIG. 24 is another partial schematic diagram of a first display region according to at least one embodiment of the present disclosure. Connection relationships between several first light emitting elements and first pixel circuits are just illustrated in FIG. 24. In some examples, as shown in FIG. 24, a plurality of first region light emitting elements in this example may include a plurality of first light emitting elements 14 located in a transmissive region TA, a plurality of second light emitting elements 15 located in an island region A11, and a plurality of third light emitting elements 16 located in an inter-island connection region. A plurality of first region pixel circuits may include a plurality of first pixel circuits 11 located in an inter-island connection region, and a plurality of second pixel circuits 12 located in the island region A11.

In some examples, as shown in FIG. 24, the inter-island connection regions and the island regions A11 may communicate to form a mesh region. A plurality of first region pixel circuits are arranged in the mesh region formed by the inter-island connection regions and the island regions A11. The first pixel circuits 11 and the second pixel circuits 12 may be arranged in a mesh shape as a whole. Arrangement of the first region pixel circuits in this example may be described with reference to the description in the embodiment shown in FIG. 18, which is not be repeated here.

In some examples, as shown in FIG. 24, a plurality of third light emitting elements 16 may be provided in a first inter-island connection region A12a, and a second inter-island connection region A12b may not be provided with a third light emitting element 16, and only the first pixel circuits 11 may be provided in the second inter-island connection region A12b. In some other examples, each of the first inter-island connection region A12a and the second inter-island connection region A12b may be provided with at least one first pixel circuit 11 and at least one third light emitting element 16. In some other examples, the first inter-island connection region A12a may be provided with at least one first pixel circuit 11, and the second inter-island connection region A12b may be provided with at least one first pixel circuit 11 and at least one third light emitting element 16.

In some examples, as shown in FIG. 24, a light emitting area of the second light emitting element 15 may be greater than or equal to a light emitting area of the third light emitting element 16 emitting light of a same color, and greater than or equal to a light emitting area of the first light emitting element 14 emitting light of a same color. A light emitting area of the first light emitting element 14 may be greater than or equal to a light emitting area of the third light emitting element 16 emitting light of a same color.

In some examples, a plurality of first pixel circuits 11 located in the inter-island connection region may be connected with a plurality of first light emitting elements 14 located in the transmissive region TA and a plurality of third light emitting elements 16 located in the inter-island connection region. For example, one first pixel circuit 11 may be connected with at least one first light emitting element 14 and at least one third light emitting element 16 emitting light of a same color. However, the embodiment is not limited thereto. In some other examples, at least one third pixel circuit may also be provided in the island region or the inter-island connection region, the at least one third pixel circuit may be connected with at least one third light emitting element, and the third pixel circuits and the third light emitting elements may be connected in a one-to-one manner or in a one-to-multiple manner. Remaining description of the display substrate in this example may be referred to the description in the aforementioned embodiments, which is not repeated here.

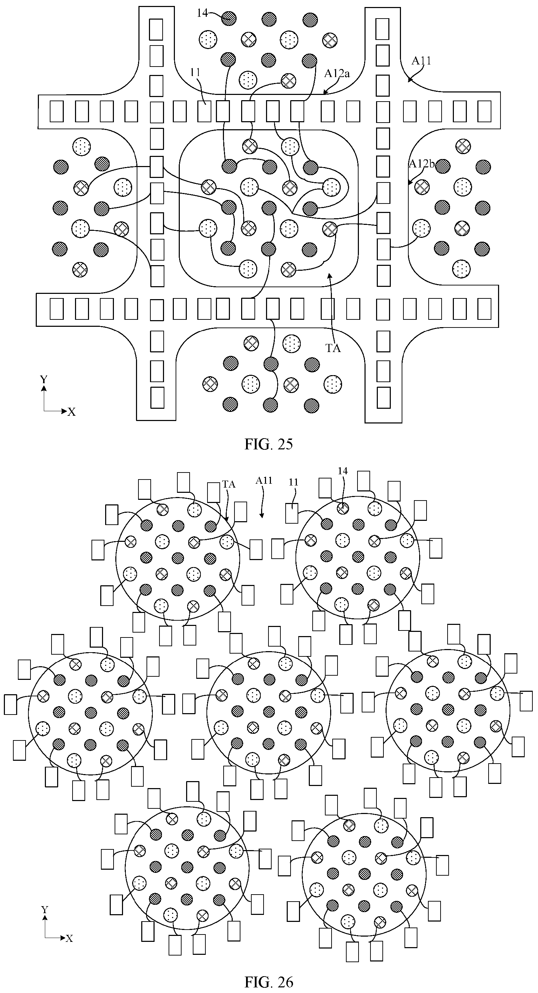

FIG. 25 is another partial schematic diagram of a first display region according to at least one embodiment of the present disclosure. Connection relationships between several first light emitting elements and first pixel circuits are just illustrated in FIG. 25. In some examples, as shown in FIG. 25, a plurality of first region light emitting elements in this example may include a plurality of first light emitting elements 14 located in a transmissive region TA, and the plurality of first region pixel circuits may include a plurality of first pixel circuits 11 located in an island region A11 and an inter-island connection region. A plurality of first pixel circuits 11 are connected with a plurality of first light emitting elements 14. The first pixel circuits 11 and the first light emitting elements 14 may be connected in a one-to-one manner or in a one-to-multiple manner. An orthographic projection of a first pixel circuit 11 on the substrate may be not overlapped with an orthographic projection of its connected first light emitting element 14 on the substrate. In this example, the first pixel circuits and the first light emitting elements are disposed separately to ensure the light transmittance of the first display region. Remaining description of the display substrate in this example may be referred to the description in the aforementioned embodiments, which is not repeated here.

FIG. 26 is another partial schematic diagram of a first display region according to at least one embodiment of the present disclosure. Connection relationships between several first light emitting elements and first pixel circuits are just illustrated in FIG. 26. In some examples, as shown in FIG. 26, the first display region may include a plurality of transmissive regions TA provided separately, and island regions A11 located between adjacent transmissive regions. A plurality of island regions A11 in this example may be connected to each other, and surround the transmissive region TA.

In some examples, the plurality of transmissive regions TA may be circular or elliptical. However, the embodiment is not limited thereto. In some other examples, the transmissive region TA may be in another shape, such as a rounded rectangle, an octagon, or the like.

In some examples, a plurality of first region light emitting elements may include a plurality of first light emitting elements 14 located in a transmissive region TA, and a plurality of first region pixel circuits may include a plurality of first pixel circuits 11 located in an island region A11. A plurality of first pixel circuits 11 are connected with a plurality of first light emitting elements 14. For example, the first pixel circuits 11 and the first light emitting elements 14 may be connected in a one-to-one manner or in a one-to-multiple manner. An orthographic projection of the first pixel circuit 11 on the substrate may not be overlapped with an orthographic projection of its connected first light emitting element 14 on the substrate.

In some other examples, a plurality of first region light emitting elements may include a plurality of first light emitting elements 14 located in the transmissive region TA and a plurality of second light emitting elements located in the island region A11, and a plurality of first region pixel circuits may include a plurality of first pixel circuits 11 located in the island region A11. A plurality of first pixel circuits 11 located in the island region A11 are connected with a plurality of first light emitting elements 14 located in a transmissive region TA and a plurality of second light emitting elements located in the island region A11. For example, at least one first pixel circuit 11 are connected with at least one first light emitting element and at least one second light emitting element emitting light of a same color.

In some other examples, a plurality of first region light emitting elements may include a plurality of first light emitting elements 14 located in the transmissive region TA and a plurality of second light emitting elements located in the island region A11, and a plurality of first region pixel circuits may include a plurality of first pixel circuits 11 and a plurality of second pixel circuits located in the island region A11. A plurality of first pixel circuits are connected with a plurality of first light emitting elements. For example, the first pixel circuits and the first light emitting elements may be connected in a one-to-one manner or in a one-to-multiple manner. A plurality of second pixel circuits are connected with a plurality of second light emitting elements. For example, the second pixel circuits and the second light emitting elements may be connected in a one-to-one manner or in a one-to-multiple manner. The embodiment is not limited thereto.

Remaining description of the display substrate in this example may be referred to the description in the aforementioned embodiments, which is not repeated here.

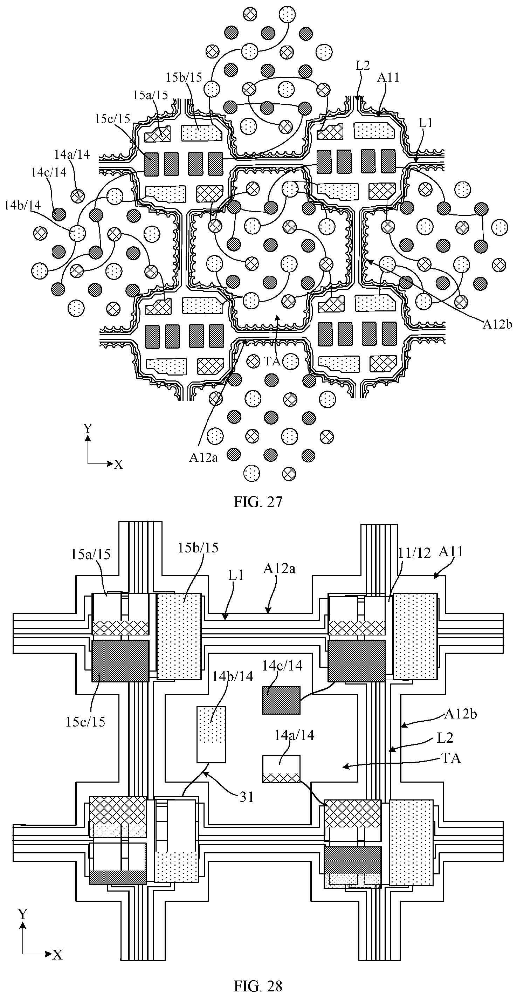

FIG. 27 is another partial schematic diagram of a first display region according to at least one embodiment of the present disclosure. Connection relationships between several first light emitting elements and first pixel circuits are just illustrated in FIG. 27. In some examples, as shown in FIG. 27, an island region A11 may be substantially rectangular, and an edge of the island region A11 may be a non-planarized edge or an arc-shaped edge. For example, a profile of the edge may be wavy, jagged or arc-shaped. Edges of the first inter-island connection region A12a and the second inter-island connection region A12b may be non-planarized edges. For example, a profile of the edge may be wavy or jagged. Arrangements of the edges of the island regions and the inter-island connection regions in this example can reduce a light diffraction effect, and improve the display effect of the first display region. Remaining description of the display substrate in this example may be referred to the description in the aforementioned embodiments, which is not repeated here.

FIG. 28 is another partial schematic diagram of a first display region according to at least one embodiment of the present disclosure. In some examples, as shown in FIG. 28, a plurality of first region light emitting elements in this example may include a plurality of first light emitting elements 14 located in the transmissive region TA and a plurality of second light emitting elements located in the island region A11, and a plurality of first region pixel circuits may include a plurality of second pixel circuits 12 located in the island region A11. In this example, the second pixel circuit 12 may also act as a first pixel circuit 11, to drive the first light emitting element 14 and the second light emitting element 15.

In some examples, as shown in FIG. 28, the island region A11 may include a pixel unit that may include three second light emitting elements 15, including, for example, a second light emitting element 15a emitting light of a first color, a second light emitting element 15b emitting light of a second color, and a second light emitting element 15c emitting light of a third color. The second light emitting elements 15a emitting light of the first color and the second light emitting elements 15c emitting light of the third color may be arranged along a second direction Y, and the second light emitting elements 15b emitting light of the second color may be located on a same side of the second light emitting elements 15a and 15c in a first direction X.

In some examples, at least one transmissive region TA may be provided with a plurality of first light emitting elements 14, including, for example, a first light emitting element 14a emitting light of a first color, a first light emitting element 14b emitting light of a second color, and a first light emitting element 14c emitting light of a third color. The first light emitting elements 14a emitting light of the first color and the first light emitting elements 14c emitting light of the third color may be arranged along the second direction Y, and the first light emitting elements 14b emitting light of the second color may be located on a same side of the first light emitting elements 14a and 14c in the first direction X.

In some examples, the second pixel circuit 12 may be connected with one second light emitting element 15 in the island region A11 and one first light emitting element 14 emitting light of a same color in an adjacent transmissive region TA, and the second pixel circuit 12 may be configured to drive the second light emitting element 15 and the first light emitting element 14 emitting light of the same color.

In some examples, a light emitting area of the first light emitting element 14 may be less than a light emitting area of the second light emitting element 15 emitting light of the same color. A minimum distance between adjacent first light emitting elements 14 in the first direction X may be greater than a minimum distance between adjacent second light emitting elements 15 in the first direction X. A minimum distance between adjacent first light emitting elements 14 in the second direction Y may be greater than a minimum distance between adjacent second light emitting elements 15 in the second direction Y.

A display substrate in this example can be beneficial for increasing the pixel density of the first display region by providing the first light emitting elements in the transmissive region, thereby achieving high PPI display. Remaining description of the display substrate in this example may be referred to the description in the aforementioned embodiments, which is not repeated here.

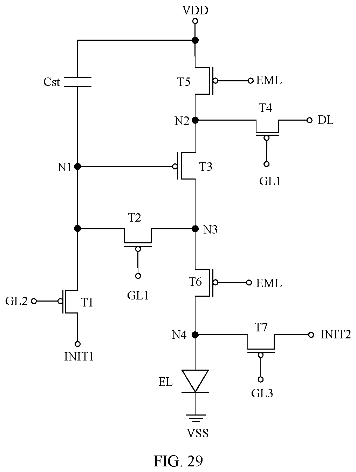

FIG. 29 is an equivalent circuit diagram of a pixel circuit according to at least one embodiment of the present disclosure. The pixel circuit in this example is described by taking a 7T1C structure as an example. In some examples, as shown in FIG. 29, the pixel circuit in this example may include seven transistors (i.e. a first transistor T1 to a seventh transistor T7) and one storage capacitor Cst. A light emitting element EL may include an anode, a cathode and an organic light emitting layer disposed between the anode and the cathode.

In some examples, as shown in FIG. 29, the pixel circuit may be connected with a first scan line GL1, a second scan line GL2, a third scan line GL3, a data line DL, a first power supply line VDD, a light emitting control line EML, a first initial signal line INIT1, and a second initial signal line INIT2. The light emitting element EL may be connected with the pixel circuit and a second power supply line VSS.

In some examples, the first power supply line VDD may be configured to provide a constant first voltage signal to the pixel circuit, and the second power supply line VSS may be configured to provide a constant second voltage signal to the pixel circuit, and the first voltage signal may be greater than the second voltage signal. The first scan line GL1 may be configured to provide a first scan signal SCAN1 to the pixel circuit, the data line DL may be configured to provide a data signal to the pixel circuit, the light emitting control line EML may be configured to provide a light emitting control signal EM to the pixel circuit, the second scan line GL2 may be configured to provide a second scan signal SCAN2 to the pixel circuit, and the third scan line GL3 may be configured to provide a third scan signal SCAN3 to the pixel circuit.

In some examples, the second scan line GL2 electrically connected to an n-th row of pixel circuits may be electrically connected to the first scan line GL1 electrically connected to an (n-1)-th row of pixel circuits, so that the second scan line GL2 is input with a first scan signal SCAN1 (n-1). That is, a second scan signal SCAN2 (n) may be the same as the first scan signal SCAN1 (n-1). A third scan line GL3 of the n-th row of pixel circuits may be electrically connected with a first scan line GL1 of the n-th row of pixel circuits, so that the third scan line GL3 is input with the first scan signal SCAN1 (n). That is, the third scan signal SCAN3 (n) may be the same as the first scan signal SCAN1 (n). n is an integer greater than 0. Thus, signal lines of the display substrate can be reduced, thereby achieving a narrow bezel design for the display substrate. However, the embodiment is not limited thereto.

In some examples, the first initial signal line INIT1 may be configured to provide a first initial signal to the pixel circuit, and the second initial signal line INIT2 may be configured to provide a second initial signal to the pixel circuit. In some examples, the first initial signal and the second initial signal line may be the same, so only the first initial signal line may be provided to provide the first initial signal. However, the embodiment is not limited thereto. In some other examples, the first initial signal may be different from the second initial signal. The first initial signal and the second initial signal may be constant voltage signals, and their magnitudes may be between a first voltage signal and a second voltage signal, but are not limited thereto.

In some examples, as shown in FIG. 29, a gate of the third transistor T3 is electrically connected with a first node N1, a first electrode of the third transistor T3 is electrically connected with a second node N2, and a second electrode of the third transistor T3 is electrically connected with a third node N3. The third transistor T3 may be referred to as a drive transistor. A gate of the fourth transistor T4 is electrically connected with the first scan line GL1, a first electrode of the fourth transistor T4 is electrically connected with the data line DL, and a second electrode of the fourth transistor T4 is electrically connected with the first electrode of the third transistor T3. The fourth transistor T4 may be referred to as a data writing transistor. A gate of the second transistor T2 is electrically connected with the first scan line GL1, a first electrode of the second transistor T2 is electrically connected with the gate of the third transistor T3, and a second electrode of the second transistor T2 is electrically connected with the second electrode of the third transistor T3. The second transistor T2 may also be referred to as a threshold compensation transistor. A gate of the fifth transistor T5 is electrically connected with the light emitting control line EML, a first electrode of the fifth transistor T5 is electrically connected with the first power supply line VDD, and a second electrode of the fifth transistor T5 is electrically connected with the first electrode of the third transistor T3. A gate of the sixth transistor T6 is electrically connected with the light emitting control line EML, a first electrode of the sixth transistor T6 is electrically connected with the second electrode of the third transistor T3, and a second electrode of the sixth transistor T6 is electrically connected with an anode of the light emitting element EL. The fifth transistor T5 and the sixth transistor T6 may also be referred to as light emitting control transistors. The first transistor T1 is electrically connected with the gate of the third transistor T3, and configured to reset the gate of the third transistor T3, and the seventh transistor T7 is electrically connected with the anode of the light emitting element EL, and configured to reset the anode of the light emitting element EL. A gate of the first transistor T1 is electrically connected with the second scan line GL2, a first electrode of the first transistor T1 is electrically connected with the first initial signal line INIT1, and a second electrode of the first transistor T1 is electrically connected with the gate of the third transistor T3. A gate of the seventh transistor T7 is connected with the third scan line GL3, a first electrode of the seventh transistor T7 is connected with the second initial signal line INIT2, and a second electrode of the seventh transistor T7 is connected with the anode of the light emitting element EL. The first transistor T1 and the seventh transistor T7 may also be referred to as reset control transistors. A first plate of the storage capacitor Cst is electrically connected with the gate of the third transistor T3, and a second plate of the storage capacitor Cst is electrically connected with the first power supply line VDD.

In this example, the first node N1 is a connection point for the storage capacitor Cst, the first transistor T1, the third transistor T3 and the second transistor T2, the second node N2 is a connection point for the fifth transistor T5, the fourth transistor T4, and the third transistor T3, the third node N3 is a connection point for the third transistor T3, the second transistor T2, and the sixth transistor T6, and the fourth node N4 is a connection point for the sixth transistor T6, the seventh transistor T7, and the light emitting element EL.

An operating process of the pixel circuit is described below. The description is given by taking a case in which a plurality of transistors included in the pixel circuit shown in FIG. 29 are all P-type transistors as an example. In this example, the third scan signal provided by the third scan line GL3 may be the same as the first scan signal provided by the first scan line GL1.

In some examples, during one-frame display time period, the operating process of the pixel circuit may include a first stage, a second stage, and a third stage.

The first stage is referred to as a reset stage. The second scan signal SCAN2 provided by the second scan signal line GL2 may be a low-level signal, so that the first transistor T1 is turned on, and the first initial signal provided by the first initial signal line INIT1 is provided to the first node N1 to initialize the first node N1 and clear an original data voltage in the storage capacitor Cst. The first scan signal SCAN1 provided by the first scan line GL1 may be a high-level signal, and the light emitting control signal EM provided by the light emitting control line EML may be a high-level signal, so that the fourth transistor T4, the second transistor T2, the fifth transistor T5, the sixth transistor T6 and the seventh transistor T7 are turned off. In this stage, the light emitting element EL does not emit light.

The second stage is referred to as a data writing stage or a threshold compensation stage. The first scan signal SCAN1 provided by the first scan line GL1 may be a low-level signal, the second scan signal SCAN2 provided by the second scan line GL2 and the emitting control signal EM provided by the emitting control line EML may be both high-level signals, and the data line DL outputs a data signal DATA. In this stage, since the first plate of the storage capacitor Cst is at a low level, the third transistor T3 is turned on. The first scan signal SCAN1 is the low-level signal, so that the second transistor T2, the fourth transistor T4, and the seventh transistor T7 are turned on. The second transistor T2 and the fourth transistor T4 are turned on, so that a data voltage Vdata output by the data line DL is provided to the first node N1 through the second node N2, the turned-on third transistor T3, the third node N3, and the turned-on second transistor T2, and the storage capacitor Cst is charged with a difference between the data voltage Vdata output by the data line DL and a threshold voltage of the third transistor T3. A voltage of the first plate (i.e., the first node N1) of the storage capacitor Cst is Vdata-|Vth|, wherein Vdata is the data voltage output by the data line DL, and Vth is the threshold voltage of the third transistor T3. The seventh transistor T7 is turned on, so that a second initial signal provided by the second initial signal line INIT2 is provided to the anode of the light emitting element EL to initialize (reset) the anode of the light emitting element EL and clear a pre-stored voltage therein, so as to complete initialization, thereby ensuring that the light emitting element EL does not emit light. The second scan signal SCAN2 provided by the second scan line GL2 may be a high-level signal, so that the first transistor T1 is turned off. The light emitting control signal EM provided by the light emitting control signal line EML is a high-level signal, so that the fifth transistor T5 and the sixth transistor T6 are turned off.

The third stage is referred to as a light emitting stage. The light emitting control signal EM provided by the light emitting control line EML is a low-level signal, and the first scan signal SCAN1 provided by the first scan line GL1 and the second scan signal SCAN2 provided by the second scan line GL2 are high-level signals. The light emitting control signal EM provided by the light emitting control line EML is a low-level signal, so that the fifth transistor T5 and the sixth transistor T6 are turned on, and the first voltage signal output from the first power supply line VDD provides a drive voltage to the anode of the light emitting device EL through the turned-on fifth transistor T5, third transistor T3 and sixth transistor T6 to drive the light emitting element EL to emit light.

In a drive process of the pixel circuit, a drive current flowing through the third transistor T3 is determined by a voltage difference between the gate and the first electrode of the third transistor T3. Since the voltage of the first node N1 is Vdata-|Vth|, the drive current of the third transistor T3 is as follows.

$$I＝K×(Vgs\text{-}Vth)^2＝K×[(Vdd\text{-}Vdata+|Vth|)\text{-}Vth]^2＝K×[Vdd\text{-}Vdata]^2。$$

Herein I is the drive current flowing through the third transistor T3 (i.e., a drive current for driving the light emitting element EL), K is a constant, Vgs is the voltage difference between the gate and the first electrode of the third transistor T3, Vth is the threshold voltage of the third transistor T3, Vdata is the data voltage output by the data line DL, and Vdd is the first voltage signal output by the first power supply line VDD.

It may be seen from the above formula that a current flowing through the light emitting element EL is independent of the threshold voltage of the third transistor T3. Therefore, the pixel circuit according to this embodiment may better compensate the threshold voltage of the third transistor T3.

Taking the display substrate shown in FIG. 28 as an example, a film structure of the display substrate will be explained by an example of a manufacturing process of the display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

"A and B are disposed in a same layer", and "A and B have a same layer structure" in the present disclosure means that A and B are formed simultaneously through a same patterning process, or distances between surfaces of A and B close to a substrate and the substrate are substantially the same, or the surfaces of A and B close to the substrate are in direct contact with a same film. A "thickness" of a film layer is a dimension of the film layer in a direction perpendicular to the display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B. "Shape of A" in the present disclosure refers to a shape of an orthographic projection of A on the substrate.

In some examples, the manufacturing process of the display substrate may include following acts. The 7T1C structure shown in FIG. 29 is used as an example of a pixel circuit of a display region. A first pixel circuit (also acting as a second pixel circuit) of an island region A11 may include a first transistor 51, a second transistor 52, a third transistor 53, a fourth transistor 54, a fifth transistor 55, a sixth transistor 56, a seventh transistor 57, and a storage capacitor. A second region pixel circuit of a second display region may include a first transistor 61, a second transistor 62, a third transistor 63, a fourth transistor 64, a fifth transistor 65, a sixth transistor 66, a seventh transistor 67, and a storage capacitor.

(1) A substrate is provided. In some examples, the substrate may be a rigid substrate or a flexible substrate. For example, the rigid substrate may be made of, but not limited to, one or more of glass and quartz. The flexible substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible substrate may include a first flexible material layer, a first inorganic material layer, a second flexible material layer and a second inorganic material layer which are stacked. The first flexible material layer and the second flexible material layer may be made of a material such as polyimide (PI), polyethylene terephthalate (PET), or a polymer soft film on which surface treatment is performed, and materials of the first inorganic material layer and the second inorganic material layer may be silicon nitride (SiNy, y>0) or silicon oxide (SiOx, x>0), etc., which are used to improve resistance to water and oxygen of the substrate.

(2) A semiconductor layer is formed. In some examples, a buffer thin film and a semiconductor thin film are deposited on the substrate sequentially, and the semiconductor thin film is patterned through a patterning process to form a buffer layer disposed on the substrate and a semiconductor layer disposed on the buffer layer. In some examples, a material of the semiconductor layer may be amorphous Silicon (a-Si), polycrystalline Silicon (p-Si), hexathiophene or polythiophene, or another material.

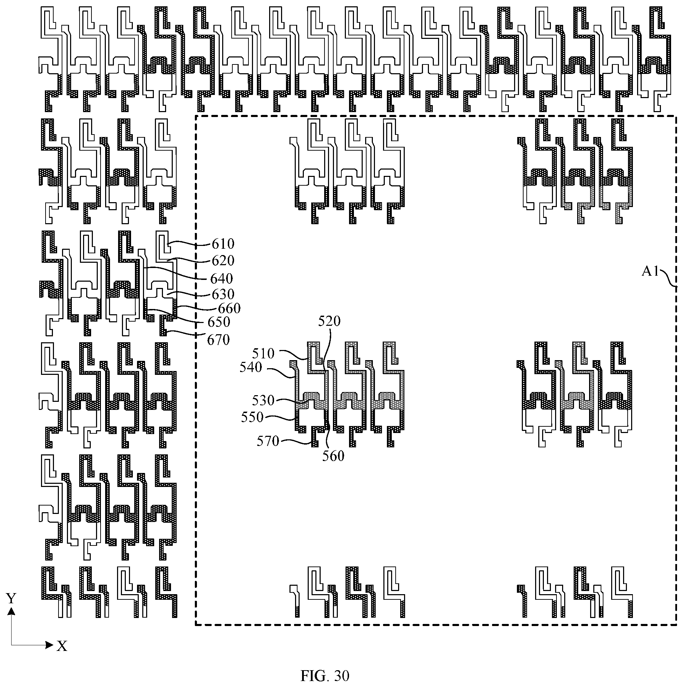

FIG. 30 is a schematic diagram of a partition of a semiconductor layer of a display region according to at least one embodiment of the present disclosure. FIG. 30 shows a partial junction region between a first display region A1 and a second display region. In some examples, as shown in FIG. 30, the semiconductor layer of the display region may include, at least, active layers (e.g., including an active layer 510 of the first transistor, an active layer 520 of the second transistor, an active layer 530 of the third transistor, an active layer 540 of the fourth transistor, an active layer 550 of the fifth transistor, an active layer 560 of the sixth transistor, and an active layer 570 of the seventh transistor, of the first pixel circuit) of a plurality of transistors of a plurality of first pixel circuits (for example, there are three first pixel circuits in each island region) located in the island region of the first display region A1, and active layers (e.g., including an active layer 610 of the first transistor, an active layer 620 of the second transistor, an active layer 630 of the third transistor, an active layer 640 of the fourth transistor, an active layer 640 of the fifth transistor, an active layer 650 of the fifth transistor, an active layer 660 of the sixth transistor, and an active layer 670 of the seventh transistor, of the second region pixel circuit) of a plurality of transistors of a plurality of second region pixel circuits located in the second display region.

In some examples, active layers of first to seventh transistors of each first pixel circuit may be connected to each other to form an integral structure. Active layers of first to seventh transistors of each second region pixel circuit may be connected to each other to form an integral structure.

In some examples, an active layer of each transistor may include: a first region, a second region, and a channel region located between the first region and the second region. A material of the semiconductor layer may include polysilicon, for example. The channel region may be not doped with impurities, and has characteristics of a semiconductor. The first region and the second region may be doped regions on both sides of the channel region, and are doped with impurities, and thus have conductivity. The impurities may be different according to a type of a transistor. In some examples, a doped region of the active layer may be interpreted as a source or a drain of a transistor. A part of active layers between transistors may be interpreted as a wiring doped with impurities, and may be used for electrically connecting the transistors. The embodiment is not limited thereto.

(3) A first conductive layer is formed. In some examples, a first gate insulation thin film and a first conductive thin film are sequentially deposited on the substrate on which the aforementioned patterns are formed, and the first conductive thin film is patterned through a patterning process to form a first gate insulation layer disposed on the semiconductor layer and a first conductive layer disposed on the first gate insulation layer.

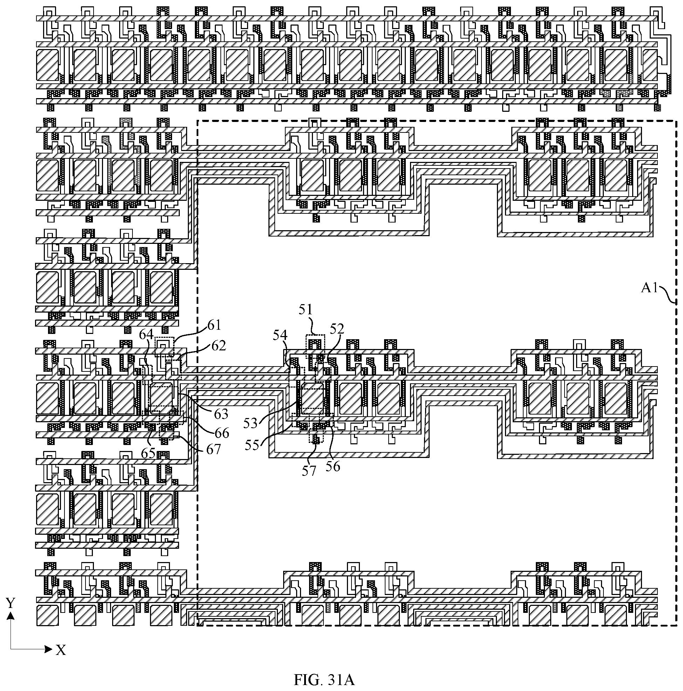

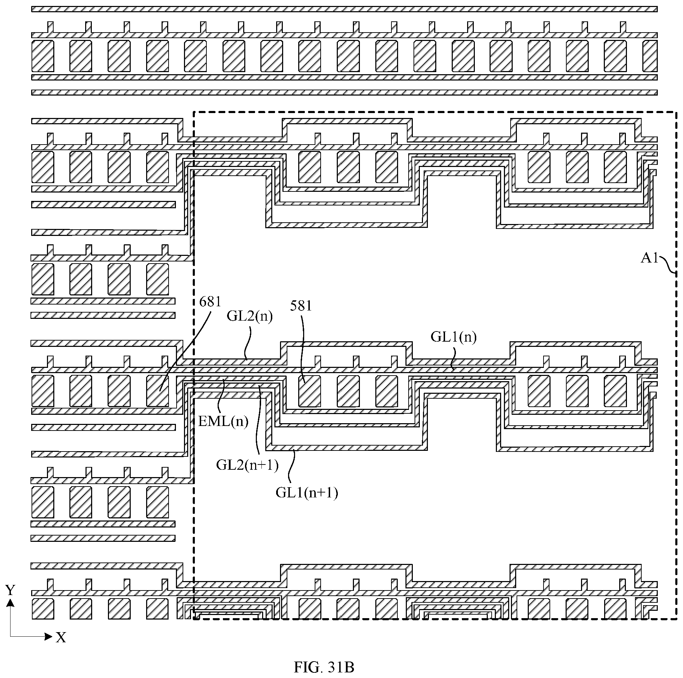

FIG. 31A is a schematic diagram of a partition of a display region after a first conductive layer is formed, according to at least one embodiment of the present disclosure. FIG. 31B is a schematic diagram of the first conductive layer in FIG. 31A. In some examples, as shown in FIGs. 31A and 31B, the first conductive layer of the display region may include, at least, a plurality of first scan lines (e.g., including first scan lines GL1 (n) and GL1 (n+1)), a plurality of second scan lines (e.g., including second scan lines GL2 (n) and GL2 (n+1)), a plurality of light emitting control lines (e.g., including light emitting control lines EML (n)), a first plate 581 of the storage capacitor of the first pixel circuit, and a first plate 681 of the storage capacitor of the second region pixel circuit.

In some examples, the first plate 581 of the storage capacitor of the first pixel circuit may also serve as a gate of a third transistor 53. The first plate 681 of the storage capacitor of the second region pixel circuit may also serve as a gate of a third transistor 63.

In some examples, two rows of second region pixel circuits in the second display region may correspond to one row of first pixel circuits in the first display region A1. The first scan line GL1 (n), the second scan line GL2 (n), and the light emitting control line EML (n) may be connected to a second region pixel circuit in an n-th row. The first scan line GL1 (n), the light emitting control line EML (n), and the first scan line GL1 (n+1) may be connected with a first pixel circuit in an n-th row, and the second scan line GL2 (n+1) may be configured to connect with a seventh transistor of the first pixel circuit in the n-th row. The first scan line GL1 (n+1) is connected with a second region pixel circuit in an (n+1)-th row, and bypasses the first pixel circuit in the n-th row on a side of the first pixel circuit in the n-th row in a direction opposite to a second direction Y.

In some examples, a shape of the second scan line GL2(n) may be substantially a polyline extending along a first direction X. A region where the second scan line GL2 (n) is overlapped with the active layer 610 of the first transistor 61 of the second region pixel circuit in the n-th row may act as a gate of the first transistor 61. A region where the second scan line GL2 (n) is overlapped with the active layer 510 of the first transistor 51 of the first pixel circuit in the n-th row may act as a gate of the first transistor 51.

In some examples, a shape of the first scan line GL1 (n) may be approximately a straight line extending along the first direction X. A region where the first scan line GL1 (n) is overlapped with the active layer 620 of the second transistor 62 of the second region pixel circuit in the n-th row may act as a gate of the second transistor 62, and a region where the first scan line GL1 (n) is overlapped with the active layer 640 of the fourth transistor 64 may act as a gate of the fourth transistor 64. A region where the first scan line GL1 (n) is overlapped with the active layer 520 of the second transistor 52 of the first pixel circuit in the n-th row may act as a gate of the second transistor 52, and a region where the first scan line GL1 (n) is overlapped with the active layer 540 of the fourth transistor 54 may serve as a gate of the fourth transistor 54.

In some examples, a shape of the light emitting control line EML(n) may be substantially a polyline extending along the first direction X. A region where the light emitting control line EML(n) is overlapped with the active layer 650 of the fifth transistor 65 of the second region pixel circuit in the n-th row may act as a gate of the fifth transistor 65, and a region where the light emitting control line EML(n) is overlapped with the active layer 660 of the sixth transistor 66 may act as a gate of the sixth transistor 66. A region where the light emitting control line EML(n) is overlapped with the active layer 550 of the fifth transistor 55 of the first pixel circuit in the n-th row may act as a gate of the fifth transistor 55, and a region where the light emitting control line EML(n) is overlapped with an active layer 560 of the sixth transistor 56 may serve as a gate of the sixth transistor 56.

In some examples, a shape of the second scan line GL2(n+1) may be substantially a polyline extending along the first direction X. A region where the second scan line GL2(n+1) is overlapped with the active layer 570 of the seventh transistor 57 of the first pixel circuit in the n-th row may act as a gate of the seventh transistor 57.

In some examples, after a pattern of the first conductive layer is formed, the first conductive layer may be used as a shield to perform a conductive processing on the semiconductor layer. The semiconductor layer in a region, which is shielded by the first conductive layer, forms a channel region of a transistor, and the semiconductor layer in a region, which is not shielded by the first conductive layer, may be made to be conductive, that is, both a first region and a second region of an active layer may be made to be conductive.

(4) A second conductive layer is formed. In some examples, a second gate insulation thin film and a second conductive thin film are sequentially deposited on the substrate on which the aforementioned patterns are formed, and the second conductive thin film is patterned through a patterning process to form a second gate insulation layer disposed on the first conductive layer and a second conductive layer disposed on the second gate insulation layer.

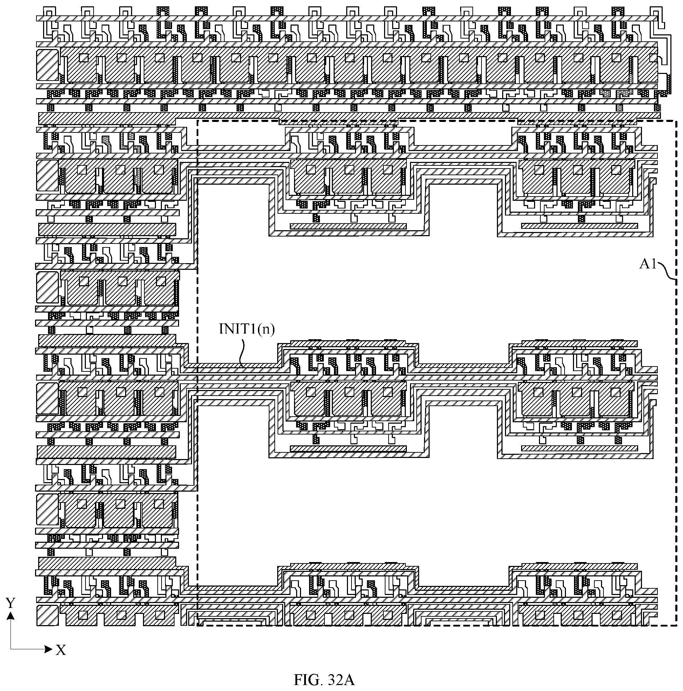

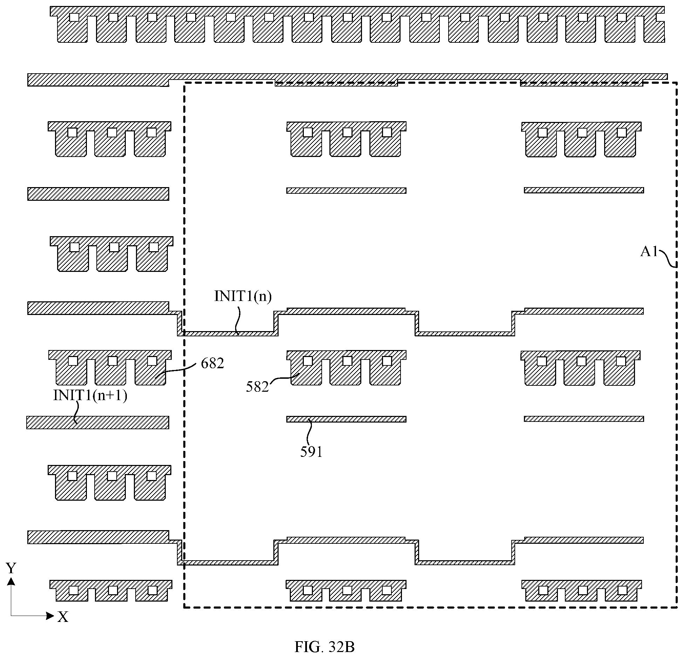

FIG. 32A is a schematic diagram of a partition of a display region after a second conductive layer is formed, according to at least one embodiment of the present disclosure. FIG. 32B is a schematic diagram of the second conductive layer in FIG. 32A. In some examples, as shown in FIGs. 32A and 32B, the second conductive layer of the display region may include, at least, a plurality of first initial signal lines (including, for example, first initial signal lines INIT1 (n), INIT1 (n+1)), a first initial connection section 591, a second plate 582 of the storage capacitor of the first pixel circuit, and a second plate 682 of the storage capacitor of the second region pixel circuit.

In some examples, an orthographic projection of the second plate 582 of the storage capacitor of the first pixel circuit on the substrate is overlapped with an orthographic projection of the first capacitor plate 581 on the substrate. Second plates 582 of storage capacitors of three first pixel circuits in one island region may be connected to each other to form an integral structure.

In some examples, an orthographic projection of the second plate 682 of the storage capacitor of the second region pixel circuit on the substrate is overlapped with an orthographic projection of the first plate 681 on the substrate. Second plates 682 of storage capacitors of a plurality of second region pixel circuits in a same row may be connected to each other to form an integral structure.

In some examples, the first initial connection segment 591 may be located in the island region, and be a strip extending along the first direction X. The first initial connection section 591 may be located on a side of the semiconductor layer of the three first pixel circuits in the island region in a direction opposite to the second direction.

In some examples, a shape of the first initial signal line INIT1(n) may be substantially a polyline extending along the first direction X. The first initial signal line INIT1(n) may extend from the second display region to the first display region A1, and the first initial signal line INIT1(n+1) does not extend to the first display region A1. The first initial signal line in this example may be configured to provide an initial signal to the first transistor and the seventh transistor.

(5) A third conductive layer is formed. In some examples, an interlayer insulation thin film is deposited on the substrate on which the aforementioned patterns are formed, and the interlayer insulation thin film is patterned through a patterning process to form an interlayer insulation layer. The interlayer insulation layer of the display region may be provided with a plurality of vias that may expose, for example, a part of a surface of the semiconductor layer, a part of a surface of the first conductive layer, and a part of a surface of the second conductive layer. Subsequently, a third conductive thin film is deposited on the substrate on which the aforementioned patterns are formed, and the third conductive thin film is patterned through a patterning process to form a third conductive layer disposed on the interlayer insulation layer.

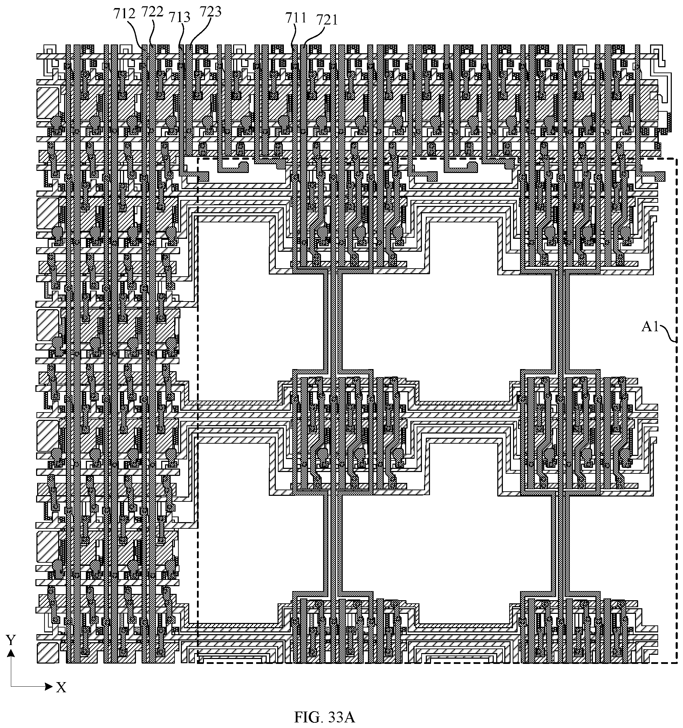

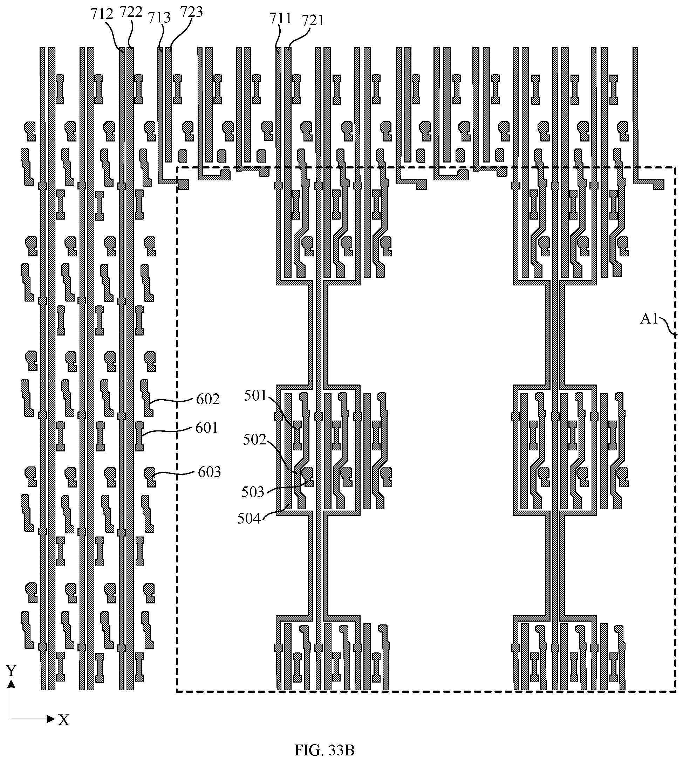

FIG. 33A is a schematic diagram of a partition of a display region after a third conductive layer is formed, according to at least one embodiment of the present disclosure. FIG. 33B is a schematic diagram of the third conductive layer in FIG. 33A. In some examples, as shown in FIGs. 33A and 33B, the third conductive layer of the display region may include, at least, a plurality of data lines (including, for example, data lines 711, 712, and 713), a plurality of first power supply lines (including, for example, first power supply lines 721, 722, and 723), and a plurality of connection electrodes (including, for example, a first connection electrode 501, a second connection electrode 502, a third connection electrode 503, a fourth connection electrode 504, a fifth connection electrode 601, a sixth connection electrode 602, and a seventh connection electrode 603).

In some examples, the first connection electrode 501, the second connection electrode 502, the third connection electrode 503, and the fourth connection electrode 504 may be located in the island region. The first connection electrode 501 may be connected with the active layer 520 of the second transistor 52 of the first pixel circuit, and may also be connected with the gate of the third transistor 53. The first connection electrode 501 may act as a first node of the first pixel circuit. The second connection electrode 502 may be connected with the first initial signal line INIT1 (n), may be also connected with the active layer 510 of the first transistor 51, may be also connected with the active layer 570 of the seventh transistor 57, and may be also connected with the first initial connection section 591. The second connection electrode 502 may achieve electrical connections of the first initial signal line with the first transistor 51 and the seventh transistor 57. The third connection electrode 503 may be connected with the active layer 560 of the sixth transistor 56. The fourth connection electrode 504 may be connected with the active layer 550 of the fifth transistor 55.

In some examples, the fifth connection electrode 601, the sixth connection electrode 602, and the seventh connection electrode 603 may be located in the second display region. The fifth connection electrode 601 may be connected with the active layer 620 of the second transistor 62 of the second region pixel circuit, and may be also connected with the gate of the third transistor 63. The sixth connection electrode 602 may be connected with the first initial signal line INIT1 (n), the active layer 610 of the first transistor 61 of the second region pixel circuit in the n-th row, and the active layer 670 of the seventh transistor 67 of the second region pixel circuit in the (n-1)-th row. The seventh connection electrode 603 may be connected with the active layer 660 of the sixth transistor 66 of the second region pixel circuit.

In some examples, in the second direction Y, six columns of second region pixel circuits may correspond to three columns of first pixel circuits. The data line 711 may extend from the second display region to the first display region A1, and is connected with the active layer 540 of the fourth transistor 54 of the first pixel circuit in the island region. A shape of the data line 711 may be substantially a polyline or a straight line extending along the second direction Y. The data line 712 may be located in the second display region and connected with the active layers 640 of the fourth transistors 64 of the plurality of second region pixel circuits arranged along the second direction Y. The data line 713 may be located in the second display region, and connected with a data transfer line located in the fourth conductive layer at a junction region between the second display region and the first display region A1. In the first direction X, three data lines 713 and three data lines 711 may be arranged alternately in turn. The three data lines 713 may be bypassed from a side of the first pixel circuit by the data transfer line, and the three data lines 711 may be connected with the three first pixel circuits in the island region respectively, so as to achieve transmission of data signals.

In some examples, the first power supply line 721 may extend from the second display region to an island region in an adjacent first display region A1, and be connected with the active layer 550 of the fifth transistor 55 of the first pixel circuit in the island region to achieve transmission of the first voltage signal. The first power supply lines 722 and 723 may be located in the second display region, and connected with the active layers 650 of the fifth transistors 65 of the plurality of second region pixel circuits arranged in the second direction Y to achieve longitudinal transmission of the first voltage signal in the second display region. In the first direction X, three first power supply lines 723 and three first power supply lines 721 may be arranged alternately in turn.

(6) A fourth conductive layer is formed. In some examples, a passivation insulation thin film is deposited on the substrate on which the aforementioned patterns are formed, and the passivation insulation thin film is patterned through a patterning process to form a passivation layer. The passivation layer may be provided with a plurality of vias which may expose a part of a surface of the third conductive layer. Subsequently, a fourth conductive thin film is deposited on the substrate on which the aforementioned patterns are formed, and the fourth conductive thin film is patterned through a patterning process to form a fourth conductive layer disposed on the passivation layer. In some examples, the fourth conductive layer may also be referred to as a second source-drain metal layer.

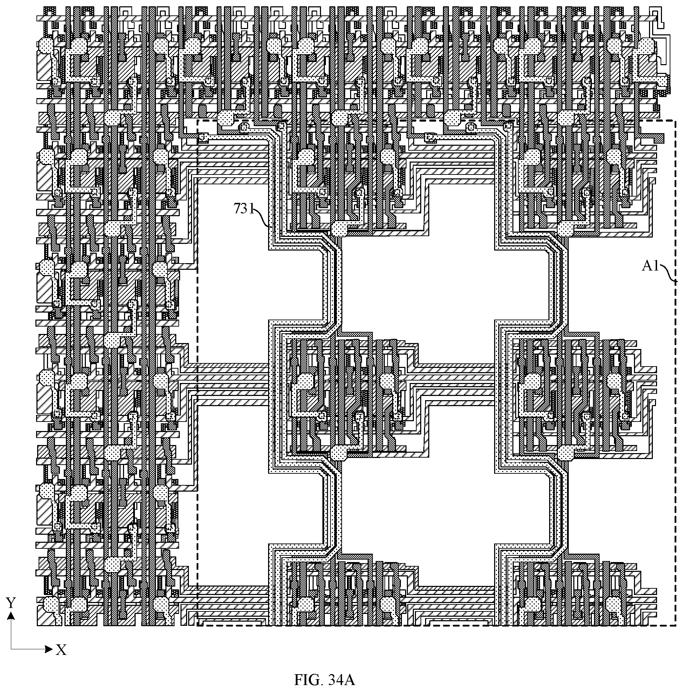

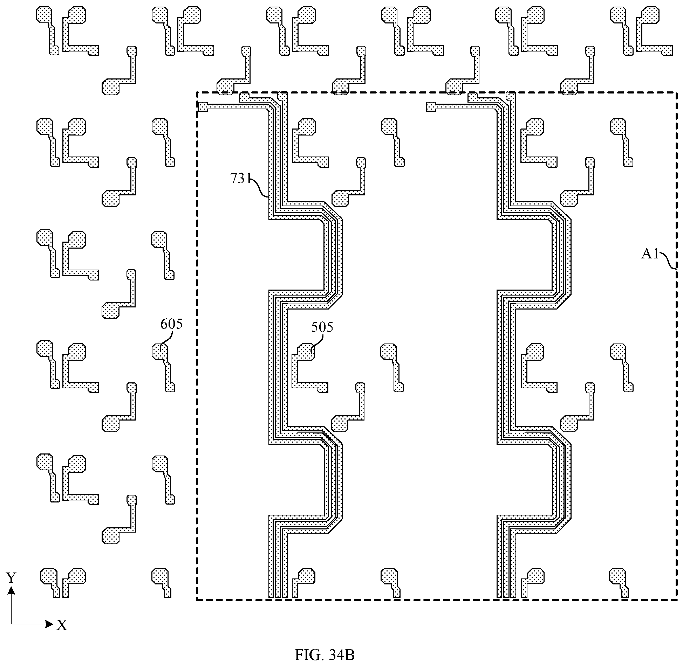

FIG. 34A is a schematic diagram of a partition of a display region after a fourth conductive layer is formed, according to at least one embodiment of the present disclosure. FIG. 34B is a schematic diagram of the fourth conductive layer in FIG. 34A. In some examples, as shown in FIGs. 34A and 34B, the fourth conductive layer of the display region may include, at least, a plurality of connection electrodes (including, for example, an eighth connection electrode 505 and a ninth connection electrode 605), and a plurality of data transfer lines 731.

In some examples, the eighth connection electrode 505 is located in the island region of the first display region A1 and connected with the third connection electrode 503, so as to achieve connection with the sixth transistor of the first pixel circuit. The ninth connection electrode 605 may be located in the second display region and connected with the seventh connection electrode 603, so as to achieve connection with the sixth transistor of the second region pixel circuit.

In some examples, the data transfer lines 731 may be located in the first display region A1. The data transfer lines 731 may be substantially polylines extending along the second direction Y. An end of the data transfer line 731 may be connected with an end of a data line 713 in the second display region on an upper side of the first display region A1, and the other end of the data transfer line 731 may be connected to with an end of the data line 713 in the second display region on a lower side of the first display region A1, thereby achieving transmission of data signals in the second display region on the upper and lower sides of the first display region A1. The three data transfer lines 731 may serve as a group and be located on a side of the three first pixel circuits in a direction opposite to the first direction X.

(7) An anode layer is formed. In some examples, a planarization thin film is coated on the substrate on which the aforementioned patterns are formed, and the planarization thin film is patterned by a patterning process to form a planarization layer. Subsequently, an anode thin film is deposited on the substrate on which the aforementioned patterns are formed, and the anode thin film is patterned through a patterning process to form an anode layer.

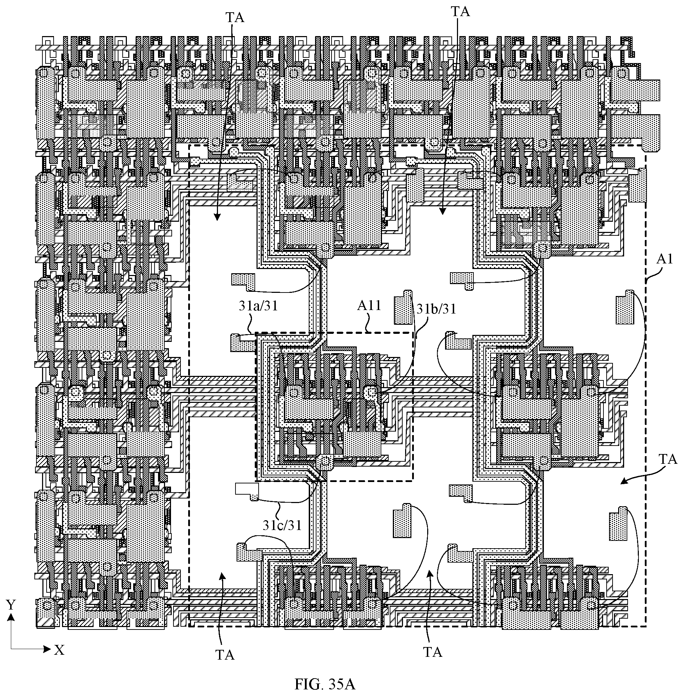

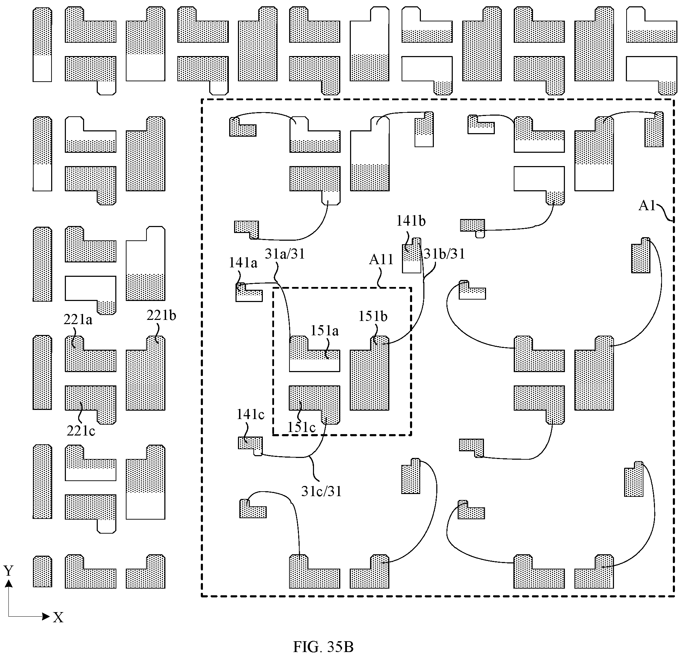

FIG. 35A is a schematic diagram of a partition of a display region after an anode layer is formed, according to at least one embodiment of the present disclosure. FIG. 35B is a schematic diagram of the anode layer in FIG. 35A. In some examples, as shown in FIGs. 35A and 35B, the anode layer may include anodes 151a, 151b, and 151c of the second light emitting element located in the island region of the first display region A1, anodes 141a, 141b, and 141c of the first light emitting element located in the transmissive region of the first display region A1, anodes 221a, 221b, and 221c of the second region light emitting element located in the second display region, and a plurality of first connection lines 31 located in the first display region A1.

In some examples, the anode 221b of the second region light emitting element may be connected through the ninth connection electrode 603, thereby achieving connection with the sixth transistor of the second region pixel circuit.

In some examples, the anode 151a of the second light emitting element may be connected with the eighth connection electrode 505, thereby achieving electrical connection with the sixth transistor of the first pixel circuit. The anode 151a of the second light emitting element may be connected with the anode 141a of the first light emitting element through the first connection line 31a. The anode 151b of the second light emitting element may be connected with the anode 141b of the first light emitting element through the first connection line 31b. The anode 151c of the second light emitting element may be connected with the anode 141c of the first light emitting element through the first connection line 31c.

In some examples, the anode layer may include a first sub-conductive layer, a second sub-conductive layer, and a third sub-conductive layer which are stacked. Materials of the first sub-conductive layer and the third sub-conductive layer may be the same. For example, a transparent conductive material may be used, such as Indium Tin Oxide (ITO). The second sub-conductive layer may be made of a metal material, including silver (Ag), for example. The first connection line 31 may be in a same layer as the first sub-conductive layer, thereby achieving electrical connection of the anode of the first light emitting element with the anode of the second light emitting element.

In some examples, an orthographic projection of a first light emitting element disposed at the junction region between the first display region A1 and the second display region on the substrate may be overlapped with an orthographic projection of a metal trace (including, for example, the first scan line, the second scan line, and the light emitting control line) extending along the first direction X on the substrate.

In some examples, a plurality of transmissive regions TA may be formed by surrounded by the island regions A11, connection lines between adjacent island regions A11, and the second display region. The transmissive region TA may be provided with a plurality of first light emitting elements, and an anode of the first light emitting element may be connected with an anode of a second light emitting element in the island region through the first connection line 31, so as to achieve electrical connection with a same pixel circuit.

Subsequently, a pixel definition layer, an organic light emitting layer, a cathode layer and an encapsulation layer are formed sequentially. In some examples, a plurality of pixel openings are formed in the pixel definition layer, and organic light emitting layers may be formed within the plurality of pixel openings, respectively. The organic light emitting layers are connected with corresponding anodes, and the cathode layer may be connected with the organic light emitting layer. In some examples, the cathode layer of the first display region may have a patterned design, so that a cathode layer outside the region where the light emitting element is located may be removed to increase the light transmittance of the first display region.

In some examples, the first conductive layer, the second conductive layer, the third conductive layer, and the fourth conductive layer may be made of a metal material, such as any one or more of Silver (Ag), Copper (Cu), Aluminum (Al), and Molybdenum (Mo), or an alloy material of the aforementioned metals, such as an Aluminum Neodymium alloy (AlNd) or a Molybdenum Niobium alloy (MoNb), and may be of a single-layer structure or a multi-layer composite structure, such as Mo/Cu/Mo. The first gate insulation layer, the second gate insulation layer, the interlayer insulation layer and the passivation layer may be made of any one or more of a silicon oxide ($SiO_x$, $x > 0$), a silicon nitride ($SiN_y$, $y > 0$) and a silicon oxynitride (SiON), and may be in a single-layer, or a multi-layer, or a composite layer. The planarization layer may be made of an organic material, e.g., polyimide, acrylic, or polyethylene terephthalate. The pixel definition layer may be made of an organic material, such as polyimide, acrylic, or polyethylene terephthalate. However, the embodiment is not limited thereto.

A structure and a manufacturing process of the display substrate of the embodiment are merely illustrative. In some examples, a corresponding structure may be changed and a patterning process may be added or reduced according to actual needs. In some other examples, the fourth conductive layer may be omitted, and the data line 713 located in the third conductive layer may extend directly to the first display region to avoid the first pixel circuit by bending the trace. In some other examples, at least one transparent conductive layer may be provided between the fourth conductive layer and the anode layer, and a plurality of first connection lines 31 may be located in the transparent conductive layer. In some other examples, a shielding layer may be provided on a side of the semiconductor layer close to the substrate. The embodiment is not limited thereto.

The manufacturing process in the exemplary embodiment may be implemented using an existing mature manufacturing device, and may be compatible well with an existing manufacturing process, simple in process implementation, easy to implement, high in a production efficiency, low in a production cost, and high in yield.

The display substrate provided in this example can increase the pixel density of the first display region while ensuring the light transmittance by providing the first light emitting element in the transmissive region, thereby achieving the high PPI display.

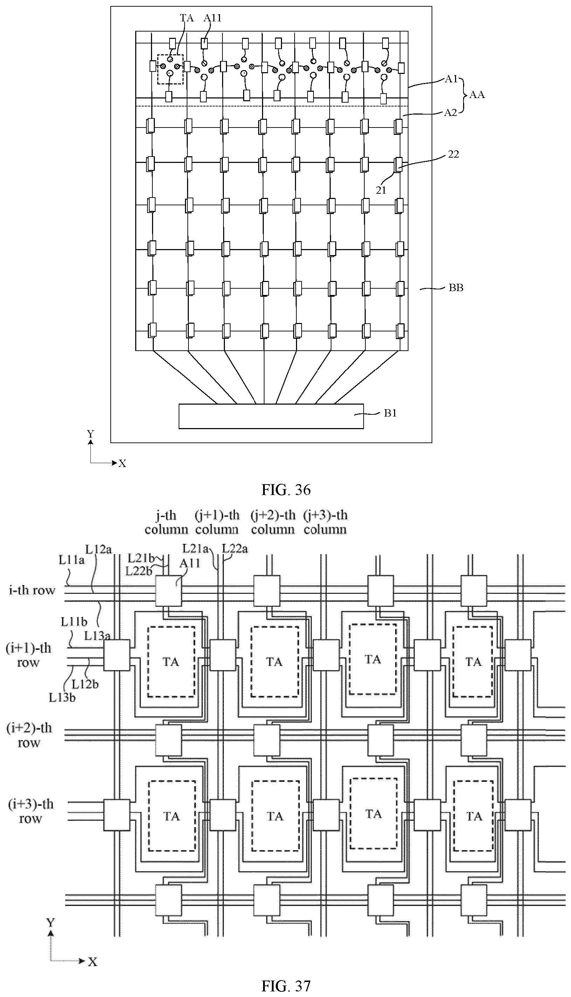

FIG. 36 is another schematic diagram of a display substrate according to at least one embodiment of the present disclosure. In some examples, as shown in FIG. 36, the display region AA may include a first display region A1, and a second display region A2 located on a side of the first display region A1. The first display region A1 may be located at a top of the display region AA, and three sides of the first display region A1 may be adjacent to a peripheral region BB, the first display region A1 and the second display region A2 may be adjacent in a second direction Y, and the first display region A1 may be located on a side of the second display region A2 along the second direction Y.

In some examples, as shown in FIG. 36, the first display region A1 may be substantially a rectangular region extending along a first direction X. The first display region A1 may include a plurality of island regions A11 and transmissive regions TA located between adjacent island regions A11. Each transmissive region TA may include at least one first light emitting element. A first pixel circuit driving the first light emitting element may be located in an island region A11 or in an inter-island connection region connecting the adjacent island regions A11. The embodiment is not limited thereto.

Remaining description of the display substrate in this example may be referred to the description in the aforementioned embodiments, which is not repeated here.

FIG. 37 is a partial schematic diagram of a pixel circuit and a trace of a first display region according to at least one embodiment of the present disclosure. FIG. 37 may be a schematic diagram of a partition of the first display region in FIG. 36. In some examples, as shown in FIG. 37, the first display region A1 may include, at least, a plurality of island regions A11, and a plurality of transmissive regions TA formed by surrounded by a plurality of island regions A11 and inter-island traces. The plurality of island regions A11 may be arranged in a plurality of rows and a plurality of columns, wherein each row includes a plurality of island regions A11 arranged along a first direction X, and each column may include a plurality of island regions A11 arranged along a second direction Y. Island regions A11 in adjacent rows may be misaligned in the second direction Y, and island regions A11 in adjacent columns may be misaligned in the first direction X. For example, island regions in an i-th row may be aligned with island regions in an (i+2)-th row in the second direction Y, island regions in an (i+1)-th row may be aligned with island regions in an (i+3)-th row in the second direction Y, and the island regions in the i-th row and the island regions in the (i+1)-th row may be misaligned in the second direction Y. Island regions in a j-th column and island regions in a (j+1)-th column may be misaligned in the first direction X, the island regions in the j-th column may be aligned with island regions in a (j+2)-th column in the first direction X, and the island regions in the (j+1)-th column may be aligned with island regions in a (j+3)-th column in the first direction X. A transmissive region TA may be provided between adjacent island regions in the (i+1)-th row, and a transmissive region TA may be provided between adjacent island regions in the j-th row.

In some examples, as shown in FIG. 37, each island region A11 may include one or more pixel circuits. The pixel circuit in this example may be a pixel circuit in the 7T1C structure shown in FIG. 29. Arrangement of pixel circuits in the island region A11 may be in a manner as that shown in FIG. 35A. The embodiment is not limited thereto.

In some examples, as shown in FIG. 37, pixel circuits in the island regions A11 may be connected with a plurality of first signal lines extending along the first direction X and a plurality of second signal lines extending along the second direction Y. For example, first signal lines connected to the pixel circuits of the island regions in the i-th row may include a first trace L11a (may be an initial signal line, for example), a second trace L12a (may be a scan line, for example), and a third trace L13a (may be a light emitting control line, for example). First signal lines connected to the pixel circuits of the island regions in the (i+1)-th row may include a first trace L11b (may be an initial signal line, for example), a second trace L12b (may be a scan line, for example), and a third trace L13b (may be a light emitting control line, for example). The first trace L11a, the second trace L12a, and the third trace L13a may extend substantially along the first direction X, and are connected with the pixel circuits of the island regions in the i-th row. The first traces L11b, the second traces L12b, and the third traces L13b may be connected with the pixel circuits of the island regions in the (i+1)-th row, and bent in the second direction Y to bypass the transmissive regions to ensure the dimension of the transmissive regions. For example, the first trace L11b may be bypassed from a side of the transmissive region TA in the second direction Y, and the second trace L12b and the third trace L13b may be bypassed from a side of the transmissive region TA in a direction opposite to the second direction Y. The embodiment is not limited thereto.

In some examples, as shown in FIG. 37, second signal lines connected to pixel circuits of the island regions in the j-th row may include a fourth trace L21b (may be a data line, for example) and a fifth trace L22b (may be a first power supply line, for example), second signal lines connected to pixel circuits of the island regions in the j-th row may include a fourth trace L21a (may be a data line, for example) and a fifth trace L22a (may be a first power supply line, for example). The fourth trace L21a and the fifth trace L22a may extend substantially along the second direction Y, and connected with the pixel circuits in the island regions in the (j+1)-th column. The fourth trace L21b and the fifth trace L22b may be connected with the pixel circuits in the island regions in the j-th column, and bent in the first direction X to bypass the transmissive regions to ensure the dimensions of the transmissive regions. For example, the fourth trace L21b and the fifth trace L22 may be bypassed from a side of the transmissive region TA in the first direction X. The embodiment is not limited thereto.

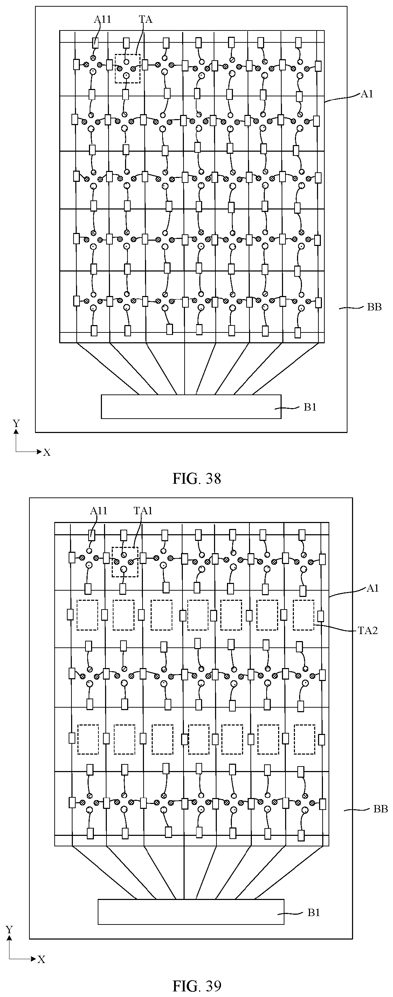

FIG. 38 is another schematic diagram of a display substrate according to at least one embodiment of the present disclosure. In some examples, as shown in FIG. 38, the display region may include a first display region A1, and a peripheral region BB may surround the first display region A1. The first display region A1 may include a plurality of island regions A11 and transmissive regions TA located between adjacent island regions A11. Each transmissive region TA may include at least one first light emitting element. A first pixel circuit driving the first light emitting elements may be located in an island region or in an inter-island connection region connecting the adjacent island regions. Each island region A11 may include one or more pixel circuits. The display substrate in this example may increase the light transmittance. Remaining description of the display substrate in this example may be referred to the description in the aforementioned embodiments, which is not repeated here.

FIG. 39 is another schematic diagram of a display substrate according to at least one embodiment of the present disclosure. In some examples, as shown in FIG. 39, the display region may include a first display region A1, and a peripheral region BB may surround the first display region A1. The first display region A1 may include a plurality of island regions A11 and transmissive regions located between adjacent island regions A11. The plurality of transmissive regions may include at least one first transmissive region TA1 and at least one second transmissive region TA2. The first transmissive region TA1 may include at least one first light emitting element, and the second transmissive region TA2 is not provided with a first light emitting element. Each island region A11 may include one or more pixel circuits.

In some examples, the first transmissive regions TA1 and the second transmissive regions TA2 may be arranged at intervals or in arrays. For example, in a second direction Y, a row of first transmissive regions TA1 and a row of second transmissive regions TA2 may be arranged at intervals. The embodiment is not limited thereto. In this example, the light transmittance of the display substrate can be increased. Remaining description of the display substrate in this example may be referred to the description in the aforementioned embodiments, which is not repeated here.

A display substrate is also provided in an embodiment. The display substrate includes a first display region including a plurality of island regions separated from each other, an inter-island connection region connecting adjacent island regions, and a plurality of transmissive regions surrounded by a plurality of island regions and the inter-island connection region. A light transmittance of the transmissive region is greater than a light transmittance of the island regions and a light transmittance of the inter-island connection region. The inter-island connection region includes at least one third light emitting element disposed on the substrate, and the at least one third light emitting element is electrically connected with at least one third pixel circuit. The at least one third pixel circuit is located in the island regions or the inter-island connection region.

In some examples, the third pixel circuits and the third light emitting elements located in the inter-island connection region may be connected in a one-to-one manner or in a one-to-multiple manner. For example, the third pixel circuit and the third light emitting element may be connected in a one-to-one correspondence. Alternatively, one third pixel circuit may be electrically connected with a plurality of third light emitting elements. For example, one third pixel circuit may be electrically connected with a plurality of third light emitting elements emitting light of a same color. The embodiment is not limited thereto.

According to the display substrate provided in this embodiment, the third light emitting elements are disposed in the inter-island connection region, and the third pixel circuits driving the third light emitting elements are disposed in the island region or the inter-island connection region, so that the pixel density of the first display region can be increased while the light transmittance of the first display region is ensured, thereby achieving high PPI display.

In some exemplary implementations, the first display region may further include at least one second light emitting element disposed on the substrate and located in the island region. The third pixel circuit of the island region is electrically connected with at least one second light emitting element and at least one third light emitting element located in the inter-island connection region, which emits light of a same color. The second light emitting element and the third light emitting element emitting of in the same color in this example may be driven by a same pixel circuit, which can be beneficial for reducing a quantity of pixel circuits and thereby improving the light transmittance of the first display region.

In some exemplary implementations, the first display region may further include at least one second light emitting element and at least one second pixel circuit which are disposed on the substrate and located in the island region. The at least one second pixel circuit is electrically connected with the at least one second light emitting element, and an orthographic projection of the second pixel circuit on the substrate may be overlapped, at least partially, with an orthographic projection of its connected second light emitting element on the substrate. The second light emitting element and the third light emitting element in this example may be driven by different pixel circuits, which is beneficial for ensuring the display effect of the first display region.

In some exemplary implementations, the inter-island connection region of the first display region may include a first inter-island connection region and a second inter-island connection region. The first inter-island connection region connects adjacent island regions along a first direction, and the second inter-island connection region connects adjacent island regions along a second direction, wherein the first direction intersects with the second direction, or the first direction may be perpendicular to the second direction. A quantity of pixel circuit rows in the first inter-island connection region is less than or equal to a quantity of pixel circuit rows in the island region, and a quantity of pixel circuit columns in the second inter-island connection region is less than or equal to a quantity of pixel circuit columns in the island region. A plurality of pixel circuits arranged along the first direction may be a row of pixel circuits, and a plurality of pixel circuits arranged along the second direction may be a column of pixel circuits. In this example, a space of the inter-island connection region can be fully used to arrange the pixel circuits.

In some exemplary implementations, the transmissive region may include at least one first light emitting element disposed on the substrate, wherein the at least one first light emitting element is electrically connected with at least one third pixel circuit. The first inter-island connection region includes a row of pixel circuits, and a third pixel circuit in the row of pixel circuits is connected with a plurality of first light emitting elements that emit light of a same color in two transmissive regions adjacent to the first inter-island connection region in the second direction. The second inter-island connection region includes a column of pixel circuits, and a third pixel circuit in the column of pixel circuits is connected with a plurality of first light emitting elements that emit light of a same color in two transmissive regions adjacent to the second inter-island connection region in the first direction. Arrangement in this example can make the first light emitting elements and the third light emitting elements share the pixel circuit, and can reduce a length of a connection line between the first pixel circuit and the first light emitting element, so as to avoid affecting a display effect due to a large load caused by a larger length of the connection line.

In some exemplary implementations, a light emitting area of the first light emitting element may be smaller than a light emitting area of the second light emitting element emitting light of a same color. A light emitting area of the third light emitting element may be less than or equal to a light emitting area of the second light emitting element emitting light of a same color. Arrangement in this example is beneficial for ensuring the light transmittance and the display effect of the first display region.

Remaining description of the display substrate in this example may be referred to the description in the aforementioned embodiments, which is not repeated here.

A display substrate is also provided in an embodiment. The display substrate includes a first display region including a plurality of island regions separated from each other, an inter-island connection region connecting adjacent island regions, and a plurality of transmissive regions surrounded by the plurality of island regions and the inter-island connection region. A light transmittance of the transmissive region is greater than a light transmittance of the island regions and a light transmittance of the inter-island connection region. The transmissive region includes at least one first light emitting element disposed on a substrate. The inter-island connection region includes at least one first pixel circuit disposed on the substrate. At least one first light emitting element in the transmissive region is electrically connected with at least one first pixel circuit in an adjacent inter-island connection region, and a distance between an orthographic projection of the first pixel circuit on the substrate and an orthographic projection of its connected first light emitting element on the substrate is greater than 0. In other words, the orthographic projection of the first pixel circuit on the substrate is not overlapped with the orthographic projection of its connected first light emitting element on the substrate.

In some exemplary implementations, the transmissive region includes a plurality of first light emitting elements emitting light of different colors. The first light emitting elements emitting light of different colors in the transmissive region are located on different insulation layers, and first light emitting elements emitting light of a same color in the transmissive region are located on a same insulation layer. Alternatively, a plurality of first light emitting elements in the transmissive region are located on a same insulation layer. In this example, by adjusting the insulation layers below the first light emitting elements, it is advantageous to improve the light transmittance of the transmissive region.

In some exemplary implementations, the first pixel circuit in the inter-island connection region is connected with at least one first light emitting element in an adjacent transmissive region through at least one connection line. At least one connection line is made of a metal material or a transparent conductive material.

In some exemplary implementations, the inter-island connection region further includes at least one third light emitting element disposed on the substrate. At least one first pixel circuit in the inter-island connection region is electrically connected with at least one first light emitting element located in the transmissive region and at least one third light emitting element located in the inter-island connection region, which emit light of a same color. The first light emitting element and the third light emitting element in this example share the first pixel circuit, which can reduce a space occupied by the pixel circuits, and is beneficial for improving the light transmittance of the first display region.

In some exemplary implementations, the inter-island connection region further includes at least one third light emitting element and at least one third pixel circuit disposed on the substrate, wherein the at least one third pixel circuit is electrically connected with the at least one third light emitting element, an orthographic projection of the third pixel circuit on the substrate is overlapped, at least partially, with an orthographic projection of its connected third light emitting element on the substrate. The first light emitting element and the third light emitting element in this example are driven separately by different pixel circuits, so that the display effect can be guaranteed.

Remaining description of the display substrate in this example may be referred to the description in the aforementioned embodiments, which is not repeated here.

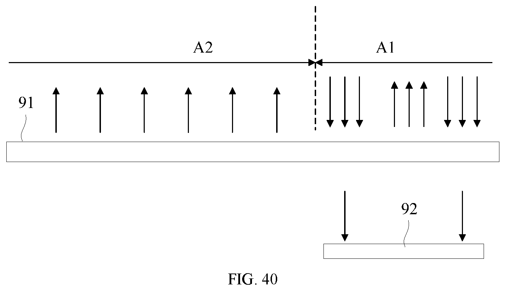

FIG. 40 is a schematic diagram of a display apparatus according to at least one embodiment of the present disclosure. As shown in FIG. 40, a display apparatus is provided in an embodiment, which includes a display substrate 91 and a sensor 92 located on a light exit side of a light emitting structure layer away from the display substrate 91. The sensor 92 may be located on a side of a non-display surface of the display substrate 91. An orthographic projection of the sensor 92 on the display substrate 91 may be overlapped with a first display region A1.

In some examples, the display substrate 91 may be a flexible OLED display substrate, a QLED display substrate, a Micro-LED display substrate, or a Mini-LED display substrate. The display apparatus may be a product having an image (including a still image or a moving image, wherein the moving image may be a video) display function. For example, the display apparatus may be: displays, televisions, billboards, digital photo frames, laser printers with display function, telephones, mobile phones, picture screens, personal digital assistants (PDA), digital cameras, portable camcorders, viewfinders, navigators, vehicles, large-area walls, information inquiry equipment (such as business inquiry equipment in e-government, banks, hospitals, power departments, etc.), monitors, etc. As another example, the display apparatus may be any one of a micro-display, a VR device or an AR device including a micro-display.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. It should be noted that the above examples or embodiments are exemplary only and not restrictive. Therefore, the present disclosure is not limited to what is specifically shown and described herein. Various modifications, substitutions or omissions may be made in forms and details of implementations without departing from the scope of the present disclosure.

## Claims

1. A display substrate, comprising: a first display region comprising a plurality of island regions and a transmissive region located between adjacent island regions; wherein a light transmittance of the transmissive region is greater than a light transmittance of an island region;

   the transmissive region comprises at least one first light emitting element disposed on a substrate; the island region comprises at least one first pixel circuit disposed on the substrate;
   at least one first pixel circuit of the island region is electrically connected with at least one first light emitting element of an adjacent transmissive region, and a distance between an orthographic projection of the first pixel circuit on the substrate and an orthographic projection of the connected first light emitting element on the substrate is greater than 0.

2. The display substrate of claim 1, wherein the first pixel circuit in the island region is electrically connected with a plurality of first light emitting elements emitting light of a same color in an adjacent transmissive region.

3. The display substrate of claim 1, wherein the transmissive region comprises a plurality of first light emitting elements emitting light of different colors, the first light emitting elements emitting light of different colors in the transmissive region are located on different insulation layers, first light emitting elements emitting light of a same color in the transmissive region are located on a same insulation layer.

4. The display substrate of claim 1, wherein the transmissive region comprises a plurality of first light emitting elements emitting light of different colors, and the plurality of first light emitting elements are located on a same insulation layer.

5. The display substrate of claim 1, wherein the first pixel circuit of the island region is connected with at least one first light emitting element in an adjacent transmissive region by at least one connection line, and the at least one connection line is made of a metal material or a transparent conductive material.

6. The display substrate of claim 5, further comprising a shielding layer located in the island region, wherein the shielding layer is located on a side of the first pixel circuit close to the substrate, an orthographic projection of the shielding layer on the substrate covers an orthographic projection of an active layer of at least one transistor of the first pixel circuit on the substrate, and the at least one connection line and the shielding layer are in a same layer.

7. The display substrate of claim 5, wherein an anode of the first light emitting element comprises a plurality of anode sub-layers, and the at least one connection line and one of the anode sub-layers are in a same layer.

8. The display substrate of claim 5, further comprising: at least one transparent conductive layer located between the first pixel circuit and the first light emitting element, wherein the at least one connection line is located in the at least one transparent conductive layer.

9. The display substrate of any one of claims 1 to 8, wherein the island region further comprises at least one second light emitting element; the first pixel circuit of the island region is electrically connected with at least one second light emitting element and at least one first light emitting element located in the transmissive region, which emit light of a same color.

10. The display substrate of any one of claims 1 to 8, wherein the island region further comprises at least one second pixel circuit and at least one second light emitting element, the at least one second pixel circuit is electrically connected with the at least one second light emitting element, and an orthographic projection of the second pixel circuit on the substrate is overlapped, at least partially, with an orthographic projection of the connected second light emitting element on the substrate.

11. The display substrate of claim 9 or 10, wherein a light emitting area of the first light emitting element is less than a light emitting area of a second light emitting element emitting light of a same color.

12. The display substrate of any one of claims 9 to 11, wherein both a plurality of second light emitting elements of the island region and a plurality of first light emitting elements of the transmissive region are located on a same insulation layer.

13. The display substrate of any one of claims 9 to 11, wherein the transmissive region comprises at least one first light emitting element that emits light of a first color, at least one first light emitting element that emits light of a second color, and at least one first light emitting element that emits light of a third color;
the first light emitting element emitting light of the first color in the transmissive region and the plurality of second light emitting elements in the island region are located on a same insulation layer, the first light emitting element emitting light of the second color, the first light emitting element emitting light of the third color, and the first light emitting element emitting light of the first color in the transmissive region are located on different insulation layers, a minimum distance between the first light emitting element emitting light of the first color and the substrate is greater than a minimum distance between the first light emitting element emitting light of the second color and the substrate, and is greater than a minimum distance between the first light emitting element emitting light of the third color and the substrate.

14. The display substrate of any one of claims 1 to 13, wherein the first display region further comprises an inter-island connection region connecting adjacent island regions; the inter-island connection region comprises at least one third light emitting element; the first pixel circuit of the island region is electrically connected with at least one first light emitting element located in the transmissive region and at least one third light emitting element located in the inter-island connection region, which emit light of a same color;
or, the inter-island connection region comprises at least one third light emitting element and at least one third pixel circuit, wherein the at least one third pixel circuit is electrically connected with the at least one third light emitting element.

15. The display substrate of any one of claims 1 to 14, further comprising a second display region located on at least one side of the first display region, a light transmittance of the second display region is less than a light transmittance of the first display region;
the second display region comprises a plurality of second region light emitting elements and a plurality of second region pixel circuits, the plurality of second region pixel circuits are electrically connected with the plurality of second region light emitting elements, and orthographic projections of the second region pixel circuits on the substrate are overlapped, at least partially, with orthographic projections of the connected second region light emitting elements on the substrate.

16. The display substrate of claim 15, wherein a pixel density of the first display region is smaller than a pixel density of the second display region.

17. The display substrate of any one of claims 1 to 16, wherein the plurality of transmissive regions are spaced apart from each other, the plurality of transmissive regions comprising at least one of the following shapes: a rounded rectangle, a circle, an oval, an octagon, a cross with twelve sides.

18. A display apparatus, comprising the display substrate of any one of claims 1 to 17, and a sensor located on a non-display side of the display substrate, wherein an orthographic projection of the sensor on the substrate of the display substrate is overlapped with an orthographic projection of the first display region of the display substrate on the substrate.

19. A display substrate, comprising a first display region comprising a plurality of island regions separated from each other, an inter-island connection region connecting adjacent island regions, and a plurality of transmissive regions surrounded by the plurality of island regions and the inter-island connection region, a light transmittance of the transmissive regions is greater than a light transmittance of the island regions and a light transmittance of the inter-island connection region;
the inter-island connection region comprises at least one third light emitting element disposed on a substrate; the at least one third light emitting element is electrically connected with at least one third pixel circuit, the at least one third pixel circuit is located in the island region or in the inter-island connection region.

20. The display substrate of claim 19, wherein the first display region further comprises at least one second light emitting element disposed on the substrate and located in the island region, a third pixel circuit of the island region is electrically connected with at least one second light emitting element and at least one third light emitting element located in the inter-island connection region, which emits light of a same color.

21. The display substrate of claim 19, wherein the first display region further comprises at least one second light emitting element and at least one second pixel circuit which are disposed on the substrate and located in the island region; the at least one second pixel circuit is electrically connected with the at least one second light emitting element, and an orthographic projection of the second pixel circuit on the substrate is overlapped, at least partially, with an orthographic projection of the connected second light emitting element on the substrate.

22. The display substrate of claim 20 or 21, wherein the inter-island connection region of the first display region comprises a first inter-island connection region and a second inter-island connection region, the first inter-island connection region connects adjacent island regions along a first direction, the second inter-island connection region connects adjacent island regions along a second direction, and the first direction intersects with the second direction;

a quantity of pixel circuit rows in the first inter-island connection region is less than or equal to a quantity of pixel circuit rows in the island region, and a quantity of pixel circuit columns in the second inter-island connection region is less than or equal to a quantity of pixel circuit columns in the island region;
a plurality of pixel circuits arranged along the first direction are a row of pixel circuits, and a plurality of pixel circuits arranged along the second direction are a column of pixel circuits.

23. The display substrate of claim 22, wherein the transmissive region comprises at least one first light emitting element disposed on the substrate; the at least one first light emitting element is electrically connected with the at least one third pixel circuit;

the first inter-island connection region comprises a row of pixel circuits, and a third pixel circuit in the row of pixel circuits is connected with a plurality of first light emitting elements that emit light of a same color in two transmissive regions adjacent to the first inter-island connection region in the second direction;
the second inter-island connection region comprises a column of pixel circuits, and a third pixel circuit in the column of pixel circuits is connected with a plurality of first light emitting elements that emit light of a same color in two transmissive regions adjacent to the second inter-island connection region in the first direction.

24. The display substrate of claim 23, wherein the third pixel circuit in the inter-island connection region is connected with at least one first light emitting element in an adjacent transmissive region by at least one connection line, the at least one connection line is made of a metal material or a transparent conductive material.

**EP 4 590 100 A1**

25. The display substrate of claim 23, wherein a light emitting area of the first light emitting element is smaller than a light emitting area o of the second light emitting element emitting light of a same color; and a light emitting area of the third light emitting element is less than or equal to a light emitting area of the second light emitting element emitting light of a same color.

26. A display substrate, comprising a first display region comprising a plurality of island regions separated from each other, an inter-island connection region connecting adjacent island regions, and a plurality of transmissive regions surrounded by the plurality of island regions and the inter-island connection region, a light transmittance of the transmissive regions is greater than a light transmittance of the island regions and a light transmittance of the inter-island connection region;
the transmissive region comprises at least one first light emitting element disposed on a substrate; the inter-island connection region comprises at least one first pixel circuit disposed on the substrate; at least one first light emitting element in the transmissive region is electrically connected with at least one first pixel circuit in an adjacent inter-island connection region, and a distance between an orthographic projection of the first pixel circuit on the substrate and an orthographic projection of the connected first light emitting element on the substrate is greater than 0.

27. The display substrate of claim 26, wherein the transmissive region comprises a plurality of first light emitting elements emitting light of different colors; the first light emitting elements emitting light of different colors in the transmissive region are located on different insulation layers, and first light emitting elements emitting light of a same color in the transmissive region are located on a same insulation layer; or a plurality of first light emitting elements in the transmissive region are located on a same insulation layer.

28. The display substrate of claim 26, wherein the first pixel circuit in the inter-island connection region is connected with at least one first light emitting element in an adjacent transmissive region by at least one connection line; the at least one connection line is made of a metal material or a transparent conductive material.

29. The display substrate of claim 26, wherein the inter-island connection region further comprises at least one third light emitting element disposed on the substrate; at least one first pixel circuit in the inter-island connection region is electrically connected with at least one first light emitting element located in the transmissive region and at least one third light emitting element located in the inter-island connection region, which emit light of a same color.

30. The display substrate of claim 26, wherein the inter-island connection region further comprises at least one third light emitting element and at least one third pixel circuit disposed on the substrate, wherein the at least one third pixel circuit is electrically connected with the at least one third light emitting element, an orthographic projection of the third pixel circuit on the substrate is overlapped, at least partially, with an orthographic projection of the connected third light emitting element on the substrate.

FIG. 1

FIG. 2

FIG. 3

FIG. 4

FIG. 5

FIG. 6

FIG. 7

FIG. 8

A2

22

221 222 223

A1

A11                                    TA                                    A11

401 402    15b           403      14a
       151b 152b 153b          141a 142a 143a

14c
141c 142c 143c

14b
141b 142b 143b

411
308
307
306
305
304
303
302
301
30

36  38   21

35  37    11    421        31/32   31   31/32        31    31/32  31/32        11   421

92

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31A

FIG. 31B

FIG. 32A

FIG. 32B

712 722 713 723    711 721

A1

Y

X

FIG. 33A

FIG. 33B

FIG. 34A

FIG. 34B

FIG. 35A

FIG. 35B

FIG. 36

FIG. 37

FIG. 38

FIG. 39

A2    A1

91

92

FIG. 40

## INTERNATIONAL SEARCH REPORT

| International application No. |
| --- |
| **PCT/CN2023/126428** |

| **A.** | **CLASSIFICATION OF SUBJECT MATTER** |
| --- | --- |

H10K59/12(2023.01)i; H10K59/123(2023.01)i

According to International Patent Classification (IPC) or to both national classification and IPC

| **B.** | **FIELDS SEARCHED** |
| --- | --- |

Minimum documentation searched (classification system followed by classification symbols)

IPC: H10K

Documentation searched other than minimum documentation to the extent that such documents are included in the fields searched

Electronic data base consulted during the international search (name of data base and, where practicable, search terms used)

CNABS; CNTXT; CNKI; VEN; EPTXT; USTXT; WOTXT: 显示, 透射, 透光, 透明, 区, 电路, 驱动, 连接, 相连, 岛, 发光, 像素, display, transmission, area, circuit, connect+, island, pixel

| **C.** | **DOCUMENTS CONSIDERED TO BE RELEVANT** | |
| --- | --- | --- |
| Category* | Citation of document, with indication, where appropriate, of the relevant passages | Relevant to claim No. |
| X | CN 111668278 A (WUHAN TIANMA MICRO-ELECTRONICS CO., LTD.) 15 September 2020 (2020-09-15) description, paragraphs [0004]-[0067], and figures 1-19 | 1-18 |
| Y | CN 111668278 A (WUHAN TIANMA MICRO-ELECTRONICS CO., LTD.) 15 September 2020 (2020-09-15) description, paragraphs [0004]-[0067], and figures 1-19 | 23-30 |
| X | CN 113540195 A (WUHAN TIANMA MICRO-ELECTRONICS CO., LTD.) 22 October 2021 (2021-10-22) description, paragraphs [0005]-[0067], and figures 1-10 | 19-22 |
| Y | CN 113540195 A (WUHAN TIANMA MICRO-ELECTRONICS CO., LTD.) 22 October 2021 (2021-10-22) description, paragraphs [0005]-[0067], and figures 1-10 | 23-30 |
| X | CN 113763874 A (BOE TECHNOLOGY GROUP CO., LTD.) 07 December 2021 (2021-12-07) description, paragraphs [0004]-[0160], and figures 1-19 | 1-18 |

☑ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **16 May 2024** | **23 May 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/126428** |

| C. | DOCUMENTS CONSIDERED TO BE RELEVANT | |
| --- | --- | --- |
| Category* | Citation of document, with indication, where appropriate, of the relevant passages | Relevant to claim No. |
| Y | CN 113763874 A (BOE TECHNOLOGY GROUP CO., LTD.) 07 December 2021 (2021-12-07) description, paragraphs [0004]-[0160], and figures 1-19 | 23-30 |
| X | CN 113937134 A (SAMSUNG DISPLAY CO., LTD.) 14 January 2022 (2022-01-14) description, paragraphs [0007]-[0241], and figures 1-17 | 19-22 |
| Y | CN 113937134 A (SAMSUNG DISPLAY CO., LTD.) 14 January 2022 (2022-01-14) description, paragraphs [0007]-[0241], and figures 1-17 | 23-30 |

Form PCT/ISA/210 (second sheet) (July 2022)

**INTERNATIONAL SEARCH REPORT**
Information on patent family members

International application No.

**PCT/CN2023/126428**

| Patent document cited in search report | | | Publication date (day/month/year) | Patent family member(s) | | | Publication date (day/month/year) |
|---|---|---|---|---|---|---|---|
| CN | 111668278 | A | 15 September 2020 | CN | 111668278 | B | 05 May 2023 |
| CN | 113540195 | A | 22 October 2021 | CN | 113540195 | B | 17 May 2022 |
| CN | 113763874 | A | 07 December 2021 | CN | 113763874 | B | 26 September 2023 |
| CN | 113937134 | A | 14 January 2022 | KR | 20220008992 | A | 24 January 2022 |
| | | | | US | 2022020835 | A1 | 20 January 2022 |

Form PCT/ISA/210 (patent family annex) (July 2022)